(19) **Europäisches Patentamt / European Patent Office / Office européen des brevets**

(11) **EP 4 661 206 A1**

(12) **EUROPEAN PATENT APPLICATION**
published in accordance with Art. 153(4) EPC

(43) Date of publication:
**10.12.2025 Bulletin 2025/50**

(21) Application number: **23931799.3**

(22) Date of filing: **22.11.2023**

(51) International Patent Classification (IPC):
**H01Q 1/08** (2006.01)

(52) Cooperative Patent Classification (CPC):
**H01Q 1/08; H01Q 1/24; H01Q 1/36; H01Q 1/50; H05K 5/02**

(86) International application number:
**PCT/CN2023/133256**

(87) International publication number:
**WO 2024/207753 (10.10.2024 Gazette 2024/41)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **03.04.2023 CN 202310389830**

(71) Applicant: **Honor Device Co., Ltd.**
**Shenzhen, Guangdong 518040 (CN)**

(72) Inventors:
• **LI, Shichao**
**Shenzhen, Guangdong 518040 (CN)**
• **LIANG, Tiezhu**
**Shenzhen, Guangdong 518040 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **ELECTRONIC DEVICE HAVING FOLDABLE SCREEN, AND ANTENNA APPARATUS THEREOF**

(57) This application provides a foldable-screen electronic device and an antenna apparatus thereof. When the foldable-screen electronic device is in a folded state, parasitic radiators of each primary radiator in an antenna may be divided based on a communication scenario, and an operating frequency of each radiator in the antenna (including the primary radiator) may be adjusted according to a preset frequency adjustment rule, to enable a current direction of each parasitic radiator of the primary radiator in the antenna and a current direction of the primary radiator to meet an expected target current direction, to improve performance of the antenna (including the primary radiator).

FIG. 7

EP 4 661 206 A1

**Description**

This application claims priority to Chinese Patent Application No. 202310389830.7, filed with the China National Intellectual Property Administration on April 3, 2023 and entitled "FOLDABLE-SCREEN ELECTRONIC DEVICE AND ANTENNA APPARATUS THEREOF", which is incorporated herein by reference in its entirety.

**TECHNICAL FIELD**

This application relates to the field of antenna technologies, and in particular, to a foldable-screen electronic device and an antenna apparatus thereof.

**BACKGROUND**

A foldable-screen electronic device provides abundant interaction modes and a novel appearance for a user. The foldable-screen electronic device includes a foldable electronic device, for example, a foldable mobile phone. An antenna is disposed in the foldable-screen electronic device to support communication between the foldable-screen electronic device and another electronic device. Usually, antenna performance is good when the foldable-screen electronic device is in an unfolded state, but is poor in a folded state. A reason lies in that the antenna is made of a metal material, and radiation performance of the antenna is subject to interference from another metal object. Therefore, a clear space (referred to as a clearance space) is usually reserved in a surrounding space of the antenna, to ensure the radiation performance of the antenna. When the foldable-screen electronic device switches from the unfolded state to the folded state, two device bodies block each other. Consequently, the clearance space becomes increasingly small, and the antenna performance becomes worse correspondingly.

**SUMMARY**

This application provides a foldable-screen electronic device and an antenna apparatus thereof. The antenna apparatus in the foldable-screen electronic device can enable an antenna to have good performance when the electronic device is in a folded state.

According to a first aspect, this application provides a foldable-screen electronic device. The foldable-screen electronic device includes a first device body and a second device body. The first device body and the second device body are connected through a hinge, a first antenna stub is disposed along a bezel of the first device body, and a second antenna stub is disposed along a bezel of the second device body. Two ends of the first antenna stub are open, a first ground terminal and a second ground terminal are disposed on the first antenna stub, and the first ground terminal and the second ground terminal are close to each other. The first ground terminal is close to a first open end of the first antenna stub, and the second ground terminal is close to a second open end of the first antenna stub. A first feed point is provided on the first antenna stub, and the first feed point is arranged between the first ground terminal and the first open end. Two ends of the second antenna stub are open, a third ground terminal and a fourth ground terminal are disposed on the second antenna stub, and the third ground terminal and the fourth ground terminal are close to each other. The third ground terminal is close to a third open end of the second antenna stub, and the second ground terminal is close to a fourth open end. When the foldable-screen electronic device is in a folded state, a projection of the first antenna stub on the second device body overlaps the second antenna stub.

In some embodiments, the first device body may be a first device body 100 in the specification, and the second device body may be a second device body 200 in the specification. The first antenna stub may be understood as a collective name for all radiation sections in the first device body, and the second antenna stub may be understood as a collective name for all radiation sections in the second device body. The radiation section herein may be understood as a radiator in the specification. The open end may be an opening end in the specification. For example, the first open end may be understood as an opening end 103a in the specification, the second open end may be understood as an opening end 103c in the specification, the third opening end may be an opening end 203b in the specification, and the fourth opening end may be an opening end 203d in the specification. The first ground terminal may be a ground terminal 102a in the specification, the second ground terminal may be a ground terminal 102c in the specification, the third ground terminal may be a ground terminal 202b in the specification, and the fourth ground terminal may be 202d in the specification. The first feed point may be understood as a feed point 104a in the specification. A first radiation section may be understood as a radiator A in the specification, a second radiator section may be understood as a radiator B in the specification, a third radiation section may be understood as a radiator C in the specification, and a fourth radiation section may be understood as a radiator D in the specification.

In an antenna apparatus in the foregoing embodiment, two adjacent ground terminals that are close to each other are disposed on one antenna stub, and one antenna stub may serve as two radiation sections. In the first antenna stub and the second antenna stub, a radiation section not including a feed point may serve as a coupled radiation section (a parasitic radiation section) of a radiation section provided with a feed point. In the folded state, the two antenna stubs overlap each other, so that coupling effect between the two antenna stubs in the folded state is better. In this design, when the electronic device is in the folded state, performance of an antenna (including the first feed point) can be improved. In addition, two ends of each of the first antenna stub and the second antenna stub are open, and other radiation sections may be further included. This provides a basis for setting different operating frequencies based on different radiation sections. In addition, the radiator B overlaps the radiator A, so that coupling effect between the radiator B and the radiator A is better, and the radiator B is more likely to have forward parasitic radiation effect on the radiator A. In this way, during operation of the antenna, performance of the antenna can be improved.

With reference to the first aspect, in some embodiments, a projection of the second radiation section on the second device body does not overlap the third radiation section.

In some embodiments, when the electronic device is in the folded state, the radiator B does not overlap the radiator C, so that mutual interference between the radiator C and the radiator B can be reduced. In this way, during operation of the antenna, performance of the antenna can be further improved.

With reference to the first aspect, in some embodiments, the first antenna stub is specifically distributed along an L-shaped bezel of the first device body, and the second antenna stub is specifically distributed along an L-shaped bezel of the second device body.

In the foregoing embodiment, the L-shaped bezel may be a bezel at a corner in the specification. Radiators are arranged in a broken-line shape.

With reference to the first aspect, in some embodiments, a first current is distributed on the first radiation section, a current in a same direction as the first current is distributed on the second radiation section, a current in a same direction as the first current is distributed on the third radiation section, and a current in a direction opposite to a direction of the first current is distributed on the fourth radiation section.

In the foregoing embodiment, when the antenna stubs are distributed along the L-shaped bezels, the first radiator section is a primary radiation section, and the second radiation section, the third radiation section, and the fourth radiation section are parasitic radiation sections of the first radiation section. An operating frequency band of the first radiation section may be a Wi-Fi 2.4G frequency band. The fourth radiation section and the first radiation section are located in different device bodies, and the fourth radiation section and the first radiation section are not arranged in parallel. In this case, when a current distributed on the fourth radiation section is opposite to a current distributed on the first radiation section, the fourth radiation section may have forward parasitic radiation effect on the first radiation section, to improve performance of the antenna. Based on a relationship between another radiation section and the first radiation section, when a current distributed on the another radiation section is in a same direction as a current distributed on the first radiator section, the another radiation section may have forward parasitic radiation effect on the first radiation section.

With reference to the first aspect, in some embodiments, the first antenna stub is specifically distributed along a linear bezel of the first device body, and the second antenna stub is specifically distributed along a linear bezel of the second device body.

In the foregoing embodiment, the antenna stubs are distributed along the linear bezels, and therefore radiation sections in different device bodies are arranged in parallel.

With reference to the first aspect, in some embodiments, a first current is distributed on the first radiation section, and a current in a same direction as the first current is distributed on each of the second radiation section, the third radiation section, and the fourth radiation section.

In the foregoing embodiment, the first radiator section is a primary radiation section, an operating frequency band of the first radiation section may be a Wi-Fi 2.4G frequency band, and other radiation sections are parasitic radiation sections of the first radiation section. When the antenna stubs are distributed along the linear bezels and a current distributed on another radiation section and a current distributed on the first radiation section are in a same direction as a current distributed on the first radiator section, the another radiation section may have forward parasitic radiation effect on the first radiation section, to improve performance of the antenna.

With reference to the first aspect, in some embodiments, the first antenna stub further includes a fifth radiation section, and the second antenna stub further includes a sixth radiation section. A slot exists between the fifth radiation section and the third radiation section, and a ground terminal is disposed on the fifth radiation section. A slot exists between the sixth radiation section and the fourth radiation section, and a ground terminal is disposed on the sixth radiation section.

In some embodiments, the fifth radiation section may be understood as a radiator E in the specification, and the sixth radiation section may be understood as a radiator F in the specification.

In the foregoing embodiment, the antenna stubs include more radiation sections through slot coupling. During operation of a primary radiation section, the primary radiation section may have more parasitic radiation sections with forward radiation effect, to further improve performance of the antenna. In addition, there are more radiation sections. This provides a basis for setting different operating frequencies based on different radiation sections.

With reference to the first aspect, in some embodiments, when the foldable-screen electronic device is in a folded state, a projection of the fifth radiation section on the second device body overlaps the sixth radiation section.

In the foregoing embodiment, the fifth radiation section overlaps the sixth radiation section, so that coupling effect between the fifth radiation section and the sixth radiation section is better. For example, if the electronic device is in the folded state, one of the fifth radiation section and the sixth radiation section serves as a primary radiation section, and the other serves as a parasitic radiation section, a radiator serving as the parasitic radiation section may have better parasitic radiation effect on the primary radiation section.

With reference to the first aspect, in some embodiments, a current in a same direction as the first current is distributed on each of the fifth radiation section and the sixth radiation section.

In the foregoing embodiment, both the fifth radiator section and the sixth radiation section serve as parasitic radiation sections of the first radiation section. When a current on the fifth radiation section, a current on the sixth radiation section, and a current on the first radiation section are in a same direction, the fifth radiation section and the sixth radiation section may have forward parasitic radiation effect on the first radiation section, to improve performance of the antenna. An operating frequency (an operating frequency A) of the first radiation section may belong to a Wi-Fi 2.4G frequency band.

With reference to the first aspect, in some embodiments, the third radiation section is connected to a first tuning circuit, the fourth radiation section is connected to a second tuning circuit, the fifth radiation section is connected to a third tuning circuit, and the sixth radiation section is connected to a fourth tuning circuit.

In the foregoing embodiment, the tuning circuit may be a frequency control circuit in the specification. When a radiation section is connected to a tuning circuit, the radiation section can have more frequencies.

With reference to the first aspect, in some embodiments, the second radiation section is connected to a fifth tuning circuit.

In the foregoing embodiment, the tuning circuit may be a frequency control circuit in the specification. When the second radiation section is connected to a tuning circuit, the second radiation section can have more frequencies.

With reference to the first aspect, in some embodiments, the current distributed on the second radiation section includes a current of a first frequency and a current of a second frequency, and the first frequency and the second frequency are operating frequencies of the first radiation section.

In some embodiments, the first frequency may be a Wi-Fi 2.4G frequency band in the specification, and the second frequency band may be a GPS frequency band in the specification.

In the foregoing embodiment, the fifth tuning circuit enables the second radiation section to have two frequencies. Resonance at one of the two frequencies enables the current distributed on the second radiation section to be a current of the first frequency. The current of the first frequency is a current excited on the second radiation section when the first radiation section is at resonance on a first frequency band (to be specific, an operating frequency is the first frequency). Resonance at the other frequency enables the current distributed on the second radiation section to be a current of the second frequency. The current of the second frequency is a current excited on the second radiation section when the first radiation section is at resonance on a second frequency band (to be specific, an operating frequency is the second frequency).

With reference to the first aspect, in some embodiments, a second feed point is further provided on the fifth radiation section.

In some embodiments, the second feed point may be a feed point 104e in the specification. In the foregoing embodiment, when a feed point is provided on the fifth radiation section, the antenna may have more operating frequency bands, to provide more communication modes for the electronic device.

With reference to the first aspect, in some embodiments, an excitation source connected to the first feed point transmits an excitation signal, and an excitation source connected to the second feed point does not transmit an excitation signal. The excitation source connected to the first feed point is different from the excitation source connected to the second feed point.

In the foregoing embodiment, although the second feed point is provided on the fifth radiation section, the excitation source connected to the second feed point does not transmit an excitation signal. This may be understood as that the electronic device does not use (does not enable) a communication mode corresponding to an operating frequency band of the fifth radiation section.

With reference to the first aspect, in some embodiments, the L-shaped bezel specifically includes a horizontal bezel and a vertical bezel, and the horizontal bezel is perpendicular to the vertical bezel. When the fifth radiation section is specifically disposed at the vertical bezel and the first radiation section is specifically disposed at the horizontal bezel, a second current is distributed on the first radiation section, a current in a same direction as the second current is distributed on the second radiation section, a current in a direction opposite to a direction of the second current is distributed on the fourth radiation section, a third current is distributed on the fifth radiation section, and a current in a same direction as the third current is distributed on the sixth radiation section.

In some embodiments, when the fifth radiation section and the first radiation section are distributed at a bezel at a corner, a feed point is provided on each of the first radiation section and the fifth radiation section. In this case, both the first radiation section and the fifth radiation section may serve as primary radiation sections. An operating frequency (an operating frequency A) of the first radiation section may belong to a Wi-Fi 2.4G frequency band. An operating frequency (an operating frequency C) of the fifth radiation section may belong to a B41 frequency band.

In the foregoing embodiment, in the electronic device, parasitic radiators of the first radiation section and the fifth radiation section can be properly allocated, to enable each primary radiation section to have a parasitic radiation section. In this way, the electronic device can better use a communication mode corresponding to an operating frequency band of the first radiation section and a communication mode corresponding to the fifth radiation section. For example, a radiation section close to a primary radiation section is allocated as a main parasitic radiation section of the primary radiation section, and a main parasitic radiator of the first radiation section may include the second radiation section and the fourth radiation section, and a main parasitic radiator of the fifth radiation section may include the sixth radiation section.

With reference to the first aspect, in some embodiments, the current distributed on the third radiation section is weaker than the second current and the third current.

In the foregoing embodiment, the third radiation section is disposed between two primary radiation sections (the first radiation section and the fifth radiation section). When a current distributed on the first radiation section and a current distributed on the fifth radiation section are in different directions, if the current on the third radiation section is strong, adverse impact is caused to one of the primary radiation sections. Therefore, the current distributed on the third radiation section is weak, to avoid interference to the radiator A or the radiator E.

With reference to the first aspect, in some embodiments, no current is distributed on the third radiation section.

In the foregoing embodiment, the third radiation section is disposed between two primary radiation sections (the first radiation section and the fifth radiation section). When a current distributed on the first radiation section and a current distributed on the fifth radiation section are in different directions, if the current on the third radiation section is strong, adverse impact is caused to one of the primary radiation sections. Therefore, no current is distributed on the third radiation section, to avoid interference to the radiator A or the radiator E.

With reference to the first aspect, in some embodiments, when the fifth radiation section and the first radiation section are specifically disposed at the horizontal bezel, the second current is distributed on the first radiation section, a current in a same direction as the second current is distributed on each of the second radiation section, the fourth radiation section, and the sixth radiation section, the third current is distributed on the fifth radiation section, and a current in a same direction as the third current is distributed on the third radiation section.

In some embodiments, when the fifth radiation section and the first radiation section are arranged in a linear shape, a feed point is provided on each of the first radiation section and the fifth radiation section. In this case, both the first radiation section and the fifth radiation section may serve as primary radiation sections. An operating frequency (an operating frequency A) of the first radiation section may belong to a Wi-Fi 2.4G frequency band. An operating frequency (an operating frequency C) of the fifth radiation section may belong to a B41 frequency band.

In the foregoing embodiment, in the electronic device, parasitic radiators of the first radiation section and the fifth radiation section can be properly allocated, to enable each primary radiation section to have a parasitic radiation section. In this way, the electronic device can better use a communication mode corresponding to an operating frequency band of the first radiation section and a communication mode corresponding to the fifth radiation section. For example, a main parasitic radiator of the first radiation section may include the second radiation section, the fourth radiation section, and the sixth radiation section, and a main parasitic radiator of the fifth radiation section may include the third radiation section. When the second radiation section and the sixth radiation section are arranged in a linear shape, the second radiation section and the sixth radiation section may serve as one parasitic radiation section with the second radiation section as a main radiation section, or the sixth radiation section together with the second radiation section may serve as parasitic radiation sections of the first radiation section, to improve performance of the first radiation section.

With reference to the first aspect, in some embodiments, a third feed point is further provided on the third radiation section.

In the foregoing embodiment, the third feed point may be a feed point 404e in the specification. In some embodiments, when a feed point is provided on the third radiation section, the antenna may have more operating frequency bands, to provide more communication modes for the electronic device.

With reference to the first aspect, in some embodiments, the L-shaped bezel specifically includes a horizontal bezel and a vertical bezel, and the horizontal bezel is perpendicular to the vertical bezel. When the third radiation section is specifically disposed at the vertical bezel and the first radiation section is specifically disposed at the horizontal bezel, a fourth current is distributed on the first radiation section, a current in a same direction as the fourth current is distributed on the second radiation section, a current in a direction opposite to a direction of the fourth current is distributed on the fourth radiation section, a fifth current is distributed on the third radiation section, and a current in a same direction as the fifth current is distributed on the fifth radiation section and the sixth radiation section.

In some embodiments, when the third radiation section and the first radiation section are distributed at a bezel at a corner, a feed point is provided on each of the first radiation section and the third radiation section. In this case, both the first radiation section and the third radiation section may serve as primary radiation sections. An operating frequency (an operating frequency A) of the first radiation section may belong to a Wi-Fi 2.4G frequency band. An operating frequency (an operating frequency C) of the third radiation section may belong to a B41 frequency band.

In the foregoing embodiment, in the electronic device, parasitic radiators of the first radiation section and the fifth radiation section can be properly allocated, to enable each primary radiation section to have a parasitic radiation section. In this way, the electronic device can better use a communication mode corresponding to an operating frequency band of the first radiation section and a communication mode corresponding to the third radiation section. For example, a radiation section close to a primary radiation section is allocated as a main parasitic radiation section of the primary radiation section, and a main parasitic radiator of the first radiation section may include the second radiation section and the fourth radiation section, and a main parasitic radiator of the third radiation section may include the fifth radiation section and the sixth radiation section.

With reference to the first aspect, in some embodiments, an excitation source connected to the first feed point and an excitation source connected to the second feed point each transmit a radio frequency signal. The excitation source connected to the first feed point is different from the excitation source connected to the second feed point.

In the foregoing embodiment, a feed point is provided on each of the fifth radiation section and the first radiation section, and excitation sources connected to the two feed points each transmit an excitation signal. This may be understood as that the electronic device uses (enables) a communication mode corresponding to an operating frequency band of the fifth radiation section and a communication mode corresponding to an operating frequency band of the first radiation section. In addition, in this case, communication performance of the electronic device in the two communication modes is good.

With reference to the first aspect, in some embodiments, an excitation source connected to the first feed point and an excitation source connected to the third feed point each transmit a radio frequency signal. The excitation source connected to the first feed point is different from the excitation source connected to the third feed point.

In the foregoing embodiment, a feed point is provided on each of the third radiation section and the first radiation section, and excitation sources connected to the two feed points each transmit an excitation signal. This may be understood as that the electronic device uses (enables) a communication mode corresponding to an operating frequency band of the fifth radiation section and a communication mode corresponding to an operating frequency band of the first radiation section. In addition, in this case, communication performance of the electronic device in the two communication modes is good.

With reference to the first aspect, in some embodiments, the first antenna stub further includes a seventh radiation section, and the second antenna stub further includes an eighth radiation section. A slot exists between the seventh radiation section and the first radiation section, and a ground terminal is disposed on the seventh radiation section. A slot exists between the eighth radiation section and the second radiation section, and a ground terminal is disposed on the eighth radiation section.

In some embodiments, the seventh radiation section may be understood as a radiator G in the specification, and the eighth radiation section may be understood as a radiator H in the specification.

In the foregoing embodiment, the antenna stubs include more radiation sections through slot coupling. During operation of a primary radiation section, the primary radiation section may have more parasitic radiation sections with forward radiation effect, to further improve performance of the antenna. In addition, there are more radiation sections. This provides a basis for setting different operating frequencies based on different radiation sections.

With reference to the first aspect, in some embodiments, when the foldable-screen electronic device is in the folded state, a projection of the seventh radiation section on the second device body overlaps the eighth radiation section.

In the foregoing embodiment, the seventh radiation section overlaps the eighth radiation section, so that coupling effect between the seventh radiation section and the eighth radiation section is better. For example, if the electronic device is in the folded state, one of the seventh radiation section and the eighth radiation section serves as a primary radiation section, and the other serves as a parasitic radiation section, a radiator serving as the parasitic radiation section may have better parasitic radiation effect on the primary radiation section.

With reference to the first aspect, in some embodiments, a current distributed on the seventh radiation section is in a same direction as the current distributed on the second radiation section.

In the foregoing embodiment, the seventh radiator section and the second radiation section may be considered as one parasitic radiation section with the second radiation section as a main radiation section.

With reference to the first aspect, in some embodiments, a fourth feed point is further provided on the eighth radiation section.

In some embodiments, the fourth feed point may be a feed point 104g in the specification. In the foregoing embodiment, when a feed point is provided on the seventh radiation section, the antenna may have more operating frequency bands, to provide more communication modes for the electronic device.

## BRIEF DESCRIPTION OF DRAWINGS

FIG. 1 is a group of diagrams of an electronic device in a folded state and an unfolded state;

FIG. 2 shows fixed arrangements in different antenna structures;

FIG. 3 is an example diagram of a first antenna structure;

FIG. 4 shows example arrangements of radiators in an electronic device in a first antenna structure;

FIG. 5A is a diagram of comparison between a current direction in a single-mode Wi-Fi scenario and a current direction in a low-performance scenario 11;

FIG. 5B is a simulation diagram of example current distribution when an electronic device is in single-mode Wi-Fi;

FIG. 6 is a diagram of a preset frequency adjustment rule 21a;

FIG. 7 is a diagram of comparison between a frequency adjustment rule in a single-mode Wi-Fi scenario and a frequency adjustment rule in a low-performance scenario 11;

FIG. 8 is a diagram of a frequency control circuit arrangement in a single-mode Wi-Fi scenario and a frequency control circuit arrangement in a low-performance scenario 11;

FIG. 9 is a diagram of comparison between radiation efficiency and system efficiency of an antenna 2 in a single-mode Wi-Fi scenario and radiation efficiency and system efficiency of the antenna 2 in a low-performance scenario 11 during simulation effect testing of an electronic device;

FIG. 10 is a diagram of comparison between a current direction in a Wi-Fi and B41 coexistence mode scenario and a current direction in a low-performance scenario 12;

FIG. 11 is a simulation diagram of example current distribution of radiators mainly responsible for a Wi-Fi 2.4G frequency band when an electronic device is in a Wi-Fi and B41 coexistence mode scenario;

FIG. 12 is a diagram of a preset frequency adjustment rule 21b;

FIG. 13 is a diagram of comparison between a frequency adjustment rule in a Wi-Fi and B41 coexistence mode scenario and a frequency adjustment rule in a low-performance scenario 12;

FIG. 14 is a diagram of a frequency control circuit arrangement in a single-mode Wi-Fi scenario and a frequency control circuit arrangement in a low-performance scenario 12;

FIG. 15 is a diagram of comparison between efficiency of an antenna 2 in a Wi-Fi and B41 coexistence mode scenario and efficiency of the antenna 2 in a low-performance scenario 12 during simulation effect testing of an electronic device;

FIG. 16 is a diagram of comparison between efficiency of an antenna 1 in a Wi-Fi and B41 coexistence mode scenario and efficiency of the antenna 1 in a low-performance scenario 11 during simulation effect testing of an electronic device;

FIG. 17 is an example diagram of a second antenna structure;

FIG. 18 shows an example arrangement of a first antenna structure in an electronic device;

FIG. 19A is a diagram of comparison between a current direction in a single-mode Wi-Fi scenario and a current direction in a low-performance scenario 21;

FIG. 19B is a simulation diagram of example current distribution when an electronic device is in single-mode Wi-Fi;

FIG. 20 is a diagram of a preset frequency adjustment rule 22a;

FIG. 21 is a diagram of comparison between a frequency adjustment rule in a single-mode Wi-Fi scenario and a frequency adjustment rule in a low-performance scenario 21;

FIG. 22 is a diagram of a frequency control circuit arrangement in a single-mode Wi-Fi scenario and a frequency control circuit arrangement in a low-performance scenario 21;

FIG. 23 is a diagram of comparison between radiation efficiency and system efficiency of an antenna 2 in a single-mode Wi-Fi scenario and radiation efficiency and system efficiency of the antenna 2 in a low-performance scenario 21 during simulation effect testing of an electronic device;

FIG. 24 is a diagram of a target current direction 22;

FIG. 25 is a simulation diagram of example current distribution of radiators mainly responsible for a Wi-Fi 2.4G frequency band when an electronic device is in a Wi-Fi and B41 coexistence mode scenario;

FIG. 26 is a diagram of a preset frequency adjustment rule 22b;

FIG. 27 is a diagram of comparison between a frequency adjustment rule in a Wi-Fi and B41 coexistence mode scenario and a frequency adjustment rule in a low-performance scenario 22;

FIG. 28 is a diagram of a frequency control circuit arrangement in a Wi-Fi and B41 coexistence mode scenario and a frequency control circuit arrangement in a low-performance scenario 22;

FIG. 29 is a diagram of comparison between efficiency of an antenna 2 and an antenna 1 in a Wi-Fi and B41 coexistence mode scenario and efficiency of the antenna 2 and the antenna 1 in a low-performance scenario 22 during simulation effect testing of an electronic device;

FIG. 30 is a diagram of comparison between efficiency of an antenna 1 in a Wi-Fi and B41 coexistence mode scenario and efficiency of the antenna 1 in a low-performance scenario 11 during simulation effect testing of an electronic device;

FIG. 31 is an example diagram of a third antenna structure;

FIG. 32 shows a target current direction 31 in a single-mode Wi-Fi scenario;

FIG. 33 is a simulation diagram of example current distribution of radiators when an electronic device is in a single-mode Wi-Fi scenario;

FIG. 34 is a diagram of a preset frequency adjustment rule 23a;

FIG. 35 is a diagram of comparison of radiation efficiency and system efficiency of an antenna 2 in a single-mode Wi-Fi scenario during simulation effect testing of an electronic device;

FIG. 36 shows a target current direction 32 in a Wi-Fi and B41 coexistence mode scenario;

FIG. 37A and FIG. 37B are simulation diagrams of example current distribution of radiators when an electronic device is in a Wi-Fi and B41 coexistence mode scenario;

FIG. 38 is a diagram of frequencies of radiators mainly responsible for a B41 frequency band;

FIG. 39 is a diagram of comparison between efficiency in a Wi-Fi and B41 coexistence mode scenario and efficiency in a low-performance scenario 12 during simulation effect testing of an electronic device;

FIG. 40 shows an example antenna structure in a single-mode MHB scenario;

FIG. 41 shows an example frequency adjustment rule in a single-mode MHB scenario;

FIG. 42 is another diagram in which a frequency control circuit is added;

FIG. 43 and FIG. 44 are example diagrams of causes of improvement of antenna performance;

FIG. 45 is a diagram of current distribution of a radiator A to a radiator D when an electronic device is in single-mode Wi-Fi in a case;

FIG. 46 is a diagram of current distribution of a radiator A to a radiator D when an electronic device is in single-mode Wi-Fi in a case;

FIG. 47 is a diagram of current distribution of a radiator A to a radiator F when an electronic device is in a Wi-Fi and B41 coexistence mode in a case; and

FIG. 48 is a diagram of current distribution of a radiator A to a radiator F when an electronic device is in a Wi-Fi and B41 coexistence mode in a case.

## DESCRIPTION OF EMBODIMENTS

Terms used in the following embodiments of this application are merely intended to describe specific embodiments, but not to limit this application. The singular expressions "a", "an", "the", "the foregoing", "that", and "this" used in this specification and the appended claims of this application are also intended to include plural expressions, unless otherwise clearly specified in the context. It should be further understood that the term "and/or" used in this application indicates and includes any or all possible combinations of one or more listed items.

The terms "first" and "second" mentioned below are merely intended for description, and shall not be construed as an indication or implication of relative importance or an implicit indication of a quantity of indicated technical features. Therefore, a feature defined by "first" or "second" may explicitly or implicitly include one or more features. In the descriptions of embodiments of this application, "a plurality of" means two or more, unless otherwise specified.

In the descriptions of this application, it should be noted that, an orientation or position relationship indicated by the term "center", "on", "below", "left", "right", "vertical", "horizontal", "inside", "outside", or the like is based on an orientation or position relationship shown in the accompanying drawings, and is merely intended for ease and brevity of description of this application, but not to indicate or imply that a specified apparatus or component needs to have a specific orientation or needs to be constructed or operated in a specific orientation. Therefore, the terms shall not be construed as a limitation on this application. In addition, the terms "first" and "second" are merely intended for description, and shall not be construed as an indication or implication of relative importance. In the descriptions of this application, it should be noted that the terms "mount", "connect", and "connection" should be understood in a broad sense, unless otherwise clearly specified or defined. For example, the connection may be a fixed connection, a detachable connection, or an integral connection; or the connection may be a mechanical connection or an electrical connection; or the connection may be a direct connection, an indirect connection through an intermediate medium, or internal communication between two components. Persons of ordinary skill in the art may understand specific meanings of the foregoing terms in this application based on specific situations.

Embodiments of this application provide a foldable-screen electronic device. The foldable-screen electronic device is equipped with an antenna set. The antenna set may include at least two antennas. Any antenna in the antenna set may include at least one radiator (provided with a feed point), and the radiator may be configured to receive an electromagnetic wave signal and transmit an electromagnetic wave signal. Different antennas in the antenna set may provide at least one communication mode for the foldable-screen electronic device alone or in combination with another antenna. The foldable-screen electronic device adjusts an operating frequency of each antenna according to a preset frequency adjustment rule 1, to communicate with another electronic device in different communication modes. The communication mode includes but is not limited to one or a combination of the following communication modes: cellular network communication such as 2G/3G/4G/5G, global positioning system (global positioning system, GPS)-based communication, wireless local area network (wireless local area networks, WLAN) (for example, a wireless fidelity (wireless fidelity, Wi-Fi) network) communication, Bluetooth (Bluetooth, BT) communication, and the like.

When the electronic device is in a folded state, the operating frequency of each antenna is adjusted according to the preset frequency adjustment rule 1, and a communication mode of the foldable-screen electronic device is a communication mode A, performance of an antenna responsible for providing the communication mode A may be low. When the performance of the antenna (an antenna A) responsible for providing the communication mode A is low, the foldable-screen electronic device has a poor communication capability when communicating with another electronic device in the communication mode A. For this problem, when the communication mode of the foldable-screen electronic device is the communication mode A, an operating frequency of the antenna A or operating frequencies of the antenna A and an antenna coupled thereto may be re-adjusted according to a preset frequency adjustment rule 2, to improve performance of the antenna A, and therefore improve a communication capability of the foldable-screen electronic device during communication with another electronic device in the communication mode A. The preset frequency adjustment rule 2 is different from the preset frequency adjustment rule 1.

The antenna set includes at least two antennas, denoted as an antenna 1 and an antenna 2. In addition to the antenna 1 and the antenna 2, the antenna set may further include another antenna, for example, an antenna 3. In the following content, an example in which the antenna set includes the antenna 1 to the antenna 3 is used for description.

Herein, it should be understood that antennas in the antenna set may have different antenna structures. When antenna structures are different, the foldable-screen electronic device may re-adjust, according to different preset frequency adjustment rules 2, operating frequencies of the antenna A and an antenna coupled thereto, to improve a communication capability of the foldable-screen electronic device during communication with another electronic device in the communication mode A.

A difference between two antenna structures includes but is not limited to: Radiators in the two antenna structures are arranged in different manners, or frequency control circuits to which radiators are connected in the two antenna structures are different.

An arrangement manner of radiators in the antenna set includes but is not limited to the following two arrangement manners.

Arrangement manner 1: The radiators are arranged in a linear shape. For example, all of the radiators are disposed at a vertical bezel of the foldable-screen electronic device, or all of the radiators are disposed at a horizontal bezel of the foldable-screen electronic device.

Arrangement manner 2: The radiators are arranged in a broken-line shape (for example, an L shape). For example, the radiators may be disposed at a bezel at a corner of the foldable-screen electronic device. To be specific, some radiators included in the antenna are disposed at a horizontal bezel, and other radiators are disposed at a vertical bezel.

A manner of coupling between the radiators in the antenna includes coupling through a slot.

In the following descriptions, for ease of description, the foldable-screen electronic device is referred to as an electronic device.

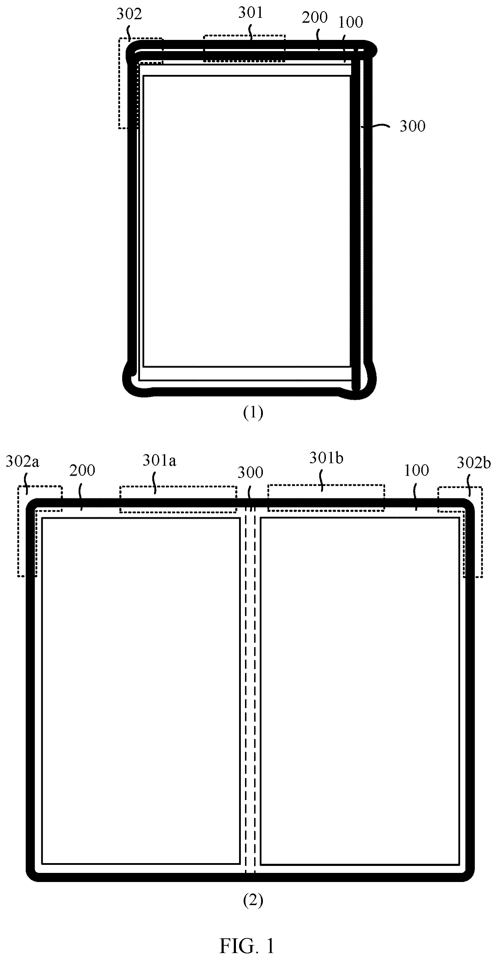

**FIG. 1 is a group of diagrams of an electronic device in a folded state**

**and an unfolded state.**

(1) in FIG. 1 is a diagram of the electronic device in the folded state. The electronic device includes a first device body 100, a second device body 200, a hinge 300, a first floor (not shown in FIG. 1), a second floor (not shown in FIG. 1), a first mainboard (not shown in FIG. 1), and a second mainboard (not shown in FIG. 1).

The first device body 100 and the second device body 200 are rotatably connected through the hinge 300, so that the electronic device can switch between the unfolded state and the folded state. The first floor is disposed in the first device body 100, and the second floor is disposed in the second device body 200. The first mainboard and the second mainboard are respectively disposed in the first device body 100 and the second device body 200.

In some possible cases, the first device body 100 is a device body on a side on which a primary screen of the electronic device is located, and the second device body 200 is a device body on a side on which a secondary screen of the electronic device is located. Certainly, persons skilled in the art may understand that, in another case, the first device body 100 may be a device body on a side on which a secondary screen of the electronic device is located, and the second device body 200 is a device body on a side on which a primary screen of the electronic device is located. This does not constitute a limitation on the protection scope of this application.

In this embodiment of this application, an example in which the electronic device is a foldable mobile phone is used for description. Certainly, persons skilled in the art may understand that, in another alternative implementation, the electronic device may alternatively be another foldable-screen electronic device such as a foldable tablet computer or a foldable smartwatch. This does not constitute a limitation on the protection scope of this application.

(2) in FIG. 1 is a diagram of the electronic device in the folded state. The first device body 100 and the first floor therein are disposed on one side of the hinge 300. The second device body 200 and the second floor therein are disposed on the other side of the hinge 300.

With reference to the content shown in (1) in FIG. 1 and (2) in FIG. 1, radiators may be disposed along a bezel of the electronic device. When the radiators are arranged in a linear shape, the radiators may be disposed at a bezel included in an area 301. When the radiators are arranged in a broken-line shape (for example, an L shape), the radiators may be disposed at a bezel (a bezel at a corner) included in an area 302. All of the radiators in the electronic device may be arranged in a linear shape or a broken-line shape. Alternatively, some of the radiators may be arranged in a linear shape, and some are arranged in a broken-line shape. The area 301 may include an area 301a and an area 301b. The area 302 may include an area 302a and an area 302b.

It should be understood that, in addition to the foregoing components, the electronic device may further include other components. Any component may be implemented in a form of hardware, software, or a combination of hardware and software. For example, the electronic device may include a processor, an external memory interface, an internal memory, a universal serial bus (universal serial bus, USB) interface, a charging management module, a power management unit, a battery, a mobile communication module, a wireless communication module, an audio module, a speaker, a receiver, a microphone, a headset jack, a sensor module, a button, a motor, a camera, and a display.

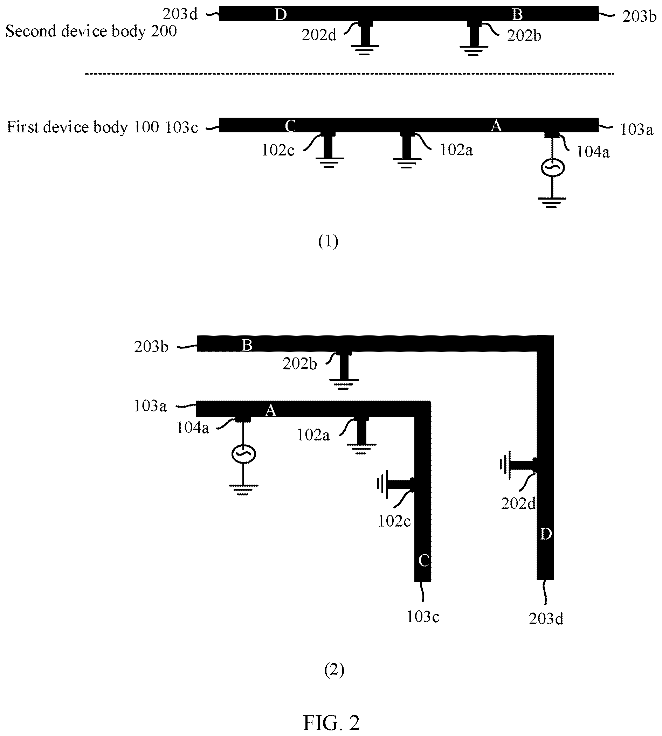

**FIG. 2 shows fixed arrangements in different antenna structures.**

Fixed arrangements in different antenna structures are described in detail below with reference to FIG. 1 and FIG. 2.

At least one antenna includes two antenna stubs. One antenna stub (an antenna stub 1) is disposed in the first device body 100, and the other antenna stub (an antenna stub 2) is disposed in the second device body 200. As shown in (1) in FIG. 2 and (2) in FIG. 2, the antenna stub 1 includes a radiator A and a radiator C, and the antenna stub 2 includes a radiator B and a radiator D. The radiator A is connected to the first floor in the first device body 100 through a ground terminal 102a, and the radiator C is connected to the first floor in the first device body 100 through a ground terminal 102c. The radiator B is connected to the second floor in the second device body 200 through a ground terminal 202b, and the radiator D is connected to the second floor in the second device body 200 through a ground terminal 202d.

The ground terminal 102a of the radiator A and the ground terminal 102c of the radiator C are close to each other. The ground terminal 202b of the radiator B and the ground terminal 202d of the radiator D are close to each other. That ground terminals of two radiators are close to each other includes that two ground terminals are connected to each other, but does not include the radiators.

When the electronic device is in the folded state, the radiator A and the radiator B are parallel to each other, and an opening end 103a of the radiator A and an opening end 203b of the radiator B face a same direction. The radiator C and the radiator D are parallel to each other, and an opening end 103c of the radiator C and an opening end 203d of the radiator D face a same direction. Projection overlapping exists between the radiator A and the radiator B. To be specific, a projection of the radiator A on the second device body 200 overlaps the radiator B. Projection overlapping exists between the radiator C and the radiator D. To be specific, a projection of the radiator C on the second device body 200 overlaps the radiator D. No projection overlapping exists between the radiator B and the radiator C. To be specific, a projection of the radiator C on the second device body 200 does not overlap the radiator B. Projection overlapping may or may not exist between the radiator A and the radiator D.

The opening end may be referred to as an open end.

The radiator A further includes a feed point 104a. The feed point 104a is connected to a radio frequency source 1 of the electronic device, so that a radio frequency signal transmitted by the radio frequency source 1 is fed, directly or through coupling, to the radiator A through a feeder of the radiator A. The radio frequency source 1 is disposed on the first mainboard of the first device body 100.

The radiator A to the radiator D may be coupled to a radiator of another antenna through a slot. Herein, an example in which the radiator A to the radiator D are disposed in the antenna 2 is used for description. The antenna 1 includes at least a radiator E and a radiator F. The antenna 3 includes at least a radiator G and a radiator H. In some possible cases, the radiator A and the radiator B may be respectively coupled to the radiator G and the radiator H to implement coupling between the antenna 2 and the antenna 3, and the radiator C and the radiator D may be respectively coupled to the radiator E and the radiator F to implement coupling between the antenna 2 and the antenna 1.

In some possible cases, when the electronic device is in the folded state, projection overlapping exists between the radiator E and the radiator F, to be specific, a projection of the radiator E on the second device body 200 overlaps the radiator F; and projection overlapping exists between the radiator G and the radiator H, to be specific, a projection of the radiator G on the second device body 200 overlaps the radiator H.

Herein, it should be understood that the four radiators shown in (1) in FIG. 2 are arranged in a linear shape. In another case, the four radiators may alternatively be arranged in another manner. Refer to (2) in FIG. 2. The four radiators may be arranged in a broken-line shape, and the four antennas still satisfy the foregoing fixed arrangements. The radiator A and the radiator C may be disposed at bezels of different types. For example, the radiator A is disposed at a horizontal bezel, and the radiator C is disposed at a vertical bezel. The radiator B and the radiator D may be disposed at bezels of different types. For example, the radiator B is disposed at a horizontal bezel, and the radiator D is disposed at a vertical bezel.

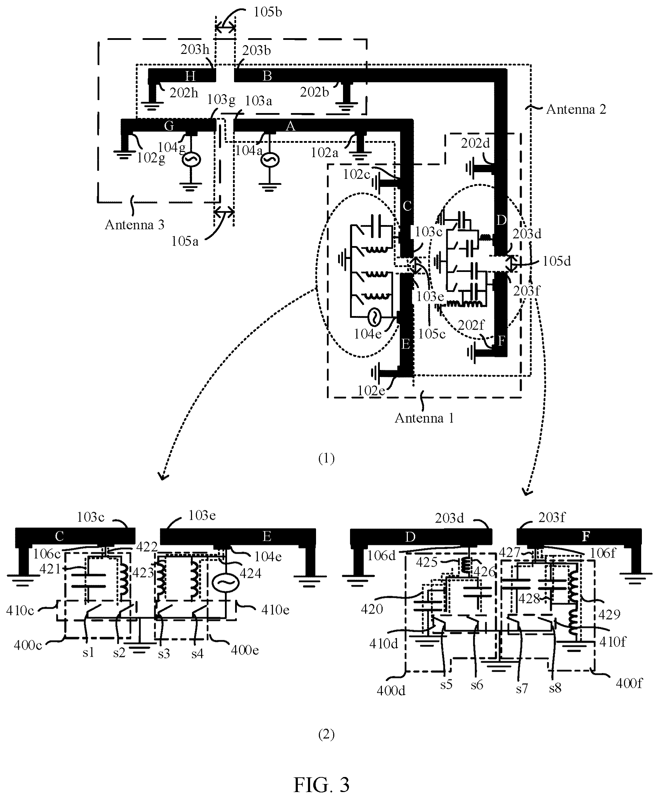

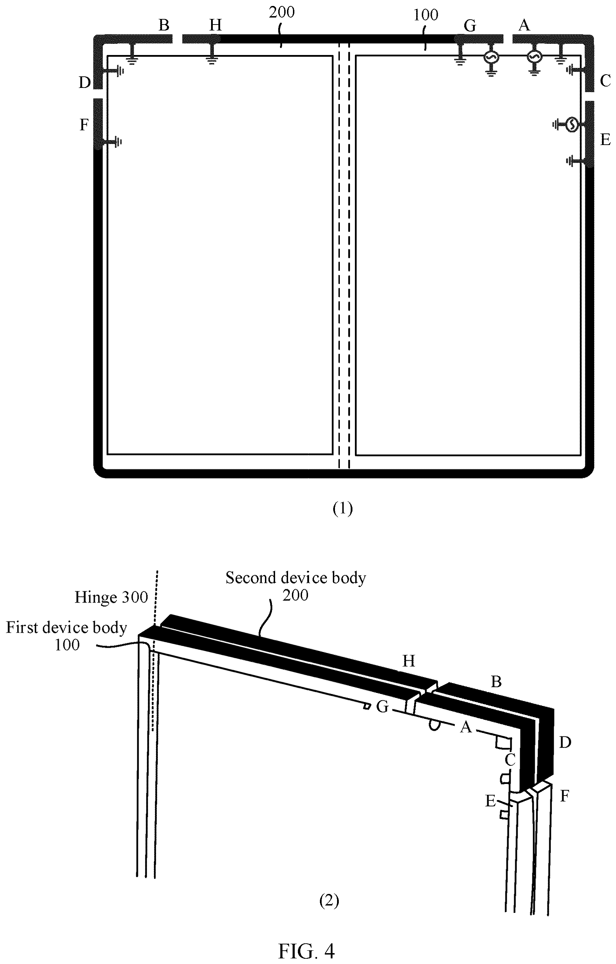

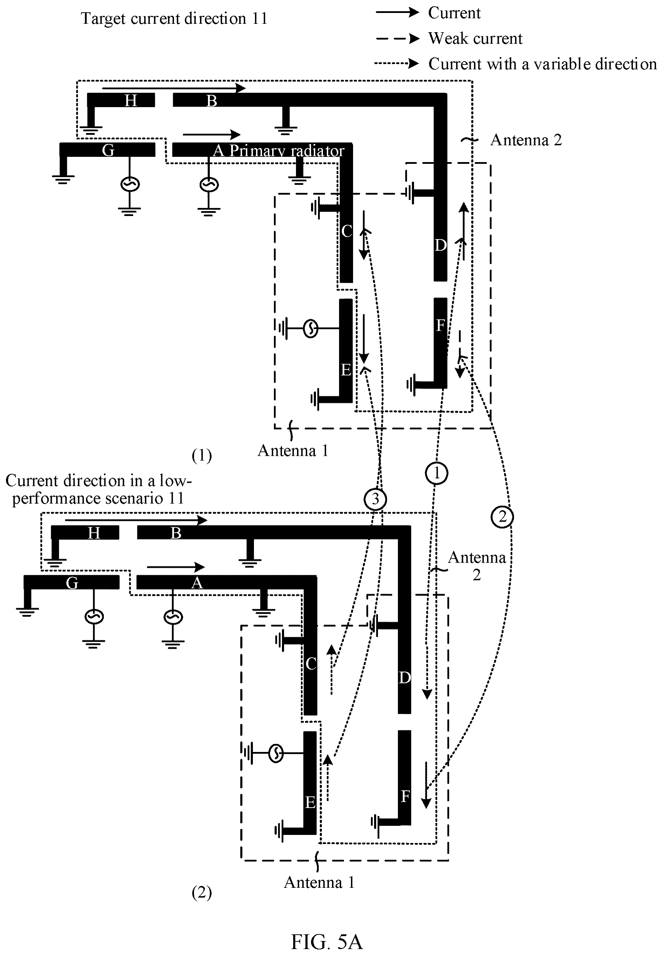

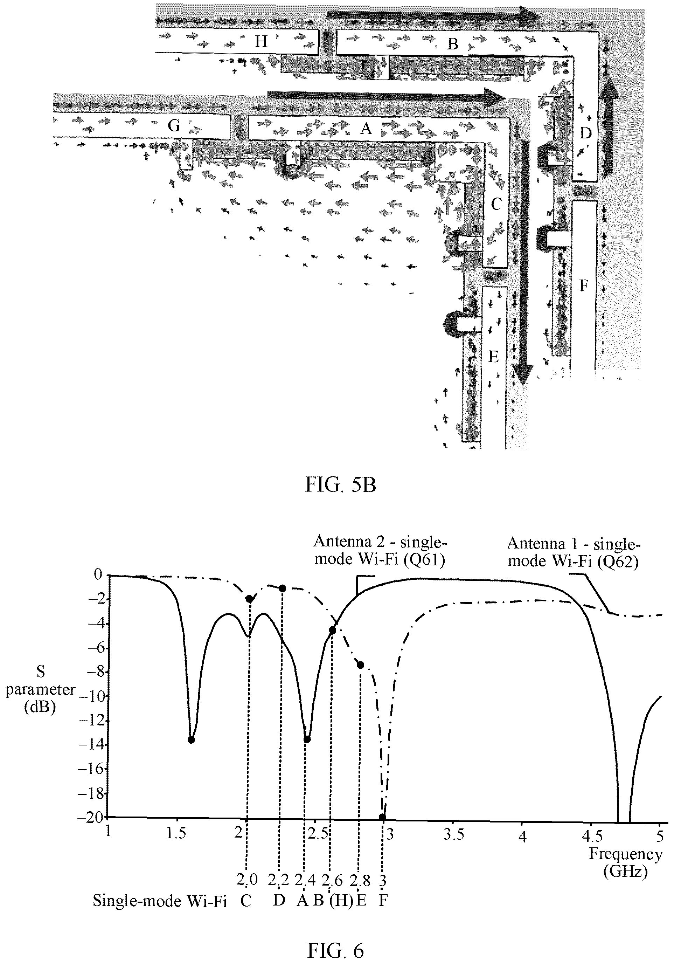

Herein, it should be understood that the diagram of the antenna structure shown in FIG. 2 is drawn based on an angle of view for ease of describing a solution, and the angle of view shown in FIG. 2 actually does not exist. In an actual case, when the electronic device is in the folded state, the antenna stub 1 in the first device body 100 and the antenna stub 2 in the second device body 200 overlap (refer to (2) in FIG. 4 below). For a specific overlapping relationship, refer to the foregoing related descriptions of overlapping relationships between radiators. Because the two antenna stubs overlap, blocking occurs during observation from different angles of view, and it is difficult to show details (for example, ground terminals) of radiators and a relative relationship between radiators in the antenna stubs from one angle of view. Therefore, to show details of the two antenna stubs on a same plane, the two antenna stubs are shown on a same plane in a staggered manner. In the following content, example diagrams in which this illustration manner is used further include FIG. 3, FIG. 5A, FIG. 5B, and the like. Persons skilled in the art may determine an actual position relationship between radiators in the antenna stubs with reference to related example diagrams and text descriptions. This shall not be construed as a limitation on this application.

**Embodiments of this application provide three antenna structures and frequency adjustment rules for different antenna structures, to improve performance of an antenna in the folded state.**

Herein, it should be understood that, in some possible cases, the frequency adjustment rules provided in embodiments of this application are applicable to a case in which the electronic device is in the folded state. For ease of description below, the electronic device is considered to be in the folded state by default. This is not to be emphasized with text.

**A first antenna structure is described below in detail.**

**FIG. 3 is an example diagram of the first antenna structure.**

As shown in (1) in FIG. 3, in the first antenna structure, an antenna 2 includes radiators arranged in a broken-line shape. The antenna 2 may include a radiator A, a radiator C, a radiator B, and a radiator D, and the four radiators satisfy the foregoing fixed arrangements. The radiator A is disposed at a bezel 1 of the first device body 100, and the radiator A is connected to a radio frequency source. For example, a feed point 104a of the radiator A is connected to a radio frequency source 1 of the electronic device. The radiator C is disposed at a bezel 2 of the first device body 100. A ground terminal 102a of the radiator A and a ground terminal 102c of the radiator C are disposed close to and opposite to each other. A bezel between the ground terminal 102a and the ground terminal 102c includes a bezel at a corner of the first device body 100. The radiator B is disposed at a bezel 1 of the second device body 200, and the radiator D is disposed at a bezel 2 of the second device body 200. A ground terminal 202b of the radiator B and a ground terminal 202d of the radiator D are disposed close to and opposite to each other. A bezel between the ground terminal 202b and the ground terminal 202d includes a bezel at a corner of the second device body 200. The radiator A to the radiator D satisfy the foregoing fixed arrangements. For related descriptions of the fixed arrangements, refer to the foregoing content. Details are not described herein again.

The bezel 1 of the first device body is perpendicular to the bezel 2 of the first device body. The bezel 1 of the second device body is perpendicular to the bezel 2 of the second device body.

In the first antenna structure, an antenna 1 may include a radiator E and a radiator F. The radiator E is disposed at the bezel 2 of the first device body 100, and the radiator E is connected to a radio frequency source. For example, a feed point 104e of the radiator E is connected to a radio frequency source 2 of the electronic device. The radiator F is disposed at the bezel 2 of the second device body 200. When the electronic device is in the folded state, the radiator E and the radiator F are parallel to each other, and an opening end 103e of the radiator E and an opening end 203f of the radiator F face a same direction. A ground terminal 102e of the radiator E is connected to the first floor in the first device body 100. A ground terminal 202f of the radiator F is connected to the second floor in the second device body 200. The radio frequency source 2 is different from the radio frequency source 1.

In the first antenna structure, an antenna 3 may include a radiator G and a radiator H. The radiator G is disposed at the bezel 1 of the first device body 100, and the radiator G is connected to a radio frequency source. For example, a feed point 104g of the radiator G is connected to a radio frequency source 3 of the electronic device. The radiator H is disposed at the bezel 1 of the second device body 200. When the electronic device is in the folded state, the radiator G and the radiator H are parallel to each other, and an opening end 103g of the radiator G and an opening end 203h of the radiator H face a same direction. A ground terminal 102g of the radiator G is connected to the first floor in the first device body 100. A ground terminal 202h of the radiator H is connected to the second floor in the second device body 200. The radio frequency source 3 is different from the radio frequency source 2 and the radio frequency source 1.

The antenna 2 is separately coupled to the antenna 1 and the antenna 3. A form of coupling between the antenna 2 and the antenna 1 includes: The radiator C is coupled to the radiator E through a slot 105c, and an opening end 103c of the radiator C and the opening end 103e of the radiator E are arranged opposite to each other. The radiator D is coupled to radiator F through a slot 105d, and an opening end 203d of the radiator D and the opening end 203f of the radiator F are arranged opposite to each other.

A form of coupling between the antenna 2 and the antenna 3 includes: The radiator A is coupled to the radiator G through a slot 105a, and the opening end 103g of the radiator G and an opening end 103a of the radiator A are arranged opposite to each other. The radiator B is coupled to radiator H through a slot 105b, and an opening end 203b of the radiator B and the opening end 203h of the radiator H are arranged opposite to each other.

When the antenna 2 is coupled to the antenna 1 and the antenna 3, the antenna 2 may share the radiator C, the radiator D, and the radiator F with the antenna 1, and the antenna 2 may share the radiator B and the radiator H with the antenna 1. This may be referred to as that the antenna 2 includes the radiator A to the radiator D and further includes the radiator H and the radiator F, the antenna 1 includes the radiator E, the radiator F, the radiator C, and the radiator D, and the antenna 3 includes the radiator G, the radiator H, and the radiator B.

In addition to the structural arrangements described above, in some possible cases, the first antenna structure may further include, but is not limited to, one or more of the following structural arrangements.

Structural arrangement 11: A length of the radiator G is greater than a length of the radiator H.

Structural arrangement 12: A length of the radiator E is greater than a length of the radiator F.

Structural arrangement 13: A position of the slot 105a on the first device body 100 is the same as a position of the slot 105b on the second device body 200. That is, projections of the slot 105a and the slot 105b completely overlap.

Structural arrangement 14: A position of the slot 105c on the first device body 100 is the same as a position of the slot 105d on the second device body 200. That is, projections of the slot 105a and the slot 105b completely overlap.

Herein, it should be understood that, in this embodiment of this application, that projections completely overlap means that the projections highly overlap, with an error allowed.

As shown in (2) in FIG. 3, the electronic device may further include a frequency control circuit 400c, a frequency control circuit 400e, a frequency control circuit 400d, and a frequency control circuit 400f.

A connection point 106c of the radiator C is connected to the first floor in the first device body 100 through the frequency control circuit 400c. The frequency control circuit 400c includes a switch device 410c and a plurality of frequency adjustment branches C1 arranged in parallel. The switch device 410c is configured to be gated to at least one frequency adjustment branch C1, to adjust a frequency of the radiator C. The switch device 410c may include at least one switch unit. The switch device 410c may be gated to at least one frequency adjustment branch C1 by switching the switch unit between on (ON) and off (OFF). For example, the plurality of frequency adjustment branches C1 may include a frequency adjustment branch 421 and a frequency adjustment branch 422. The frequency adjustment branch 421 is connected to a switch unit s1, and the switch unit s1 is configured to control whether to turn on the frequency adjustment branch 421. The frequency adjustment branch 422 is connected to a switch unit s2, and the switch unit s2 is configured to control whether to turn on the frequency adjustment branch 422. A case in which the switch device 410c controls the switch unit s1 to be on (ON) and controls the switch unit s2 to be off (OFF) indicates that the switch device 410c is gated to the frequency adjustment branch 421 and is not gated to the frequency adjustment branch 422. For other cases of gating of the switch device 410c, refer to the foregoing descriptions. Details are not described herein again.

In some possible cases, the connection point 106c is provided at a position close to the opening end 103c of the radiator C.

The feed point 104e of the radiator E is connected to the first floor in the first device body 100 through the frequency control circuit 400e. The frequency control circuit 400e includes a switch device 410e and a plurality of frequency adjustment branches E11 arranged in parallel. The switch device 410e is configured to be gated to at least one frequency adjustment branch E11, to adjust a frequency of the radiator E. The switch device 410e may include at least one switch unit. The switch device 410e may be gated to at least one frequency adjustment branch E11 by switching the switch unit between on (ON) and off (OFF). For example, the plurality of frequency adjustment branches E11 may include a frequency adjustment branch 423 and a frequency adjustment branch 424. The frequency adjustment branch 423 is connected to a switch unit s3, and the switch unit s3 is configured to control whether to turn on the frequency adjustment branch 423. The frequency adjustment branch 424 is connected to a switch unit s4, and the switch unit s4 is configured to control whether to turn on the frequency adjustment branch 424. A case in which the switch device 410e controls the switch unit s3 to be on (ON) and controls the switch unit s4 to be off (OFF) indicates that the switch device 410e is gated to the frequency adjustment branch 423 and is not gated to the frequency adjustment branch 424. For other cases of gating of the switch device 410e, refer to the foregoing descriptions. Details are not described herein again.

In some possible cases, the feed point 104e is arranged at a position close to the opening end 103e of the radiator E.

A connection point 106d of the radiator D is connected to the second floor in the second device body 200 through the frequency control circuit 400d. The frequency control circuit 400d includes a switch device 410d and a plurality of frequency adjustment branches D1 arranged in parallel. The switch device 410d is configured to be gated to at least one frequency adjustment branch D1, to adjust a frequency of the radiator D. The switch device 410d may include at least one switch unit. The switch device 410d may be gated to at least one frequency adjustment branch D1 by switching the switch unit between on (ON) and off (OFF). For example, the plurality of frequency adjustment branches D1 may include a frequency adjustment branch 420, a frequency adjustment branch 425, and a frequency adjustment branch 426. The frequency adjustment branch 425 is connected to a switch unit s5, and the switch unit s5 is configured to control whether to turn on the frequency adjustment branch 425. The frequency adjustment branch 426 is connected to a switch unit s6, and the switch unit s6 is configured to control whether to turn on the frequency adjustment branch 426. A case in which the switch device 410d controls the switch unit s5 to be on (ON) and controls the switch unit s6 to be off (OFF) indicates that the switch device 410d is gated to the frequency adjustment branch 425 and is not gated to the frequency adjustment branch 426. A case in which both the switch unit s5 and the switch unit s6 are turned off (OFF) indicates that the switch device 410d is gated to the frequency adjustment branch 420. For other cases of gating of the switch device 410d, refer to the foregoing descriptions. Details are not described herein again.

In some possible cases, the connection point 106d is provided at a position close to the opening end 203d of the radiator D.

A connection point 106f of the radiator F is connected to the second floor in the second device body 200 through the frequency control circuit 400f. The frequency control circuit 400f includes a switch device 410f and a plurality of frequency adjustment branches F arranged in parallel. The switch device 410f is configured to be gated to at least one frequency adjustment branch F, to adjust a frequency of the radiator F. The switch device 410f may include at least one switch unit. The switch device 410f may be gated to at least one frequency adjustment branch F by switching the switch unit between on (ON) and off (OFF). For example, the plurality of frequency adjustment branches F may include a frequency adjustment branch 429, a frequency adjustment branch 427, and a frequency adjustment branch 428. The frequency adjustment branch 427 is connected to a switch unit s7, and the switch unit s7 is configured to control whether to turn on the frequency adjustment branch 427. The frequency adjustment branch 428 is connected to a switch unit s8, and the switch unit s8 is configured to control whether to turn on the frequency adjustment branch 428. A case in which the switch device 410f controls the switch unit s7 to be on (ON) and controls the switch unit s8 to be off (OFF) indicates that the switch device 410f is gated to the frequency adjustment branch 427 and is not gated to the frequency adjustment branch 428. A case in which both the switch unit s7 and the switch unit s8 are turned off (OFF) indicates that the switch device 410f is gated to the frequency adjustment branch 429. For other cases of gating of the switch device 410f, refer to the foregoing descriptions. Details are not described herein again.

In some possible cases, the connection point 106f is provided at a position close to the opening end 203f of the radiator F.

Herein, it should be understood that each matching branch may include one or more lumped elements, for example, one or more of lumped elements such as a resistor, a capacitor, and an inductor. Lumped elements included in different matching branches may be different. The being different includes that types, parameter values, quantities, or the like of the lumped elements are different.

**FIG. 4 shows example arrangements of radiators in the electronic device in the first antenna structure.**

For ease of observation, related content in (1) in FIG. 4 is shown by using an example in which the electronic device is in the unfolded state. (2) in FIG. 4 shows example arrangements of radiators in the electronic device in the folded state.

As shown in FIG. 4, the radiator G, the radiator A, the radiator C, and the radiator E are disposed in the first device body 100 of the electronic device. The radiator A and the radiator G are disposed at a horizontal bezel, and the radiator C and the radiator E are disposed at a vertical bezel. That is, the radiator A and the radiator C are disposed at a bezel at a corner of the first device body 100.

The radiator H, the radiator B, the radiator D, and the radiator F are disposed in the second device body 200 of the electronic device. The radiator B and the radiator H are disposed at a horizontal bezel, and the radiator D and the radiator F are disposed at a vertical bezel. That is, the radiator D and the radiator B are disposed at a bezel at a corner of the second device body 200. The first device body 100 and the second device body 200 are connected through the hinge 300.

**How to perform frequency adjustment based on the first antenna structure to improve performance of an antenna in the folded state is described below in detail.**

When an antenna structure is the first antenna structure, an operating frequency band (a frequency range) of the antenna 1 may include one or both of a mid-high band (MHB) frequency band and an N78 frequency band. In this case, the antenna 1 may be responsible for providing one or more of 2G/3G/4G/5G communication modes for the electronic device. An operating frequency band of the antenna 2 includes one or more of a GPS frequency band or a Wi-Fi 2.4G frequency band. In this case, the antenna 2 may be responsible for providing GPS communication and 2.4G Wi-Fi communication for the electronic device. An operating frequency band of the antenna 3 includes the N78 frequency band or a Wi-Fi 5G frequency band. In this case, the antenna 3 may be responsible for providing 5G communication and 5G Wi-Fi communication for the electronic device.

The mid-high band (MHB) frequency band is usually 1.700 GHz to 2.700 GHz. The N78 frequency band is usually 3.400 GHz to 3.600 GHz. The GPS frequency band is usually 1.2280 GHz to 1.6750 GHz. The Wi-Fi 2.4G frequency band is usually 2.400 GHz to 2.4835 GHz. The Wi-Fi 5G frequency band is usually 2.484 GHz to 4.915 GHz. The 2G/3G/4G/5G communication may be collectively referred to as cellular network communication.

Herein, it should be understood that the operating frequency bands of the antennas and the communication modes that the antennas are responsible for providing are examples for description. In different cases, different operating frequency bands may be used, and provided communication modes may also be different. This is not limited in embodiments of this application.

The 2.4G Wi-Fi communication and the 5G Wi-Fi communication may be collectively referred to as Wi-Fi communication. The 2.4G Wi-Fi communication indicates that an operating frequency of the antenna 2 is the Wi-Fi 2.4G frequency band. The 5G Wi-Fi communication indicates that an operating frequency of the antenna 2 is the Wi-Fi 5G frequency band.

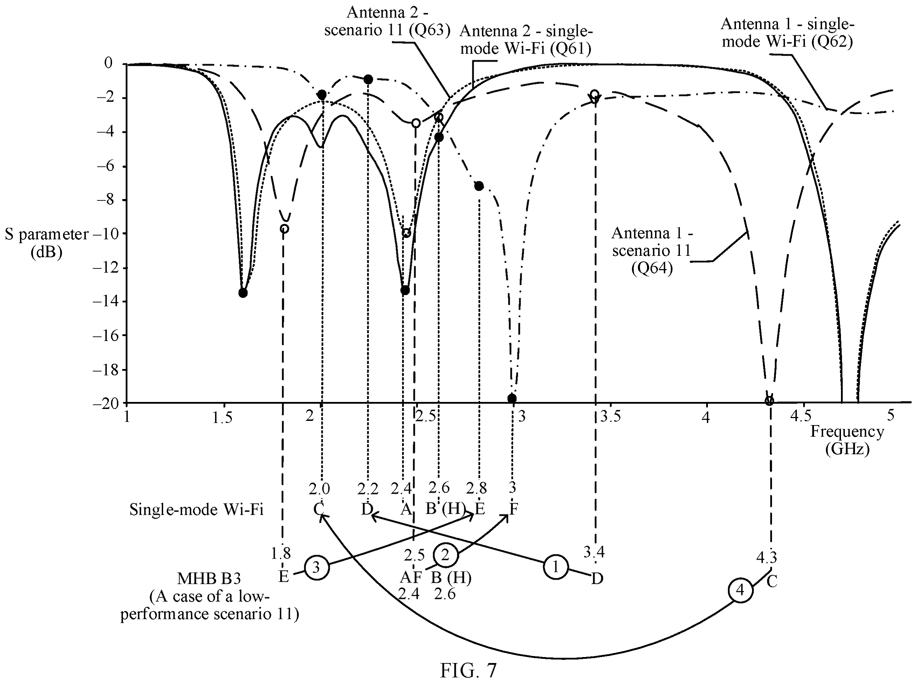

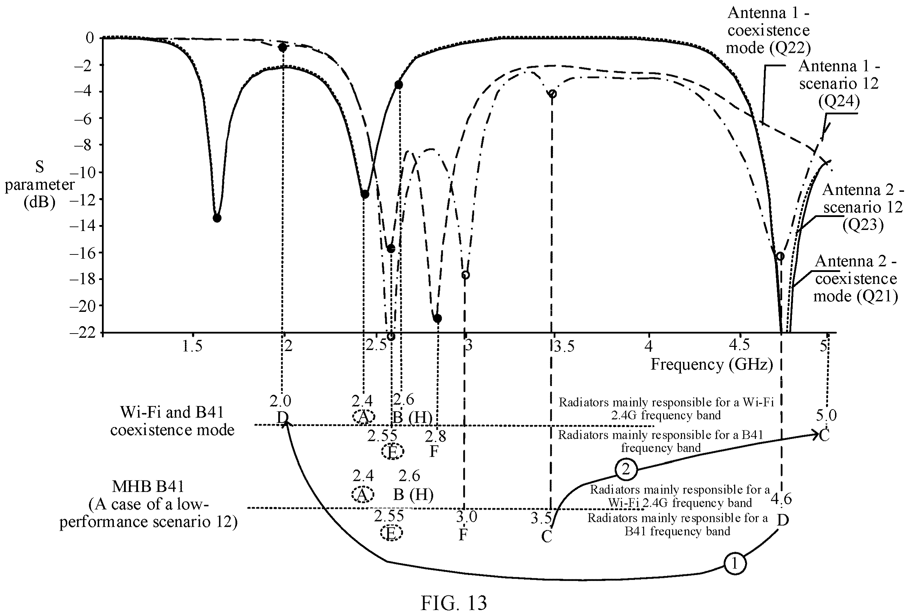

Operating frequencies of the antenna 1 to the antenna 3 may be adjusted according to a preset frequency adjustment rule 11, to enable each antenna to perform resonance on at least one target operating frequency, to provide the electronic device with various communication modes, including one or more of the 2G/3G/4G/5G communication, the GPS communication, the 2.4G Wi-Fi communication, and the 5G Wi-Fi communication. At least one target operating frequency corresponding to an antenna belongs to an operating frequency band of the antenna. The preset frequency adjustment rule 11 may include a frequency adjustment rule 11a and a frequency adjustment rule 11b below. For related descriptions of the frequency adjustment rule 11a and the frequency adjustment rule 11b, refer to the following content. For example, for the preset frequency adjustment rule 11a, refer to the following descriptions of related content in FIG. 7. For the preset frequency adjustment rule 11b, refer to the following descriptions of related content in FIG. 13.

However, when the operating frequencies of the antenna 1 to the antenna 3 are adjusted according to the preset frequency adjustment rule 11, the following low-performance scenario may appear: When performance of an antenna (an antenna A) responsible for providing a communication mode A is low, the foldable-screen electronic device has a poor communication capability when communicating with another electronic device in the communication mode A. The following describes two example low-performance scenarios (a low-performance scenario 11 and a low-performance scenario 12) that appear when the first antenna structure is arranged in the electronic device and the preset frequency adjustment rule 11 is used, and solutions for the low-performance scenarios.

**Low-performance scenario 11:**

When the operating frequencies of the antenna 1 to the antenna 3 are adjusted according to the preset frequency adjustment rule 11a and the 2.4G Wi-Fi communication is enabled for the electronic device but the cellular network communication is not enabled, the antenna 2 has low performance when operating on the Wi-Fi 2.4G frequency band. Consequently, the electronic device has a poor communication capability when communicating with another electronic device in single-mode Wi-Fi. The single-mode Wi-Fi indicates that the 2.4G Wi-Fi communication is enabled and the cellular network communication is not enabled.

Herein, it should be understood that, in the single-mode Wi-Fi, the electronic device may retain communication with another electronic device in the 2.4G Wi-Fi communication mode, and may not use the cellular network communication, but the electronic device still has a capability of using the cellular network communication. That is, in this case, the cellular network communication mode may be in an enabled state, and the electronic device may use a service, for example, make a call, in the cellular network communication mode.

For a cause of low performance of the antenna 2 operating on the Wi-Fi 2.4G frequency band in the low-performance scenario 11, refer to the following descriptions of FIG. 7. Details are not described herein.

**An improvement manner for the low-performance scenario 11 and related content thereof are described below.**

In the low-performance scenario 11, based on the first antenna structure in this application, the electronic device may re-adjust, according to a preset frequency adjustment rule 21a, operating frequencies of the antenna 2 and the antenna 1 coupled thereto, to adjust current directions of radiators in the antenna 1 and the antenna 2 to a target current direction (denoted as a target current direction 11). The target current direction 11 is a current direction satisfying the single-mode Wi-Fi when the first antenna structure is used. The radiators in the antenna 1 and the antenna 2 may be responsible for providing the 2.4G Wi-Fi communication mode, to improve performance of the antenna 2, and therefore improve a communication capability of the electronic device during communication with another electronic device in the 2.4G Wi-Fi communication mode. The antenna 1 is an antenna responsible for providing the cellular network communication. Because the communication mode for which the antenna 1 is responsible is not enabled for the electronic device in the low-performance scenario 11, an operating frequency of the antenna 1 may be adjusted to use the antenna 1 to assist the antenna 2 in improving performance.

When the electronic device is in the single-mode Wi-Fi, a scenario in which the operating frequencies of the antenna 2 and the antenna 1 coupled thereto are re-adjusted according to the preset frequency adjustment rule 21a may be referred to as a single-mode Wi-Fi scenario.

Herein, it should be understood that, if a communication mode for which another antenna (for example, the antenna 3) is responsible is not enabled, an operating frequency of the another antenna may also be adjusted to use the another antenna to assist the antenna 2 in improving performance. Refer to the descriptions of the adjustment manner for the antenna 1. Details are not described herein again.

It should be further understood that an antenna (for example, the antenna 1) other than the antenna 2 may alternatively not be used to assist the antenna 2 in improving performance, and performance of the antenna 2 may be improved through cooperation between some or all of radiators in the antenna 2.

**First, a reason for generating the target current direction is described.**

It should be understood that the reason for generating the target current direction may include: In the antenna 1 and the antenna 2, when a current generated on a parasitic radiator meeting a condition 1 is in a same direction as a current generated on a primary radiator, and a current generated on a parasitic radiator meeting a condition 2 is in a direction opposite to a direction of a current generated on the primary radiator, performance of the antenna 2 can be improved. Currents generated on a larger quantity of parasitic radiators meeting the condition 1 being in a same direction as the current generated on the primary radiator, or currents generated on a larger quantity of parasitic radiators meeting the condition 2 being in a direction opposite to the direction of the current generated on the primary radiator indicates a larger improvement of performance of the antenna 2. A current generated by a radiator meeting a condition 3 should be weak (close to having no current), to avoid adverse impact on the primary radiator.

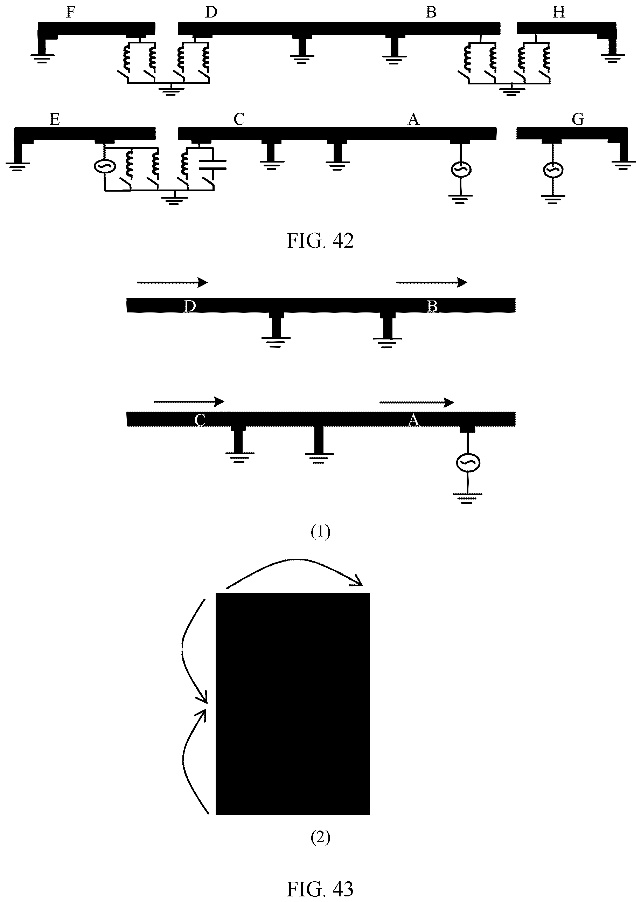

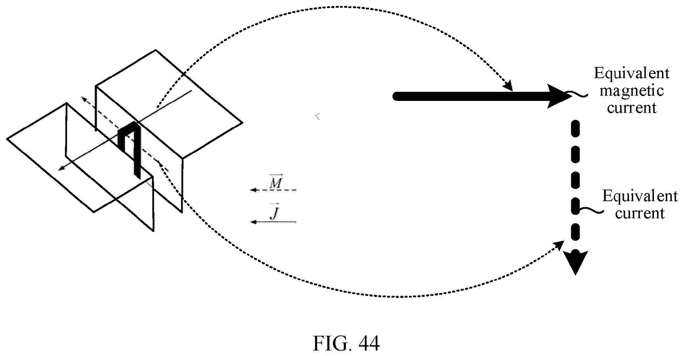

For related descriptions of the phenomenon that currents generated on a larger quantity of parasitic radiators meeting the condition 1 being in a same direction as the current generated on the primary radiator indicates a larger improvement of performance of the antenna 2 (including the primary radiator), refer to the following descriptions of FIG. 43 and related content thereof. Details are not described herein. For related descriptions of the phenomenon that currents generated on a larger quantity of parasitic radiators meeting the condition 2 being in a direction opposite to the direction of the current generated on the primary radiator indicates a larger improvement of performance of the antenna 2, refer to the following descriptions of FIG. 44 and related content thereof. Details are not described herein.

Herein, it should be understood that the primary radiator includes a radiator whose operating frequency belongs to a frequency band corresponding to a communication mode enabled for the electronic device. The parasitic radiator includes a radiator other than the primary radiator, for example, a radiator not provided with a feed point, or a radiator provided with a feed point connected to a radio frequency source that does not transmit a radio frequency signal. For example, when the electronic device is in the single-mode Wi-Fi, the primary radiator may be a radiator A, and an operating frequency of the radiator A belongs to the Wi-Fi 2.4G frequency band. All radiators in the antenna 1 may serve as parasitic radiators to improve performance of the radiator A. To be specific, a radiator E provided with a feed point may also be a parasitic radiator. When the electronic device is in a Wi-Fi and B41 coexistence mode, a radiator A in the antenna 2 is a primary radiator, and an operating frequency of the radiator A belongs to the Wi-Fi 2.4G frequency band. A radiator E in the antenna 1 is a primary radiator, and an operating frequency of the radiator E belongs to a B41 frequency band. Other radiators may serve as parasitic radiators of the radiator A or the radiator E. Some radiators may alternatively serve as parasitic radiators of both the radiator A and the radiator E. In a specific case, refer to the following related descriptions. Details are not described herein.

Herein, it should be understood that, in some possible cases, a same radiator may serve as both a parasitic radiator and a primary radiator. This specifically depends on a relationship between a current distributed on the radiator and another radiator.

A parasitic radiator meeting the condition 1 includes a parasitic radiator on a same side as the primary radiator, or a parasitic radiator parallel to the primary radiator. A parasitic radiator meeting the condition 2 includes a parasitic radiator not on a same side as the primary radiator, or a parasitic radiator that is not parallel to the primary radiator and that is close (for example, closest) to the primary radiator. A parasitic radiator meeting the condition 3 includes a parasitic radiator not on a same side as the primary radiator, or a parasitic radiator that is not parallel to the primary radiator and that is away from (not closest to) the primary radiator. That two radiators are on a same side means that the two radiators are both disposed in the first device body 100 or the two radiators are both disposed in the second device body 200. That two radiators are not on a same side means that one of the two radiators is disposed in the first device body 100 and the other is disposed in the second device body 200. That two radiators are parallel to each other means that the two radiators are both located at a horizontal bezel or are both located at a vertical bezel. That two radiators are not parallel to each other means that one radiator is located at a horizontal bezel and the other radiator is located at a vertical bezel. With reference to the foregoing related content and FIG. 3, when the primary radiator is the radiator A, the parasitic radiator meeting the condition 1 may include the radiator C, the radiator B, the radiator H, and the radiator E, the parasitic radiator meeting the condition 2 may include the radiator D, and the parasitic radiator meeting the condition 3 may include the radiator F.

In the following content, a radiator meeting the condition 1 may be referred to as a first-type radiator, a radiator meeting the condition 2 may be referred to as a second-type radiator, and a radiator meeting the condition 3 may be referred to as a third-type radiator.

After generating a current, the primary radiator may excite a parasitic radiator coupled to the primary radiator to generate a current. When one parasitic radiator is simultaneously excited by two or more primary radiators, the parasitic radiator may have (have a distribution of) currents in two directions. A main direction of a current generated by the parasitic radiator may mainly depend on the parasitic radiator and a primary radiator having a highest degree of coupling to the parasitic radiator. In some possible cases, it can be considered that a shorter distance between a parasitic radiator and a primary radiator indicates a higher degree of coupling. When ground terminals of the parasitic radiator and the primary radiator are close to each other, the distance may be 0.

In the antenna structure provided in this application, directions of currents generated by radiators have the following cases: A direction of a current generated by a parasitic radiator may mainly depend on the parasitic radiator and a primary radiator having a highest degree of coupling to the parasitic radiator, for example, depend on a position relationship between the parasitic radiator and the primary radiator and a frequency magnitude relationship between the parasitic radiator and the primary radiator.

As shown in Table 1, when a primary radiator and a parasitic radiator are on a same side and ground terminals are close, if a frequency of the primary radiator is lower than a frequency of the parasitic radiator, currents of the two radiators are in opposite directions; or if a frequency of the primary radiator is higher than a frequency of the parasitic radiator, currents of the two radiators are in a same direction. When a primary radiator and a parasitic radiator are on a same side and ground terminals are not close to each other (for example, opening ends are arranged opposite to each other), if a frequency of the primary radiator is lower than a frequency of the parasitic radiator, currents of the two radiators are in a same direction; or if a frequency of the primary radiator is higher than a frequency of the parasitic radiator, currents of the two radiators are in opposite directions. When a primary radiator and a parasitic radiator are not on a same side, the parasitic radiator is referred to as an opposite-side parasitic radiator of the primary radiator. In this case, if a frequency of the primary radiator is lower than a frequency of the parasitic radiator, currents of the two radiators are in a same direction; or if a frequency of the primary radiator is higher than a frequency of the parasitic radiator, currents of the two radiators are in opposite directions.

**Table 1**

| Primary radiator having a highest degree of coupling to a parasitic radiator | Position relationship | A frequency of the primary radiator is lower than a frequency of the parasitic radiator | A frequency of the primary radiator is higher than a frequency of the parasitic radiator |
|---|---|---|---|
| Same-side parasitic radiator | Ground terminals are close. | Currents are in opposite directions. | Currents are in a same direction. |
| Same-side parasitic radiator | Ground terminals are not close. | Currents are in a same direction. | Currents are in opposite directions. |
| Opposite-side parasitic radiator | - | Currents are in a same direction. | Currents are in opposite directions. |

Based on Table 1, an example in which a radiator A is a primary radiator is used to describe a relationship between current directions of several parasitic radiators of the radiator A and a current direction of the radiator A. As shown in Table 2, a radiator C and the radiator A are on a same side and ground terminals are close. When a frequency of the radiator A is lower than a frequency of the radiator C, current directions of the two radiators are opposite; otherwise, current directions of the two radiators are the same. A radiator E and the radiator A are on a same side and ground terminals are not close. When the frequency of the radiator A is lower than a frequency of the radiator E, current directions of the two radiators are the same; otherwise, current directions of the two radiators are opposite. A radiator B (or a radiator D) and the radiator A are not on a same side. When the frequency of the radiator A is lower than a frequency of the radiator B (or the radiator D), current directions of the two radiators are the same; otherwise, current directions of the two radiators are opposite. For relationships between currents of other parasitic radiators and the primary radiator, refer to related descriptions in Table 1 and Table 2. Details are not described herein.

**Table 2**

| Parasitic radiator | Position relationship with the radiator A (primary radiator) | A frequency of the primary radiator is lower than a frequency of the parasitic radiator | A frequency of the primary radiator is higher than a frequency of the parasitic radiator |
|---|---|---|---|
| Radiator C | On a same side, with ground terminals close to each other | Currents are in opposite directions. | Currents are in a same direction. |

(continued)

| Parasitic radiator | Position relationship with the radiator A (primary radiator) | A frequency of the primary radiator is lower than a frequency of the parasitic radiator | A frequency of the primary radiator is higher than a frequency of the parasitic radiator |
|---|---|---|---|
| Radiator E | On a same side, with ground terminals not close to each other | Currents are in a same direction. | Currents are in opposite directions. |
| Radiator B | Not on a same side | Currents are in a same direction. | Currents are in opposite directions. |
| Radiator D | Not on a same side | Currents are in a same direction. | Currents are in opposite directions. |

Herein, it should be understood that, for two adjacent parasitic radiators that are on a same side and whose opening ends are arranged opposite to each other, if an electrical length of one parasitic radiator (a parasitic radiator 1) is less than a preset length value 1 and an electrical length of the other parasitic radiator (a parasitic radiator 2) is greater than the preset length value 1, the parasitic radiator 2 and the parasitic radiator 1 may be considered as one parasitic radiator with the parasitic radiator 2 as a main radiator. In this case, a current direction of the parasitic radiator 1 does not depend on a primary radiator having a highest degree of coupling to the parasitic radiator 1, but is the same as a current direction of the parasitic radiator 2. The current direction of the parasitic radiator 2 depends on a primary radiator having a highest degree of coupling to the parasitic radiator 2.

It should be further understood that, when one of two radiators is located at a horizontal bezel and the other radiator is located at a vertical bezel, currents generated by the two radiators being in a same direction includes: After radiators arranged in a broken-line shape are equivalent to being arranged in a linear shape, currents generated by the two radiators are in a same direction. Currents generated by the two radiators being in opposite directions includes: After radiators arranged in a broken-line shape are equivalent to being arranged in a linear shape, currents generated by the two radiators are in opposite directions.

**FIG. 5A is a diagram of comparison between a current direction in the single-mode Wi-Fi scenario and a current direction in the low-performance scenario 11.**

**FIG. 5B is a simulation diagram of example current distribution when the electronic device is in the single-mode Wi-Fi.**

**Based on the foregoing reason for generating the target current direction, a target current direction 11 proposed for the single-mode Wi-Fi scenario is described below in detail with reference to FIG. 5A and FIG. 5B.**

**(1) in FIG. 5A is a diagram of a target current direction 11.**

(1) in FIG. 5A shows expected current directions (the target current direction 11) of the radiators in the antenna 1 and the antenna 2 when the operating frequencies of the antenna 2 and the antenna 1 coupled thereto are re-adjusted according to the preset frequency adjustment rule 21a.

When the electronic device is in the single-mode Wi-Fi, the antenna 2 is responsible for providing the 2.4G Wi-Fi communication mode for the electronic device, the radiator A is a primary radiator, and the radiator H, the radiator B, the radiator D, the radiator F, the radiator C, and the radiator E are parasitic radiators. Based on the foregoing content, the radiator H, the radiator B, the radiator C, and the radiator E are first-type radiators, and directions of expected currents generated by the radiators are the same as a direction of a current of the radiator A. The radiator D is a second-type radiator, and a direction of an expected current generated by the radiator D is opposite to the direction of the current of the radiator A. The radiator F is a third-type radiator, and an expected current generated by the radiator F is weak, to avoid interference to the radiator A.

In some possible cases, that a current of the radiator F is weak includes that the current of the radiator F is weaker than the current of the radiator A.

It should be understood that an example in which a current direction of the radiator A (primary radiator) is a direction shown in (1) in FIG. 5A is used for description herein. In an actual case, the current direction of the radiator A may alternatively be opposite to the direction shown in (1) in FIG. 5A. This is not limited in this embodiment of this application.

**(2) in FIG. 5A shows a current direction in the low-performance scenario 11.**

With reference to (2) in FIG. 5A and (1) in FIG. 5A, the following describes in detail causes of improvement of performance of the antenna 2 when the electronic device is in the single-mode Wi-Fi after a frequency adjustment rule in this application is used.

Refer to (2) in FIG. 5A. In the low-performance scenario 11, a cause of low performance of the antenna 2 includes but is not limited to one or more of the following causes.

**Cause of low performance 11-1:** The radiator D is a second-type radiator, but a current of the radiator D is in a same direction as a current of the radiator A. Resonance generated when the current of the radiator D is in a same direction as the current of the radiator A has adverse impact on the radiator A.

It can be learned from (1) in FIG. 5A and (2) in FIG. 5A that, for the cause of low performance 11-1, a first change is made: The current of the radiator D changes from being in a same direction as the current of the radiator A to being in a direction opposite to a direction of the current of the radiator A, so that performance of the antenna 2 can be improved. The first change for the cause of low performance 11-1 is indicated by a white circle ① in FIG. 5A.

It should be understood that a reason for changing the current of the radiator D from being in a same direction as the current of the radiator A to being in a direction opposite to the direction of the current of the radiator A lies in: Although the radiator D is a parasitic radiator of the radiator A, the radiator D is not on a same as the radiator A, is not parallel to the radiator A, and is close to the radiator A. In this case, resonance generated when the current of the radiator D and the current of the radiator A are in opposite directions has forward parasitic radiation effect on the radiator A, so that performance of the antenna 2 can be improved.

**Cause of low performance 11-2:** The radiator F is a third-type radiator, but a current of the radiator F is strong and causes adverse impact on the radiator A.

It can be learned from (1) in FIG. 5A and (2) in FIG. 5A that, for the cause of low performance 11-2, a second change is made: The current of the radiator F is weakened to reduce adverse impact on the antenna 2, so that performance of the antenna 2 can be improved. The first change for the cause of low performance 11-2 is indicated by a white circle ② in FIG. 5A.

**Cause of low performance 11-3:** The radiator H, the radiator B, the radiator C, and the radiator E are first-type radiators. Currents generated by the radiator H and the radiator B are in a same direction as a current of the radiator A (primary radiator), but currents generated by the radiator C and the radiator E are in a direction opposite to a direction of the current of the radiator A, leading to degradation of performance of the antenna 2.

It can be learned from (1) in FIG. 5A and (2) in FIG. 5A that, for the cause of low performance 11-3, a third change is made: The currents generated by the radiator C and the radiator E change from being in a direction opposite to the direction of the current of the radiator A (primary radiator) to being in a same direction as the current of the radiator A, so that performance of the antenna 2 can be improved. The third change for the cause of low performance 11-3 is indicated by a white circle ③ in FIG. 5A.

FIG. 5B is a simulation diagram of example current distribution when the electronic device is in the single-mode Wi-Fi. The current distribution corresponds to the target current direction 11 shown in (1) in FIG. 5A. Among the radiator B to the radiator E, a current direction of the radiator D is opposite to a current direction of the radiator A, and current directions of other radiators are the same as the current direction of the radiator A. In addition, a current of the radiator F is weak.

**The preset frequency adjustment rule 21a for adjusting the target current direction 11 is further described.**

In some possible cases, the preset frequency adjustment rule 21a is used for adjusting a frequency magnitude relationship between the radiator A (primary radiator) and parasitic radiators of the radiator A when the electronic device is in the single-mode Wi-Fi, to enable currents distributed on the radiators to satisfy the target current direction 11.

The preset frequency adjustment rule 21a may include: In the first antenna structure, when the electronic device is in the single-mode Wi-Fi, an operating frequency (denoted as an operating frequency A) of the radiator A (primary radiator) is adjusted to belong to the Wi-Fi 2.4G frequency band. For example, the operating frequency A may be 2.4 GHz. An operating frequency of the radiator C is adjusted to be less than and close to the operating frequency A. An operating frequency of the radiator D is adjusted to be less than and close to the operating frequency A. An electrical length of the radiator B is set to be greater than the preset length value 1, and an electrical length of the radiator H is set to be less than the preset length value 1, so that the radiator B and the radiator H can be considered as one parasitic radiator with the radiator B as a main radiator, and the radiator H and the radiator B can be considered as having a same frequency. An operating frequency of the radiator B is adjusted to be greater than and close to the operating frequency A. An operating frequency of the radiator E is adjusted to be greater than and close to the operating frequency A. An operating frequency of the radiator F is adjusted to be greater than the operating frequency A. A difference between the operating frequency of the radiator F and the operating frequency A is large (for example, is the largest on frequency bands corresponding to the radiators), so that an expected current generated by the radiator F is weak, to avoid interference to the radiator A.

In some possible cases, an operating frequency of a radiator closer to the radiator A (primary radiator) may be set to be closer to the operating frequency A. Because distances from the radiator B, the radiator E, and the radiator F to the radiator gradually increase, radiators in ascending order of frequencies in the single-mode Wi-Fi scenario may be sequentially as follows: the radiator C, the radiator D, the radiator A, the radiator B, the radiator H, the radiator E, and the radiator F.

Herein, it should be understood that the radiator A (primary radiator) is a primary radiator having a highest degree of coupling to the radiator C, the radiator D, the radiator B, the radiator E, and the radiator F. The radiator H may be considered as a parasitic radiator with the radiator B as a main radiator, and a direction of a current generated by the radiator H is the same as a direction of a current of the radiator B. Based on the foregoing reason for generating the target current direction, it can be understood that the target current direction 11 may be generated with reference to the preset frequency adjustment rule 21a and the foregoing reason for generating the target current direction, to improve performance of the antenna 2.

It should be further understood that, in the foregoing descriptions, all of the radiator C, the radiator D, the radiator B, the radiator H, the radiator E, and the radiator F serve as parasitic radiators of the radiator A (primary radiator). Operating frequencies of the parasitic radiators are adjusted, so that appropriate parasitic resonance is generated after the primary radiator performs resonance, to improve performance of the antenna 2. In an actual case, more or fewer parasitic radiators than those described above may be used to generate parasitic resonance to improve performance of the antenna 2. For example, in some other possible cases, only the radiator C, the radiator D, and the radiator B may serve as parasitic radiators of the radiator A (primary radiator), and generate appropriate parasitic resonance after the primary radiator performs resonance, to improve performance of the antenna 2. In this case, the preset frequency adjustment rule 21a may include: In the first antenna structure, when the electronic device is in the single-mode Wi-Fi, an operating frequency (denoted as an operating frequency A) of the radiator A (primary radiator) is adjusted to belong to the Wi-Fi 2.4G frequency band. For example, the operating frequency A may be 2.4 GHz. An operating frequency of the radiator C is adjusted to be less than and close to the operating frequency A. An operating frequency of the radiator D is adjusted to be less than and close to the operating frequency A. An operating frequency of the radiator B is greater than and close to the operating frequency A. In some possible cases, the radiator C, the radiator D, the radiator B, and the radiator A (primary radiator) in ascending order of operating frequencies may be sequentially as follows: the radiator C, the radiator D, the radiator A (primary radiator), and the radiator B. In this case, currents distributed on the radiator B and the radiator C are in a same direction as a current of the radiator A, and a current distributed on the radiator D is in a direction opposite to a direction of the current of the radiator A.

**FIG. 6 is a diagram of a preset frequency adjustment rule 21a.**

FIG. 6 is a line graph of effect of an S parameter for the antenna 1 and the antenna 2 in the single-mode Wi-Fi scenario during simulation effect testing of the electronic device. A horizontal coordinate represents a frequency in a unit of GHz, and a vertical coordinate represents an amplitude value of S11 in a unit of dB.

FIG. 6 includes two curves: a curve "Antenna 2 - single-mode Wi-Fi", referred to as a curve Q61; and a curve "Antenna 1 - single-mode Wi-Fi", referred to as a curve Q62. The curve Q61 shows a frequency magnitude relationship between radiators in the antenna 2 and frequencies corresponding to the radiators in the single-mode Wi-Fi scenario. The curve Q62 shows a frequency magnitude relationship between radiators in the antenna 1 and frequencies corresponding to the radiators in the single-mode Wi-Fi scenario.

In FIG. 6, letters A to F respectively represent the radiator A to the radiator F. It can be learned from FIG. 6 that radiators in ascending order of frequencies in the single-mode Wi-Fi scenario may be sequentially as follows: the radiator C (approximately 2.0 GHz), the radiator D (approximately 2.2 GHz), the radiator A (approximately 2.4 GHz), the radiator B and the radiator H (approximately 2.6 GHz), the radiator E (approximately 2.8 GHz), and the radiator F (approximately 3 GHz). This satisfies the foregoing descriptions of the preset frequency adjustment rule 21a. The frequency magnitude relationship between the radiators in FIG. 6 can enable expected current directions of the radiators in the antenna 1 and the antenna 2 to be the target current direction 11. For descriptions of the target current direction 11, refer to the foregoing descriptions of (1) in FIG. 5A. Details are not described herein again.

It should be understood that, as shown in FIG. 6, compared with the radiator C, a reason for adjusting a frequency of the radiator D to be closer to that of the radiator A (primary radiator) herein lies in: Compared with the radiator C, the radiator D is farther away from the radiator A. If the radiator D is expected to provide better forward parasitic radiation effect on the radiator A, the frequency of the radiator D needs to be adjusted to be close to that of the radiator A. Otherwise, a current excited by the radiator D is weak, and has small forward parasitic radiation effect on the radiator A.

As shown in FIG. 6, compared with the radiator E and the radiator F, a reason for adjusting a frequency of the radiator B to be closer to that of the radiator A (primary radiator) herein lies in: In the example in FIG. 6, the radiator B has main parasitic radiation effect on the radiator A, because both the radiator B and the radiator A are at a first edge (for example, a horizontal edge) of the electronic device and are close to each other.

Herein, it should be further understood that the antenna 1 and the antenna 2 may share the radiator D, the radiator F, and the radiator C in the single-mode Wi-Fi scenario. FIG. 6 shows an example in which the radiator D and the radiator F belong to the antenna 1. In an actual case, an example in which the radiator D and the radiator F belong to the antenna 2 may alternatively be used. This is not limited in this embodiment of this application.

**FIG. 7 is a diagram of comparison between a frequency adjustment rule in the single-mode Wi-Fi scenario and a frequency adjustment rule in the low-performance scenario 11.**

FIG. 7 is a line graph of comparison between effect of an S parameter for the antenna 1 and the antenna 2 in the single-mode Wi-Fi scenario and that in the low-performance scenario 11 during simulation effect testing of the electronic device. A horizontal coordinate represents a frequency in a unit of GHz, and a vertical coordinate represents an amplitude value of S11 in a unit of dB.

FIG. 7 includes four curves: a curve "Antenna 2 - single-mode Wi-Fi", referred to as a curve Q61; a curve "Antenna 1 - single-mode Wi-Fi", referred to as a curve Q62; a curve "Antenna 2 - scenario 11", referred to as a curve Q63; and a curve "Antenna 1 - scenario 11", referred to as a curve Q64. The curve Q63 shows a frequency magnitude relationship between radiators in the antenna 2 and frequencies corresponding to the radiators in the low-performance scenario 11. The curve Q64 shows a frequency magnitude relationship between radiators in the antenna 1 and frequencies corresponding to the radiators in the low-performance scenario 11. Related descriptions of the curve Q61 and the curve Q62 are the same as those of the curve Q61, the curve Q62, and related content thereof in FIG. 6. Details are not described herein again.

Herein, it should be understood that the curve Q63 and the curve Q64 shown in FIG. 7 are a case in the low-performance scenario 11. In this case, in the low-performance scenario 11, when an operating frequency of the antenna 1 is a mid-high band B3 frequency band (MHB B3 for short), performance of the antenna 2 is the best compared with performance achieved when the operating frequency of the antenna 1 is another frequency band.

In FIG. 7, letters A to F respectively represent the radiator A to the radiator F. It can be learned from FIG. 7 that radiators in ascending order of frequencies in the low-performance scenario 11 may be sequentially as follows: the radiator E (approximately 1.8 GHz), the radiator A (approximately 2.4 GHz), the radiator F (approximately 2.5 GHz), the radiator B and the radiator H (approximately 2.6 GHz), the radiator D (approximately 3.4 GHz), and the radiator C (approximately 4.3 GHz). This may be understood as an example of the foregoing frequency adjustment rule 11a.

The frequency magnitude relationships between the radiators shown in the curve Q63 and the curve Q64 satisfy the foregoing descriptions of the preset frequency adjustment rule 11a. In this way, current directions of the radiators in the antenna 1 and the antenna 2 can be a current direction in the foregoing low-performance scenario 11. For the current direction in the low-performance scenario 11, refer to the foregoing descriptions of (2) in FIG. 5A. Details are not described herein again.

It can be learned from operating frequencies of radiators determined according to the preset frequency adjustment rule 21a that, compared with the low-performance scenario 11, an operating frequency of at least one radiator in the single-mode Wi-Fi scenario changes. For example, the change includes but is not limited to the following changes.

Radiator frequency change 71: An operating frequency of the radiator D changes from 3.4 GHz that is higher than an operating frequency of the radiator A (primary radiator) to 2.2 GHz that is lower than the operating frequency of the radiator A. The change is indicated by a white circle ① in FIG. 7. The radiator frequency change 71 may cause a current direction of the radiator D to change from being the same as a current direction of the radiator A to being opposite to the current direction of the radiator A. For related descriptions of the current direction change of the radiator D, refer to the foregoing related descriptions of the white circle ① in FIG. 5A. Details are not described herein again.

Radiator frequency change 72: An operating frequency of the radiator F changes from 2.5 GHz to 3 GHz that is farther away from the operating frequency of the radiator A. The change is indicated by a white circle ② in FIG. 7. The radiator frequency change 72 may cause a current of the radiator F to be weakened. For related descriptions of the current strength change of the radiator F, refer to the foregoing related descriptions of the white circle ② in FIG. 5A. Details are not described herein again.

Radiator frequency change 73: An operating frequency of the radiator E changes from 1.8 GHz that is lower than the operating frequency of the radiator A (primary radiator) to 2.8 GHz that is higher than the operating frequency of the radiator A. The change is indicated by a white circle ③ in FIG. 7.

Radiator frequency change 74: An operating frequency of the radiator C changes from 4.3 GHz that is higher than an operating frequency of the radiator A (primary radiator) to 2.2 GHz that is lower than the operating frequency of the radiator A. The change is indicated by a white circle ④ in FIG. 7.

The radiator frequency change 73 may cause a current direction of the radiator F to change from being opposite to a current direction of the radiator A to being the same as the current direction of the radiator A. The radiator frequency change 74 may cause a current direction of the radiator C to change from being opposite to a current direction of the radiator A to being the same as the current direction of the radiator A. For related descriptions of the current direction changes of the radiator F and the radiator C, refer to the foregoing related descriptions of the white circle ③ in FIG. 5A. Details are not described herein again.

Herein, it should be understood that values of operating frequencies of radiators shown in FIG. 6 and FIG. 7 are examples for description, and may be other values in an actual case. For example, an operating frequency of a same radiator is an operating frequency greater than or less than the operating frequency by 1 GHz. This shall not be construed as a limitation on embodiments of this application.

**The following describes a process in which frequencies of radiators are adjusted by using at least one frequency control circuit according to the preset frequency adjustment rule 21a in the single-mode Wi-Fi scenario, to enable directions of expected currents generated by the radiators to satisfy the target current direction 11. In addition, the adjustment process is compared with an adjustment process in the low-performance scenario.**

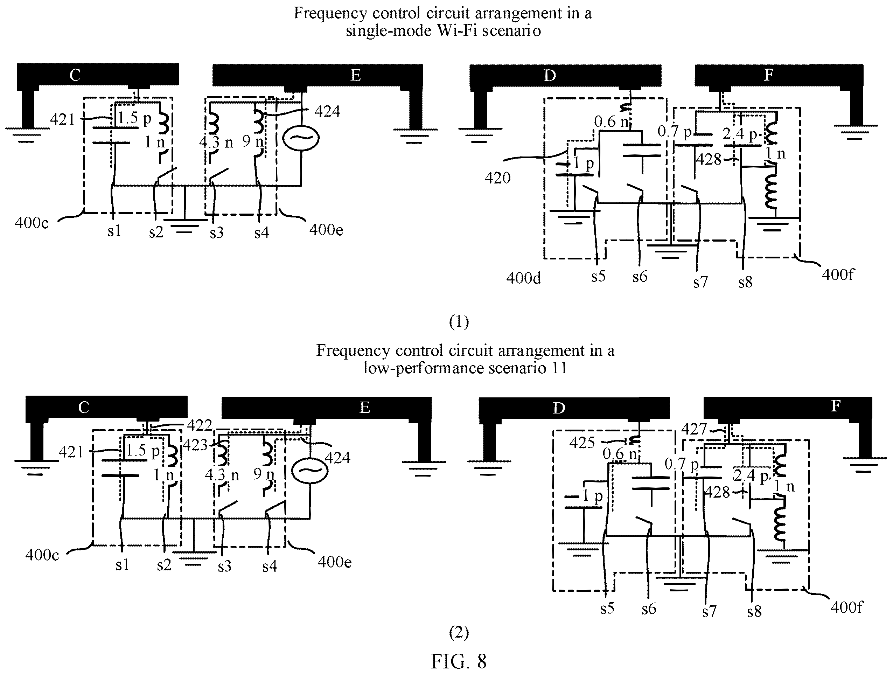

**FIG. 8 is a diagram of a frequency control circuit arrangement in the single-mode Wi-Fi scenario and a**

**EP 4 661 206 A1**

frequency control circuit arrangement in the low-performance scenario 11.

How to obtain, through adjustment, the frequencies of the radiators shown in FIG. 7 is described below based on FIG. 8.

In a second antenna structure, the radiator B and the radiator H are not connected to a frequency control circuit, and the radiator H may be considered as a parasitic radiator with the radiator B as a main radiator. Operating frequencies of the radiator B and the radiator H may be equal and fixed at a frequency band. The frequency band is approximately 2.55 GHz to 2.65 GHz. For example, the operating frequencies of the radiator B and the radiator H may be 2.6 GHz. This is not limited in this embodiment of this application.

Frequency control circuits are connected to the radiator C, the radiator E, the radiator D, and the radiator F. The arrangement of the frequency control circuits herein is also intended to describe frequency adjustment for the radiator C, the radiator E, the radiator D, and the radiator F.

(1) in FIG. 8 shows the frequency control circuit arrangement in the single-mode Wi-Fi scenario. For the radiator C, the electronic device turns on (ON) a switch unit s1 and turns off (OFF) s2 in a frequency control circuit 400c, to turn on a frequency adjustment branch 421. This is equivalent to that the radiator C is connected to a capacitor of approximately 1.5 p, and a frequency is adjusted to approximately 2.0 GHz. For the radiator E, the electronic device turns off (OFF) a switch unit s3 and turns on (ON) s4 in a frequency control circuit 400e, to turn on a frequency adjustment branch 424. This is equivalent to that the radiator E is connected to an inductor of approximately 9 n, and a frequency is adjusted to approximately 2.8 GHz. For the radiator D, the electronic device turns off (OFF) both a switch unit s5 and a switch unit s6 in a frequency control circuit 400d, to turn on a frequency adjustment branch 420. This is equivalent to that the radiator D is connected to a lumped element obtained by connecting a capacitor (approximately 1 p) to an inductor (approximately 0.6 n) in series, and a frequency is adjusted to approximately 2.2 GHz. For the radiator F, the electronic device turns off (OFF) a switch unit s7 and turns on (ON) a switch unit s8 in a frequency control circuit 400f, to turn on a frequency adjustment branch 428. This is equivalent to that the radiator F is connected to a lumped element obtained by connecting a capacitor (approximately 2.4 p) to an inductor (approximately 1 n) in parallel, and a frequency is adjusted to approximately 3 GHz.

(2) in FIG. 8 shows the frequency control circuit arrangement in the low-performance scenario 11. For the radiator C, the electronic device turns on (ON) both a switch unit s2 and a switch unit s1 in a frequency control circuit 400c, to turn on both a frequency adjustment branch 421 and a frequency adjustment branch 422. This is equivalent to that the radiator C is connected to a lumped element obtained by connecting a capacitor (approximately 1.5 p) to an inductor (approximately 1 n) in parallel, and a frequency is adjusted to a high frequency band, which is approximately 4.3 GHz. For the radiator E, the electronic device turns off (OFF) a switch unit s4 and a switch unit s3 in a frequency control circuit 400e, to turn on neither of a frequency adjustment branch 423 and a frequency adjustment branch 424. In this way, a frequency of the radiator E can be adjusted to approximately 2.8 GHz. For the radiator D, the electronic device turns on (ON) a switch unit s5 and turns off (OFF) a switch unit s6 in a frequency control circuit 400d, to turn on a frequency adjustment branch 425. This is equivalent to that the radiator D is connected to an inductor of approximately 0.6 n, and a frequency is adjusted to approximately 3.4 GHz. For the radiator F, the electronic device turns on (ON) a switch unit s7 and turns off (OFF) a switch unit s8 in a frequency control circuit 400f, to turn on a frequency adjustment branch 427. This is equivalent to that the radiator F is connected to a capacitor of approximately 0.7 p, and a frequency is adjusted to approximately 2.5 GHz.

**The following describes beneficial effect of the single-mode Wi-Fi scenario compared with the low-performance scenario 11.**

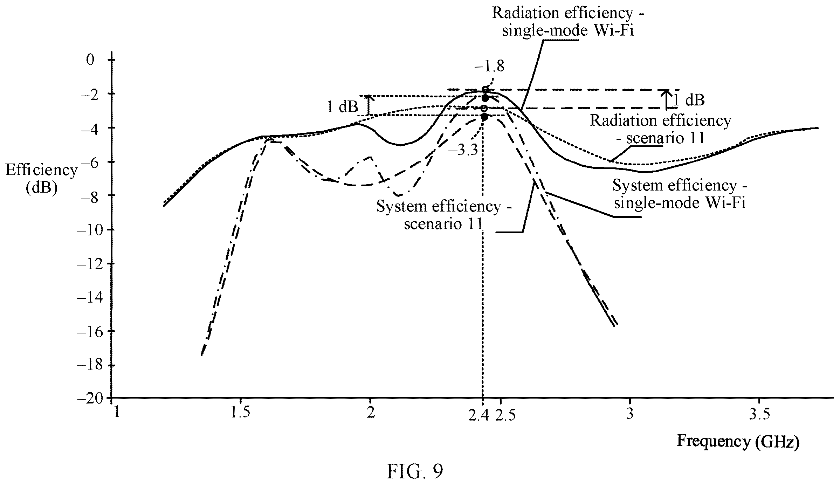

**FIG. 9 is a diagram of comparison between radiation efficiency and system efficiency of the antenna 2 in the single-mode Wi-Fi scenario and radiation efficiency and system efficiency of the antenna 2 in the low-performance scenario 11 during simulation effect testing of the electronic device.**

As shown in FIG. 9, a horizontal coordinate represents a frequency in a unit of GHz, and a vertical coordinate represents efficiency (radiation efficiency or system efficiency) in a unit of dB. The radiation efficiency and the system efficiency being closer to 0 dB indicates higher radiation efficiency and system efficiency of the antenna and better performance of the antenna.

In FIG. 9, a curve "Radiation efficiency - single-mode Wi-Fi" and a curve "Radiation efficiency - scenario 11" respectively represent radiation efficiency during operation of the antenna 2 in the single-mode Wi-Fi scenario and radiation efficiency during operation of the antenna 2 in the low-performance scenario 11. In this case, an operating frequency of the antenna 2 is 2.4 GHz, the radiation efficiency of the antenna 2 in the single-mode Wi-Fi scenario is approximately -1.8 dB, and the radiation efficiency of the antenna 2 in the low-performance scenario 11 is approximately -2.8 dB. Therefore, compared with the low-performance scenario 11, in the single-mode Wi-Fi, the radiation efficiency of the antenna 2 is improved by approximately 1 dB.

In FIG. 9, a curve "System efficiency - single-mode Wi-Fi" and a curve "System efficiency - scenario 11" respectively represent system efficiency during operation of the antenna 2 in the single-mode Wi-Fi scenario and system efficiency during operation of the antenna 2 in the low-performance scenario 11. In this case, an operating frequency of the antenna 2 is 2.4 GHz, the system efficiency of the antenna 2 in the single-mode Wi-Fi scenario is approximately -2.3 dB, and the system efficiency of the antenna 2 in the low-performance scenario 11 is approximately -3.3 dB. Therefore, compared with the low-performance scenario 11, in the single-mode Wi-Fi, the system efficiency of the antenna 2 is also improved by 1 dB.

**Low-performance scenario 12:**

When the operating frequencies of the antenna 1 to the antenna 3 are adjusted according to the preset frequency adjustment rule 11b and the 2.4G Wi-Fi communication mode and the cellular network communication mode (on a B41 frequency band) are enabled for the electronic device, the antenna 1 is responsible for providing the cellular network communication mode (on the B41 frequency band), and the antenna 2 is responsible for providing the 2.4G Wi-Fi communication mode. In this case, although performance of the antenna 1 is good, the antenna 2 has low performance when operating on the Wi-Fi 2.4G frequency band. Consequently, the electronic device has a poor communication capability when communicating with another electronic device in the 2.4G Wi-Fi communication mode in a Wi-Fi and B41 coexistence mode. The Wi-Fi and B41 coexistence mode indicates that the 2.4G Wi-Fi communication and the cellular network communication on the B41 frequency band are enabled.

For a cause of low performance of the antenna 2 operating on the Wi-Fi 2.4G frequency band in the low-performance scenario 12, refer to the following descriptions of FIG. 13. Details are not described herein.

**An improvement manner for the low-performance scenario 12 and related content thereof are described below.**

In the low-performance scenario 12, the electronic device may change some radiators responsible for providing the cellular network communication mode (on the B41 frequency band) to being responsible for providing the 2.4G Wi-Fi communication mode, and keep some radiators continuing to be responsible for providing the cellular network communication mode (on the B41 frequency band).

Based on the first antenna structure in this application, the electronic device may re-adjust, according to a preset frequency adjustment rule 21b, operating frequencies of the antenna 2 and the antenna 1 coupled thereto, to adjust current directions of radiators in the antenna 1 and the antenna 2 to a target current direction (denoted as a target current direction 12). The target current direction 12 is a current direction satisfying the Wi-Fi and B41 coexistence mode when the first antenna structure is used. The electronic device may change operating frequencies of some radiators responsible for providing the cellular network communication mode (on the B41 frequency band), to enable resonance generated by the radiators to be used for providing the 2.4G Wi-Fi communication mode. Alternatively, the electronic device may change operating frequencies of some radiators responsible for providing the cellular network communication mode (on the B41 frequency band), to prevent resonance generated by the radiators from causing adverse impact on the 2.4G Wi-Fi communication mode. In this way, when the antenna 1 continues to be responsible for providing the cellular network communication mode (on the B41 frequency band), the antenna 2 is enabled to better provide the 2.4G Wi-Fi communication mode. This can balance performance of the antenna 1 while improving performance of the antenna 2. For a reason for generating the target current direction herein, refer to the foregoing related descriptions of generating the target current direction. Details are not described herein again.

When the electronic device is in the Wi-Fi and B41 coexistence mode, a scenario in which the operating frequencies of the antenna 2 and the antenna 1 are re-adjusted according to the preset frequency adjustment rule 21b may be referred to as a Wi-Fi and B41 coexistence mode scenario.

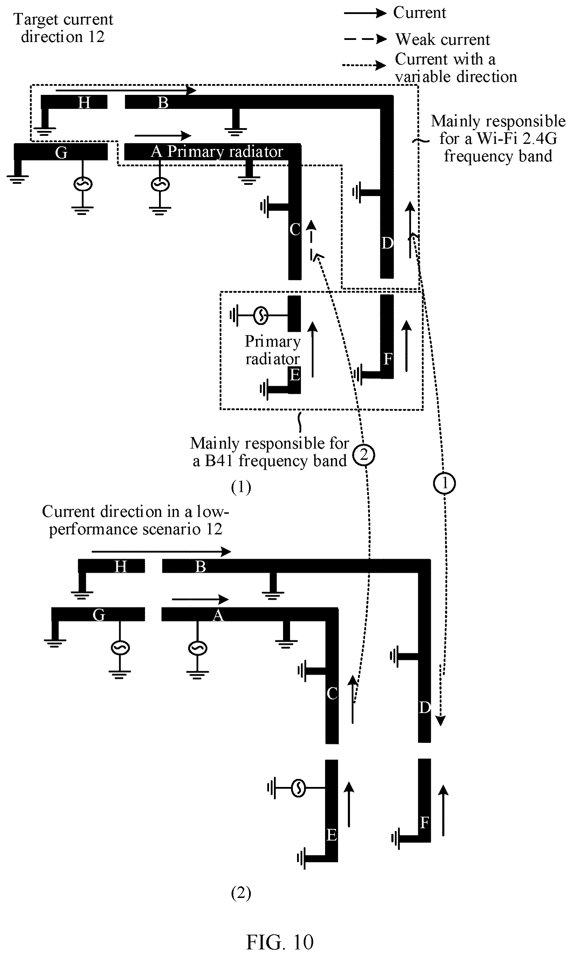

**FIG. 10 is a diagram of comparison between a current direction in the Wi-Fi and B41 coexistence mode scenario and a current direction in the low-performance scenario 12.**

**First, based on the foregoing reason for generating the target current direction, a target current direction 12 proposed for the Wi-Fi and B41 coexistence mode scenario is described in detail with reference to FIG. 10.**

(1) **in FIG. 10 is a diagram of a target current direction 12.**

(1) in FIG. 10 shows expected current directions (the target current direction 12) of the radiators in the antenna 1 and the antenna 2 when the operating frequencies of the antenna 2 and the antenna 1 are re-adjusted according to the preset frequency adjustment rule 21b.

When the electronic device is in the Wi-Fi and B41 coexistence mode, the antenna 2 is mainly responsible for providing the 2.4G Wi-Fi communication mode for the electronic device, and the antenna 1 is mainly responsible for providing the cellular network communication mode (on the B41 frequency band) for the electronic device.

Radiators mainly responsible for the B41 frequency band include the radiator E and the radiator F. In this case, the radiator E is a primary radiator, the radiator F is a first-type radiator, and a direction of an expected current generated by the radiator F is the same as a direction of a current of the radiator E.

Herein, it should be understood that, in addition to the radiator F, a parasitic radiator of the radiator E may further include the radiator B, the radiator D, and other parasitic radiators. However, in the Wi-Fi and B41 coexistence mode scenario, radiators other than the radiator F have small impact on the radiator E and have large impact on the radiator A. This is not described herein, and is to be described below during description of the radiator A.

Radiators mainly responsible for the Wi-Fi 2.4G frequency band include the radiator A, the radiator B, and the radiator D, and may further include the radiator H. In this case, the radiator A is a primary radiator. The radiator H and the radiator B are first-type radiators, and directions of expected currents generated by the radiators are the same as a direction of a current of the radiator A. The radiator D is a second-type radiator, and a direction of an expected current generated by the radiator D is opposite to the direction of the current of the radiator A. The radiator C is a third-type radiator, and an expected current generated by the radiator C is weak, to avoid interference to the radiator A or the radiator E.

Herein, that a current of the radiator C is weak includes that the current of the radiator C is weaker than the current of the radiator A and the current of the radiator E.

In some possible cases, in the second antenna structure, when the electronic device is in the Wi-Fi and B41 coexistence mode scenario, alternatively, no current may be distributed on the radiator C.

Herein, it should be understood that, in the Wi-Fi and B41 coexistence mode scenario, in addition to the radiator B, the radiator D, and the radiator H, the parasitic radiator of the radiator A may further include the radiator F or other parasitic radiators. However, these parasitic radiators have small impact on the radiator A and are not described herein.

It should be understood that an example in which current directions of the radiator A (primary radiator) and the radiator E (primary radiator) are a direction shown in (1) in FIG. 10 is used for description herein. In an actual case, the current directions of the radiator A and the radiator E may alternatively be opposite to the direction shown in (1) in FIG. 10. This is not limited in this embodiment of this application.

**(2) in FIG. 10 shows a current direction in the low-performance scenario 12.**

With reference to (2) in FIG. 10 and (1) in FIG. 10, the following describes in detail causes of improvement of performance of the antenna 2 when the electronic device is in the Wi-Fi and B41 coexistence mode after a frequency adjustment rule in this application is used.

Refer to (2) in FIG. 10. In the low-performance scenario 12, a cause of low performance of the antenna 2 includes but is not limited to one or more of the following causes.

**Cause of low performance 12-1:** The radiator D is a parasitic radiator of the radiator A (primary radiator), and is a second-type radiator. However, a current of the radiator D is in a same direction as a current of the radiator A. Resonance generated when the current of the radiator D is in a same direction as the current of the radiator A has adverse impact on the radiator A.

It can be learned from (1) in FIG. 10 and (2) in FIG. 10 that, for the cause of low performance 12-1, a first change is made: The current of the radiator D changes from being in a same direction as the current of the radiator A to being in a direction opposite to a direction of the current of the radiator A, so that performance of the antenna 2 can be improved. The first change for the cause of low performance 12-1 is indicated by a white circle ① in (2) in FIG. 10.

It should be understood that a reason for changing the current of the radiator D from being in a same direction as the current of the radiator A to being in a direction opposite to the direction of the current of the radiator A lies in: Although the radiator D is a parasitic radiator of the radiator A, the radiator D is not on a same as the radiator A, is not parallel to the radiator A, and is close to the radiator A. Resonance generated when the current of the radiator D and the current of the radiator A are in opposite directions has forward parasitic radiation effect on the radiator A, so that performance of the antenna 2 can be improved.

**Cause of low performance 12-2:** In the Wi-Fi and B41 coexistence mode scenario, the radiator C is highly coupled to both the radiator A (primary radiator) and the radiator E (primary radiator). When a current of the radiator C is strong, if the radiator C has good parasitic radiation effect on one primary radiator, the radiator C may cause adverse impact on the other primary radiator.

It can be learned from (1) in FIG. 10 and (2) in FIG. 10 that, for the cause of low performance 12-2, a second change is made: The current of the radiator C is weakened to reduce adverse impact on the antenna 2 or the antenna 1. The second change for the cause of low performance 12-2 is indicated by a white circle ② in (2) in FIG. 10.

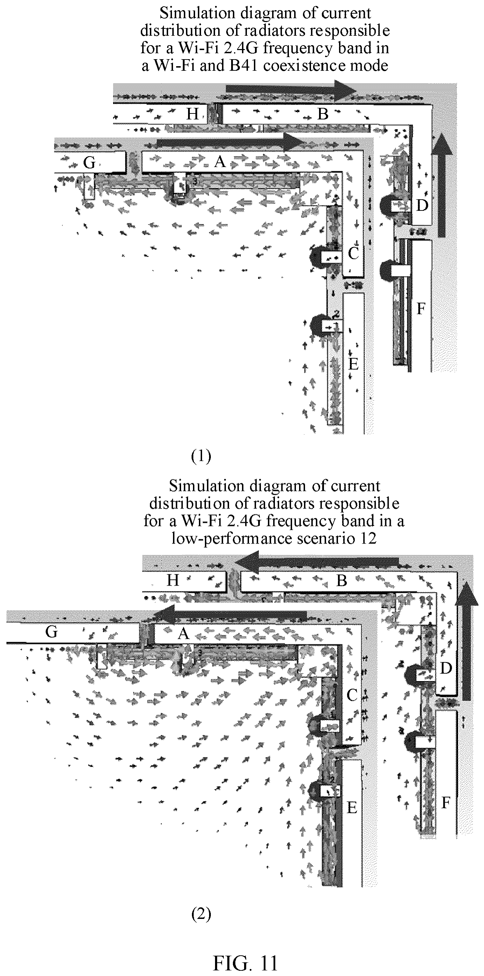

**FIG. 11 is a simulation diagram of example current distribution of radiators mainly responsible for the Wi-Fi 2.4G frequency band when the electronic device is in the Wi-Fi and B41 coexistence mode scenario.**

(1) in FIG. 11 is a simulation diagram of current distribution of radiators mainly responsible for the Wi-Fi 2.4G frequency band when the electronic device is in the Wi-Fi and B41 coexistence mode. Current directions of the radiators correspond to current directions of radiators in the target current direction 12 shown in (1) in FIG. 10. A current direction of the radiator D is opposite to a current direction of the radiator A. Current directions of the radiator B and the radiator H are the same as the current direction of the radiator A. In addition, it can be learned from (1) in FIG. 11 that a current of the radiator C is weaker than currents of other radiators.

(2) in FIG. 11 is a simulation diagram of current distribution of radiators mainly responsible for the Wi-Fi 2.4G frequency band when the electronic device is in the low-performance scenario 12. In this case, a current direction of the radiator D is the same as a current direction of the radiator A, causing degradation of performance of the antenna 2 (including the radiator A).

Herein, it should be understood that, in the first antenna structure, when the electronic device is in another mode, operating frequencies of the antenna 1 and the antenna 2 may be adjusted according to the preset frequency adjustment rule 11, to enable the electronic device to communicate with another electronic device. The another mode may be a mode other than the single-mode Wi-Fi and the Wi-Fi and B41 coexistence mode. Details are not described in this embodiment of this application.

**The preset frequency adjustment rule 21b for adjusting the target current direction 12 is further described.**

In some possible cases, the preset frequency adjustment rule 21b is used for adjusting a frequency magnitude relationship between the radiator A (primary radiator) and a main parasitic radiator (including the radiator B, the radiator H, and the radiator D) of the radiator A when the electronic device is in the Wi-Fi and B41 coexistence mode; and is further used for adjusting a frequency magnitude relationship between the radiator E (primary radiator) and a main parasitic radiator (including the radiator F) of the radiator E, to enable currents distributed on the radiators to satisfy the target current direction 12.

An operating frequency (denoted as an operating frequency A) of the radiator A (primary radiator) belongs to the Wi-Fi 2.4G frequency band. For example, the operating frequency A may be 2.4 GHz. An operating frequency of the radiator D is less than and close to the operating frequency A. An electrical length of the radiator B is set to be greater than a preset length value 1, and an electrical length of the radiator H is set to be greater than the preset length value 1, so that the radiator B and the radiator H can be considered as one parasitic radiator with the radiator B as a main radiator. In this case, a frequency of the radiator H may be the same as a frequency of the radiator B. An operating frequency of the radiator B is adjusted to be greater than and close to the operating frequency A. In this case, radiators, mainly responsible for providing the 2.4G Wi-Fi communication mode, in ascending order of frequencies in the Wi-Fi and B41 coexistence mode scenario may be sequentially as follows: the radiator D, the radiator A, the radiator B, and the radiator H.

An operating frequency (denoted as an operating frequency E) of the radiator E (primary radiator) belongs to the B41 frequency band. For example, the operating frequency E may be 2.55 GHz. An operating frequency of the radiator F is greater than the operating frequency E, and is close to the operating frequency E, so that an expected current generated by the radiator F is in a same direction as a current of the radiator E. In addition, the operating frequency of the radiator F in the Wi-Fi and B41 coexistence mode scenario is less than the operating frequency of the radiator F in the foregoing single-mode Wi-Fi. In this case, radiators, mainly responsible for providing the cellular network communication mode (on the B41 frequency band), in ascending order of frequencies in the Wi-Fi and B41 coexistence mode scenario may be sequentially as follows: the radiator E and the radiator F.

In the Wi-Fi and B41 coexistence mode scenario, an operating frequency (denoted as an operating frequency C1) of the radiator C may be adjusted, according to the preset frequency adjustment rule 21b, to a frequency greatly different from the operating frequency A and the operating frequency E. In some possible cases, the operating frequency of the radiator C may be adjusted to a quite high position (greater than 4G), for example, 5G. In this way, a current of the radiator C can be weakened to reduce adverse impact on the antenna 2 or the antenna 1.

With reference to the foregoing content, in some possible cases, radiators in ascending order of operating frequencies in the Wi-Fi and B41 coexistence mode scenario may be sequentially as follows: the radiator D, the radiator A, the radiator E, the radiator B, the radiator H, the radiator F, and the radiator C.

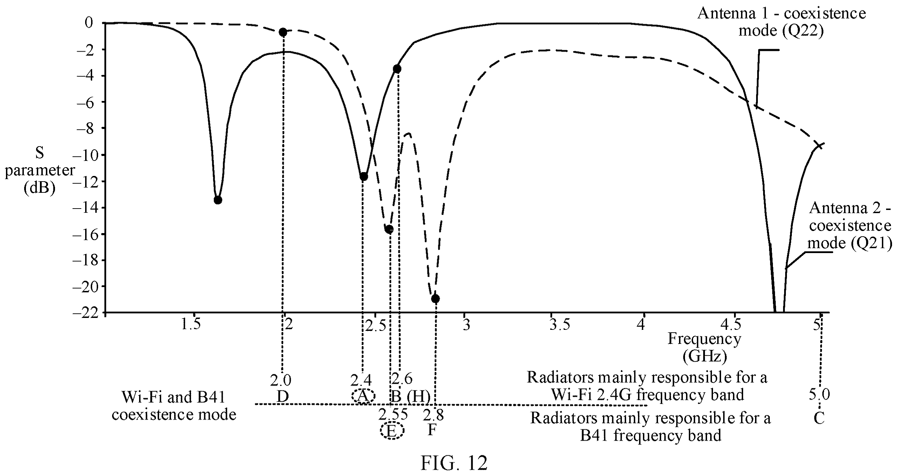

**FIG. 12 is a diagram of a preset frequency adjustment rule 21b.**

FIG. 12 is a line graph of effect of an S parameter for the antenna 1 and the antenna 2 in the Wi-Fi and B41 coexistence mode scenario during simulation effect testing of the electronic device. As shown in FIG. 12, a horizontal coordinate represents a frequency in a unit of GHz, and a vertical coordinate represents an amplitude value of S11 in a unit of dB.

FIG. 12 includes two curves: a curve "Antenna 2 - coexistence mode", referred to as a curve Q21; and a curve "Antenna 1 - coexistence mode", referred to as a curve Q22. The curve Q21 shows a frequency magnitude relationship between radiators in the antenna 2 and frequencies corresponding to the radiators in the Wi-Fi and B41 coexistence mode scenario. The curve Q22 shows a frequency magnitude relationship between radiators in the antenna 1 and frequencies corresponding to the radiators in the Wi-Fi and B41 coexistence mode scenario.

In FIG. 12, letters A to F respectively represent the radiator A to the radiator F. It can be learned from FIG. 12 that, in some possible cases, radiators, mainly responsible for the Wi-Fi 2.4G frequency band, in ascending order of frequencies in the Wi-Fi and B41 coexistence mode scenario may be sequentially as follows: the radiator D (approximately 2.0 GHz), the radiator A (approximately 2.4 GHz), and the radiator B and the radiator H (approximately 2.6 GHz).

Radiators, mainly responsible for the Wi-Fi 2.4G frequency band, in ascending order of frequencies may be sequentially as follows: the radiator E (approximately 2.55 GHz) and the radiator F (approximately 2.8 GHz).

An operating frequency (not shown) of the radiator C may be adjusted to a quite high position (greater than 4G), for example, 5G. In this way, a current of the radiator C can be weakened to reduce adverse impact on the antenna 2 or the antenna 1.

The frequency magnitude relationship between the radiators shown in FIG. 12 satisfies the foregoing descriptions of the preset frequency adjustment rule 21b. In this way, expected current directions of the radiators in the antenna 1 and the antenna 2 can be the target current direction 12. For descriptions of the target current direction 12, refer to the foregoing descriptions of (1) in FIG. 10. Details are not described herein again.

Herein, it should be further understood that the antenna 1 and the antenna 2 may share the radiator D in the single-mode Wi-Fi scenario. FIG. 12 shows an example in which the radiator D belongs to the antenna 1. In an actual case, an example in which the radiator D belongs to the antenna 2 may alternatively be used. This is not limited in this embodiment of this application.

**FIG. 13 is a diagram of comparison between a frequency adjustment rule in the Wi-Fi and B41 coexistence mode scenario and a frequency adjustment rule in the low-performance scenario 12.**

FIG. 13 is a line graph of comparison between effect of an S parameter for the antenna 1 and the antenna 2 in the Wi-Fi and D41 coexistence mode scenario and that in the low-performance scenario 12 during simulation effect testing of the electronic device. As shown in FIG. 13, a horizontal coordinate represents a frequency in a unit of GHz, and a vertical coordinate represents an amplitude value of S11 in a unit of dB.

FIG. 13 includes four curves: a curve "Antenna 2 - coexistence mode", referred to as a curve Q21; a curve "Antenna 1 - coexistence mode", referred to as a curve Q22; a curve "Antenna 2 - scenario 12", referred to as a curve Q23; and a curve "Antenna 1 - scenario 12", referred to as a curve Q24. The curve Q23 shows a frequency magnitude relationship between radiators in the antenna 2 and frequencies corresponding to the radiators in the low-performance scenario 12. The curve Q24 shows a frequency magnitude relationship between radiators in the antenna 1 and frequencies corresponding to the radiators in the low-performance scenario 11. Related descriptions of the curve Q21 and the curve Q22 are the same as those of the curve Q21, the curve Q22, and related content thereof in FIG. 12. Details are not described herein again.

Herein, it should be understood that the curve Q23 and the curve Q24 shown in FIG. 13 are a case in the low-performance scenario 12. In this case, in the low-performance scenario 12, an operating frequency of the antenna 1 is a mid-high band B41 frequency band (MHB B41 for short).

In FIG. 13, letters A to F respectively represent the radiator A to the radiator F. It can be learned from FIG. 13 that, in the low-performance scenario 12, radiators mainly responsible for the Wi-Fi 2.4G frequency band include the radiator A (primary radiator) and main parasitic radiators of the radiator A, including the radiator B and the radiator H. Radiators mainly responsible for the B41 frequency band include the radiator E (primary radiator) and main parasitic radiators of the radiator E, including the radiator F and the radiator C.

In the low-performance scenario 12, radiators, mainly responsible for the Wi-Fi 2.4G frequency band, in ascending order of frequencies may be sequentially as follows: the radiator A (approximately 2.4 GHz), and the radiator B and the radiator H (approximately 2.6 GHz). Radiators, mainly responsible for the Wi-Fi 2.4G frequency band, in ascending order of frequencies may be sequentially as follows: the radiator E (approximately 2.55 GHz), the radiator F (approximately 3.0 GHz), and the radiator C (approximately 3.5 GHz). An operating frequency (not shown) of the radiator D may be adjusted to a quite high position (greater than 4G), for example, 4.6G. In this way, a current of the radiator D can be weakened to reduce adverse impact on the antenna 2 or the antenna 1. This may be understood as an example of the foregoing frequency adjustment rule 11b.

The frequency magnitude relationships between the radiators shown in the curve Q23 and the curve Q24 can enable current directions of the radiators in the antenna 1 and the antenna 2 to be the current direction in the foregoing low-performance scenario 12. For the current direction in the low-performance scenario 12, refer to the foregoing descriptions of (2) in FIG. 10. Details are not described herein again.

It can be learned from operating frequencies of radiators determined according to the preset frequency adjustment rule 21b that, compared with the low-performance scenario 12, an operating frequency of at least one radiator in the Wi-Fi and B41 coexistence mode scenario changes. For example, the change includes but is not limited to the following changes.

Radiator frequency change 31: An operating frequency of the radiator D changes from 4.6 GHz that is higher than an operating frequency of the radiator A (primary radiator) to 2.0 GHz that is lower than the operating frequency of the radiator A. The change is indicated by a white circle ① in FIG. 13. The radiator frequency change 31 may cause a current direction of the radiator D to change from being the same as a current direction of the radiator A to being opposite to the current direction of the radiator A. For related descriptions of the current direction change of the radiator D, refer to the foregoing related descriptions of the white circle ① in FIG. 10. Details are not described herein again.

Radiator frequency change 32: An operating frequency of the radiator C changes from 3.5 GHz to 5.0 GHz that is farther away from the operating frequency of the radiator A. The change is indicated by a white circle ② in FIG. 13. The radiator frequency change 32 may cause a current of the radiator C to be weakened. For related descriptions of the current strength change of the radiator C, refer to the foregoing related descriptions of the white circle ② in FIG. 10. Details are not described herein again.

Herein, it should be understood that values of operating frequencies of radiators shown in FIG. 12 and FIG. 13 are examples for description, and may be other values in an actual case. For example, an operating frequency of a same radiator is an operating frequency greater than or less than the operating frequency by 1 GHz. This shall not be construed as a limitation on embodiments of this application.

**The following describes a process in which frequencies of radiators are adjusted by using at least one**

**frequency control circuit according to the preset frequency adjustment rule 21b in the Wi-Fi and B41 coexistence mode scenario, to enable directions of expected currents generated by the radiators to satisfy the target current direction 12. In addition, the adjustment process is compared with an adjustment process in the low-performance scenario.**

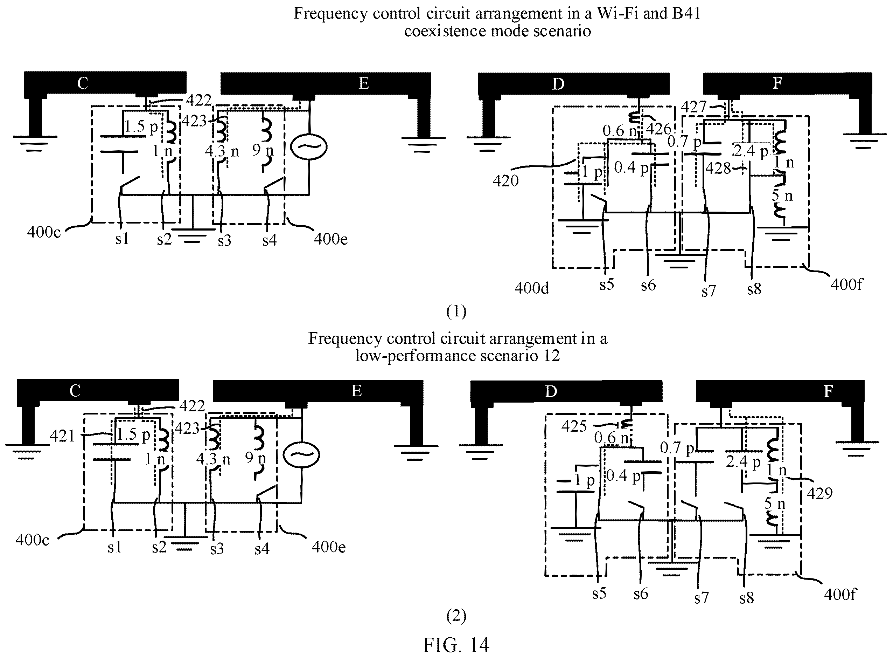

**FIG. 14 is a diagram of a frequency control circuit arrangement in the single-mode Wi-Fi scenario and a frequency control circuit arrangement in the low-performance scenario 12.**

How to obtain, through adjustment, the frequencies of the radiators shown in FIG. 13 is described below based on FIG. 14.

Frequency control circuits are connected to the radiator C, the radiator E, the radiator D, and the radiator F. The arrangement of the frequency control circuits herein is also intended to describe frequency adjustment for the radiator C, the radiator E, the radiator D, and the radiator F.

(1) in FIG. 14 shows the frequency control circuit arrangement in the Wi-Fi and B41 coexistence mode scenario. For the radiator C, the electronic device turns off (OFF) a switch unit s1 and turns on (ON) s2 in a frequency control circuit 400c, to turn on a frequency adjustment branch 422. This is equivalent to that the radiator C is connected to an inductor of approximately 1 n, and a frequency is adjusted to a high frequency, for example, approximately 5.0 GHz. For the radiator E, the electronic device turns off (OFF) a switch unit s4 and turns on (ON) s3 in a frequency control circuit 400e, to turn on a frequency adjustment branch 423. This is equivalent to that the radiator E is connected to an inductor of approximately 4.3 n, and a frequency is adjusted to approximately 2.55 GHz. For the radiator D, the electronic device turns off (OFF) a switch unit s5 and turns on (ON) a switch unit s6 in a frequency control circuit 400d, to turn on a frequency adjustment branch 426. This is equivalent to that the radiator D is connected to a lumped element obtained by connecting an inductor (approximately 0.6 n) to a capacitor (approximately 1.5 p) in series, and a frequency is adjusted to approximately 2.0 GHz. The capacitor of approximately 1.5 p is a result of a sum 1.4 p of a capacitor of approximately 1 p and a capacitor of approximately 0.4 plus 0.1 p (the switch unit s5 that is turned off may be considered as a capacitor of 0.1 p) in the frequency adjustment branch 426. For the radiator F, the electronic device turns on (ON) both a switch unit s7 and a switch unit s8 in a frequency control circuit 400f, to turn on both a frequency adjustment branch 427 and a frequency adjustment branch 428. This is equivalent to that the radiator F is connected to a lumped element obtained by connecting a capacitor (approximately 2.4 p) to an inductor (approximately 1 n) and another capacitor (approximately 0.7 p) in parallel, and a frequency is adjusted to approximately 2.8 GHz.

(2) in FIG. 14 shows the frequency control circuit arrangement in the low-performance scenario 12. For the radiator C, the electronic device turns on (ON) both a switch unit s2 and a switch unit s1 in a frequency control circuit 400c, to turn on both a frequency adjustment branch 421 and a frequency adjustment branch 422. This is equivalent to that the radiator C is connected to a lumped element obtained by connecting a capacitor (approximately 1.5 p) to an inductor (approximately 1 n) in parallel, and a frequency is adjusted to a high frequency band, for example, approximately 5 GHz. For the radiator E, the electronic device turns on (ON) a switch unit s3 and turns off (OFF) a switch unit s4 in a frequency control circuit 400e, to turn on a frequency adjustment branch 423. This is equivalent to that the radiator E is connected to an inductor (approximately 4.3 n). A frequency of the radiator E may be adjusted to approximately 2.55 GHz. For the radiator D, the electronic device turns on (ON) a switch unit s5 and turns off (OFF) a switch unit s6 in a frequency control circuit 400d, to turn on a frequency adjustment branch 425. This is equivalent to that the radiator D is connected to an inductor of approximately 0.6 n, and a frequency is adjusted to approximately 4.6 GHz. For the radiator F, the electronic device turns off (OFF) both a switch unit s7 and a switch unit s8 in a frequency control circuit 400f, to turn on a frequency adjustment branch 429. This is equivalent to that the radiator F is connected to a lumped element obtained by connecting a capacitor (approximately 2.7 p) to an inductor (approximately 1 n) in parallel and then to another inductor (approximately 5 n) in series, and a frequency is adjusted to approximately 3 GHz.

**The following describes beneficial effect of the Wi-Fi and B41 coexistence mode scenario compared with the low-performance scenario 12.**

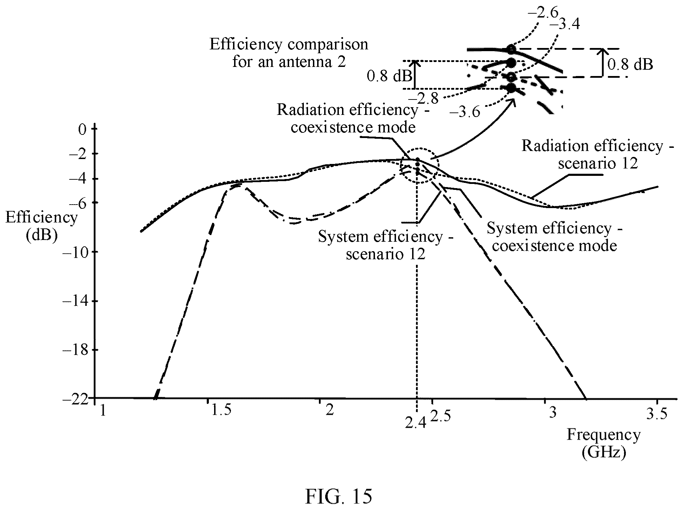

**FIG. 15 is a diagram of comparison between efficiency of the antenna 2 in the Wi-Fi and B41 coexistence mode scenario and efficiency of the antenna 2 in the low-performance scenario 12 during simulation effect testing of the electronic device.**

As shown in FIG. 15, a horizontal coordinate represents a frequency in a unit of GHz, and a vertical coordinate represents efficiency (radiation efficiency or system efficiency) in a unit of dB.

In FIG. 15, a curve "Radiation efficiency - coexistence mode" and a curve "Radiation efficiency - scenario 12" respectively represent radiation efficiency during operation of the antenna 2 in the Wi-Fi and B41 coexistence mode scenario and radiation efficiency during operation of the antenna 2 in the low-performance scenario 12. In this case, an operating frequency of the antenna 2 is 2.4 GHz, the radiation efficiency of the antenna 2 in the Wi-Fi and B41 coexistence mode scenario is approximately -2.7 dB, and the radiation efficiency of the antenna 2 in the low-performance scenario 12 is approximately -3.5 dB. Therefore, compared with the low-performance scenario 12, in the coexistence mode, the radiation efficiency of the antenna 2 is improved by approximately 0.8 dB.

In FIG. 15, a curve "System efficiency - coexistence mode" and a curve "System efficiency - scenario 12" respectively represent system efficiency during operation of the antenna 2 in the Wi-Fi and B41 coexistence mode scenario and system efficiency during operation of the antenna 2 in the low-performance scenario 12. In this case, an operating frequency of the antenna 2 is 2.4 GHz, the system efficiency of the antenna 2 in the Wi-Fi and B41 coexistence mode scenario is approximately -2.8 dB, and the system efficiency of the antenna 2 in the low-performance scenario 12 is approximately -3.6 dB. Therefore, compared with the low-performance scenario 12, in the coexistence mode, the system efficiency of the antenna 2 is also improved by approximately 0.8 dB.

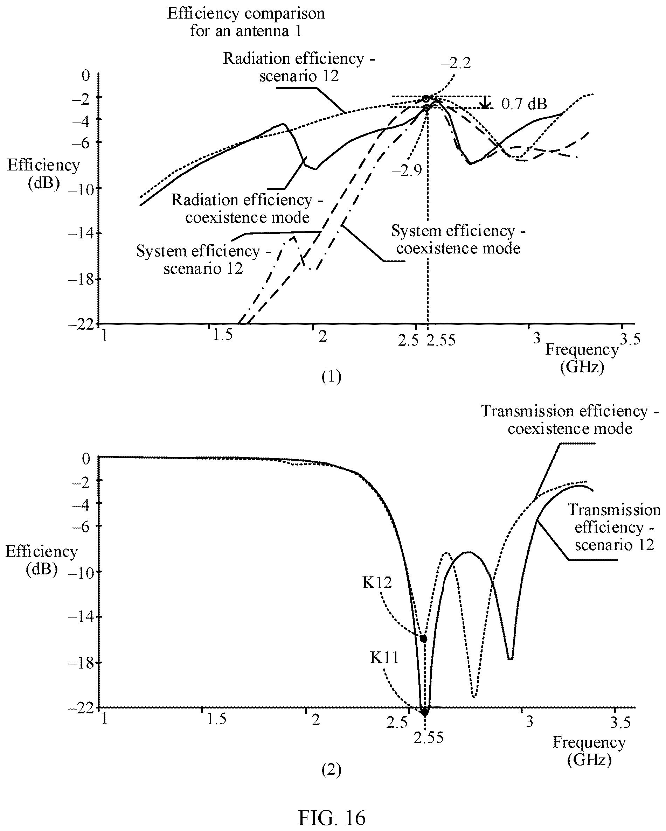

**FIG. 16 is a diagram of comparison between efficiency of the antenna 1 in the Wi-Fi and B41 coexistence mode scenario and efficiency of the antenna 1 in the low-performance scenario 11 during simulation effect testing of the electronic device.**

As shown in (1) in FIG. 16, a horizontal coordinate represents a frequency in a unit of GHz, and a vertical coordinate represents efficiency (radiation efficiency or system efficiency) in a unit of dB. A curve "Radiation efficiency - coexistence mode" and a curve "Radiation efficiency - scenario 12" respectively represent radiation efficiency during operation of the antenna 1 in the coexistence mode scenario and radiation efficiency during operation of the antenna 1 in the low-performance scenario 12. A curve "System efficiency - coexistence mode" and a curve "System efficiency - scenario 12" respectively represent system efficiency during operation of the antenna 1 in the coexistence mode scenario and system efficiency during operation of the antenna 1 in the low-performance scenario. In this case, an operating frequency of the antenna 1 is 2.55 GHz, both the radiation efficiency and the system efficiency of the antenna 1 in the coexistence mode scenario are approximately -2.9 dB, and both the radiation efficiency and the system efficiency of the antenna 1 in the low-performance scenario 12 are approximately -2.2 dB. Therefore, compared with the low-performance scenario 12, in the Wi-Fi and B41 coexistence mode, the radiation efficiency of the antenna 1 is reduced by approximately 0.7 dB.

As shown in (2) in FIG. 16, a horizontal coordinate represents a frequency in a unit of GHz, and a vertical coordinate represents efficiency (transmission efficiency) in a unit of dB. A smaller value of transmission efficiency (farther away from 0 dB) indicates better transmission efficiency of the antenna and better performance of the antenna. A value of the transmission efficiency being less than -6 dB indicates that the transmission efficiency of the antenna is good. A value of the transmission efficiency being greater than -6 dB indicates that the transmission efficiency of the antenna is poor. As shown in (2) in FIG. 16, A curve "Transmission efficiency - coexistence mode" and a curve "Transmission efficiency - scenario 12" respectively represent transmission efficiency during operation of the antenna 1 in the coexistence mode scenario and transmission efficiency during operation of the antenna 1 in the low-performance scenario 12. Transmission efficiency indicated by a point K11 is smaller than transmission efficiency indicated by K12. Therefore, the transmission efficiency of the antenna 1 in the coexistence mode is slightly poorer than the transmission efficiency of the antenna 1 in the low-performance scenario 12.

It can be learned from FIG. 15 and FIG. 16 that, although performance of the antenna 1 is degraded, the radiation efficiency and the system efficiency of the antenna 1 in this case are at a position of -2.9 dB, and the transmission efficiency is below -6 dB. This indicates that, although the performance of the antenna 1 is degraded, the performance is still good. In addition, performance of the antenna 2 is improved. This may be understood as that the performance of the antenna 1 is balanced while the performance of the antenna 2 is improved.

**A second antenna structure is described below in detail.**

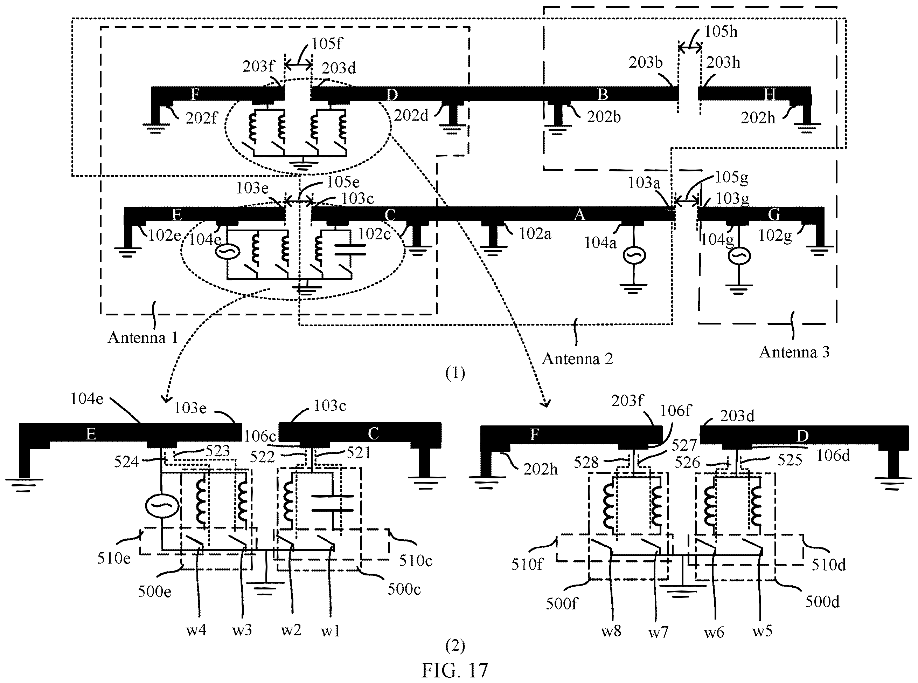

**FIG. 17 is an example diagram of the second antenna structure.**

As shown in (1) in FIG. 17, in the second antenna structure, an arrangement manner of all radiators is a linear arrangement, and all of the radiators are disposed at a bezel 1 of the electronic device. The bezel 1 may be a horizontal bezel or a vertical bezel. All of a radiator E, a radiator C, a radiator A, and a radiator G are disposed at a bezel 1 of the first device body 100. All of a radiator F, a radiator D, a radiator B, and a radiator H are disposed at a bezel 1 of the second device body 200.

In the second antenna structure, the radiator A to the radiator D satisfy the foregoing fixed arrangements. For related descriptions of the fixed arrangements, refer to the foregoing content. Details are not described herein again. Except that an arrangement manner of the radiator E, the radiator F, the radiator G, and the radiator H is different from that of corresponding radiators in the foregoing first antenna structure, other settings are the same or similar. Refer to the foregoing descriptions of the radiator E to the radiator H in the first antenna structure. Details are not described herein again.

An antenna 2 is separately coupled to an antenna 1 and an antenna 3. A form of coupling between the antenna 2 and the antenna 1 includes: The radiator C is coupled to the radiator E through a slot 105e, and an opening end 103c of the radiator C and an opening end 103e of the radiator E are arranged opposite to each other. The radiator D is coupled to radiator F through a slot 105f, and an opening end 203d of the radiator D and an opening end 203f of the radiator F are arranged opposite to each other. There is no relationship between a length of the slot 105e and a length of the foregoing slot 105c. The slot 105e and the slot 105c may have equal lengths, or one of the slot 105e and the slot 105c may be longer than the other. There is no relationship between a length of the slot 105d and a length of the foregoing slot 105f. The slot 105d and the slot 105f may have equal lengths, or one of the slot 105d and the slot 105f may be longer than the other.

A form of coupling between the antenna 2 and the antenna 3 includes: The radiator A is coupled to the radiator G through a slot 105g, and an opening end 103g of the radiator G and an opening end 103a of the radiator A are arranged opposite to each other. The radiator B is coupled to radiator H through a slot 105h, and an opening end 203b of the radiator B and an opening end 203h of the radiator H are arranged opposite to each other. There is no relationship between a length of the slot 105h and a length of the foregoing slot 105b. The slot 105h and the slot 105b may have equal lengths, or one of the slot 105h and the slot 105b may be longer than the other. There is no relationship between a length of the slot 105g and a length of the foregoing slot 105a. The slot 105g and the slot 105a may have equal lengths, or one of the slot 105g and the slot 105a may be longer than the other.

When the antenna 2 is coupled to the antenna 1 and the antenna 3, the antenna 2 may share the radiator C, the radiator D, and the radiator F with the antenna 1, and the antenna 2 may share the radiator B and the radiator H with the antenna 1. This may be referred to as that the antenna 2 includes the radiator A to the radiator D and further includes the radiator H and the radiator F, the antenna 1 includes the radiator E, the radiator F, the radiator C, and the radiator D, and the antenna 3 includes the radiator G, the radiator H, and the radiator B.

As shown in (2) in FIG. 17, the electronic device may further include a frequency control circuit 500c, a frequency control circuit 500e, a frequency control circuit 500d, and a frequency control circuit 500f.

A connection point 106c of the radiator C is connected to the first floor in the first device body 100 through the frequency control circuit 500c. The frequency control circuit 500c includes a switch device 510c and a plurality of frequency adjustment branches C2 arranged in parallel. The switch device 510c is configured to be gated to at least one frequency adjustment branch C2, to adjust a frequency of the radiator C. The switch device 510c may include at least one switch unit. The switch device 510c may be gated to at least one frequency adjustment branch C2 by switching the switch unit between on (ON) and off (OFF). For example, the plurality of frequency adjustment branches C2 may include a frequency adjustment branch 521 and a frequency adjustment branch 522. The frequency adjustment branch 521 is connected to a switch unit w1, and the switch unit w1 is configured to control whether to turn on the frequency adjustment branch 521. The frequency adjustment branch 522 is connected to a switch unit w2, and the switch unit w2 is configured to control whether to turn on the frequency adjustment branch 522. A case in which the switch device 510c controls the switch unit w1 to be on (ON) and controls the switch unit w2 to be off (OFF) indicates that the switch device 510c is gated to the frequency adjustment branch 521 and is not gated to the frequency adjustment branch 522. For other cases of gating of the switch device 510c, refer to the foregoing descriptions. Details are not described herein again.

In some possible cases, the connection point 106c is provided at a position close to the opening end 103e of the radiator E.

The feed point 104e of the radiator E is connected to the first floor in the first device body 100 through the frequency control circuit 500e. The frequency control circuit 500e includes a switch device 510e and a plurality of frequency adjustment branches E2 arranged in parallel. The switch device 510e is configured to be gated to at least one frequency adjustment branch E2, to adjust a frequency of the radiator E. The switch device 510e may include at least one switch unit. The switch device 510e may be gated to at least one frequency adjustment branch E2 by switching the switch unit between on (ON) and off (OFF). For example, the plurality of frequency adjustment branches E2 may include a frequency adjustment branch 523 and a frequency adjustment branch 524. The frequency adjustment branch 523 is connected to a switch unit w3, and the switch unit w3 is configured to control whether to turn on the frequency adjustment branch 523. The frequency adjustment branch 524 is connected to a switch unit w4, and the switch unit w4 is configured to control whether to turn on the frequency adjustment branch 524. For a case of gating of the switch device 510e, refer to the foregoing descriptions. Details are not described herein again.

In some possible cases, the feed point 104e is arranged at a position close to the opening end 103e of the radiator E.

A connection point 106d of the radiator D is connected to the second floor in the second device body 200 through the frequency control circuit 500d. The frequency control circuit 500d includes a switch device 510d and a plurality of frequency adjustment branches D2 arranged in parallel. The switch device 510d is configured to be gated to at least one frequency adjustment branch D2, to adjust a frequency of the radiator D. The switch device 510d may include at least one switch unit. The switch device 510d may be gated to at least one frequency adjustment branch D2 by switching the switch unit between on (ON) and off (OFF). For example, the plurality of frequency adjustment branches D2 may include a frequency adjustment branch 525 and a frequency adjustment branch 526. The frequency adjustment branch 525 is connected to a switch unit w5, and the switch unit w5 is configured to control whether to turn on the frequency adjustment branch 525. The frequency adjustment branch 526 is connected to a switch unit w6, and the switch unit w6 is configured to control whether to turn on the frequency adjustment branch 526. For a case of gating of the switch device 510d, refer to the foregoing descriptions. Details are not described herein again.

In some possible cases, the connection point 106d is provided at a position close to the opening end 203d of the radiator E.

A connection point 106f of the radiator F is connected to the second floor in the second device body 200 through the frequency control circuit 500f. The frequency control circuit 500f includes a switch device 510f and a plurality of frequency adjustment branches C2 arranged in parallel. The switch device 510f is configured to be gated to at least one frequency adjustment branch C2, to adjust a frequency of the radiator F. The switch device 510f may include at least one switch unit. The switch device 510f may be gated to at least one frequency adjustment branch C2 by switching the switch unit between on (ON) and off (OFF). For example, the plurality of frequency adjustment branches C2 may include a frequency adjustment branch 527 and a frequency adjustment branch 528. The frequency adjustment branch 527 is connected to a switch unit w7, and the switch unit w7 is configured to control whether to turn on the frequency adjustment branch 527. The frequency adjustment branch 528 is connected to a switch unit w8, and the switch unit w8 is configured to control whether to turn on the frequency adjustment branch 528. For a case of gating of the switch device 510f, refer to the foregoing descriptions. Details are not described herein again.

In some possible cases, the connection point 106f is provided at a position close to the opening end 203f of the radiator E.

Herein, it should be understood that each matching branch may include one or more lumped elements, for example, one or more of lumped elements such as a resistor, a capacitor, and an inductor. Lumped elements included in different matching branches may be different. The being different includes that types, parameter values, quantities, or the like of the lumped elements are different.

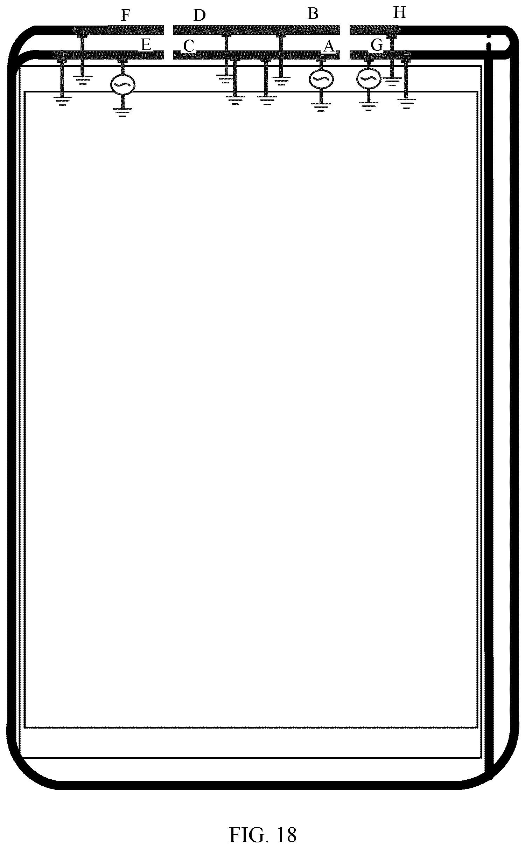

**FIG. 18 shows an example arrangement of the first antenna structure in the electronic device.**

As shown in FIG. 18, the radiator G, the radiator A, the radiator C, and the radiator E are disposed at a horizontal bezel of the first device body 100 of the electronic device.

The radiator H, the radiator B, the radiator D, and the radiator F are disposed at a horizontal bezel of the second device body 200 of the electronic device.

**How to perform frequency adjustment based on the second antenna structure to improve performance of an antenna in the folded state is described below in detail.**

When an antenna structure is the second antenna structure, operating frequency bands (frequency ranges) of the antenna 1 to the antenna 3 and communication modes provided by the antennas for the electronic device may be the same as those of the foregoing first antenna structure. For specific content, refer to the foregoing descriptions of related content. Details are not described herein again.

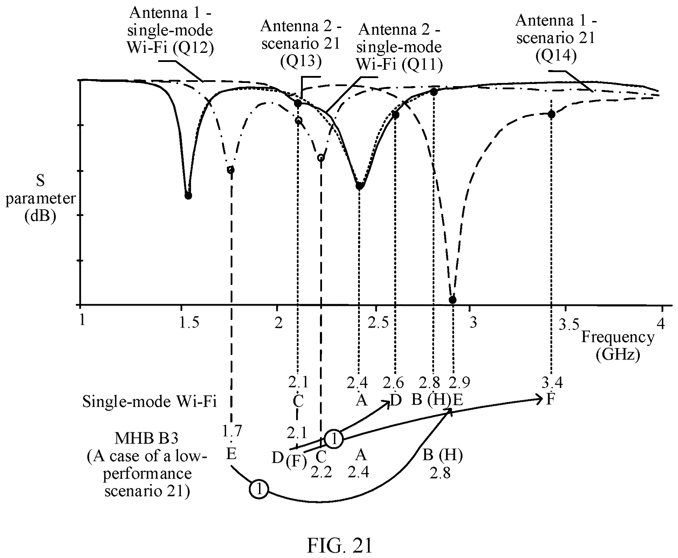

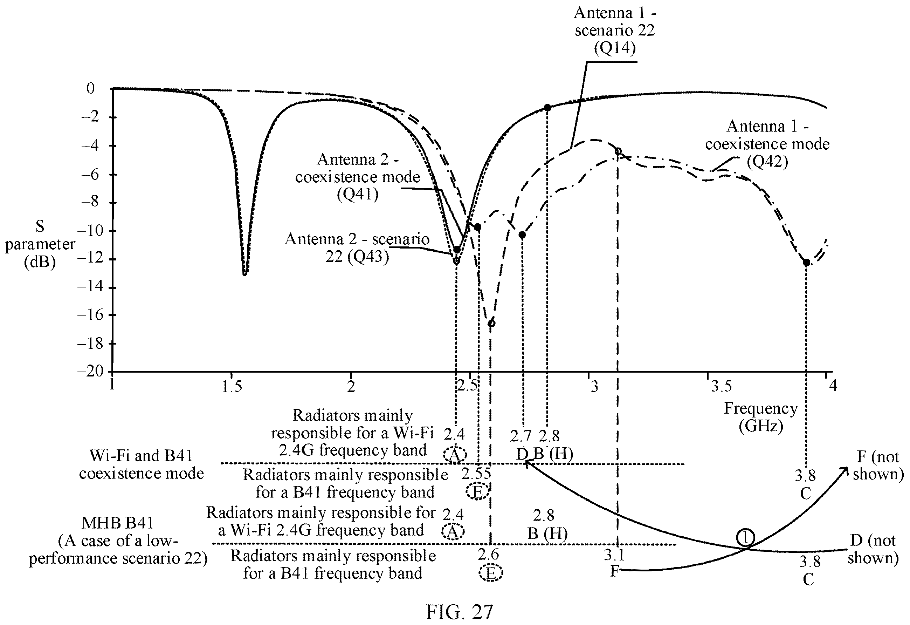

However, when operating frequencies of the antenna 1 to the antenna 3 are adjusted according to a preset frequency adjustment rule 12, the following low-performance scenario may appear: When performance of an antenna (an antenna A) responsible for providing a communication mode A is low, the foldable-screen electronic device has a poor communication capability when communicating with another electronic device in the communication mode A. The following describes two example low-performance scenarios (a low-performance scenario 21 and a low-performance scenario 22) that appear when the second antenna structure is arranged in the electronic device and the preset frequency adjustment rule 12 is used, and solutions for the low-performance scenarios. The preset frequency adjustment rule 12 may include a frequency adjustment rule 12a and a frequency adjustment rule 12b below. For related descriptions of the frequency adjustment rule 12a and the frequency adjustment rule 12b, refer to the following content. For example, for the preset frequency adjustment rule 12a, refer to the following descriptions of related content in FIG. 21. For the preset frequency adjustment rule 12b, refer to the following descriptions of related content in FIG. 27.

**Low-performance scenario 21:**

When the operating frequencies of the antenna 1 to the antenna 3 are adjusted according to the preset frequency adjustment rule 12a and the electronic device is in single-mode Wi-Fi, the antenna 2 has low performance when operating on a Wi-Fi 2.4G frequency band. Consequently, the electronic device has a poor communication capability when communicating with another electronic device in the single-mode Wi-Fi. For related descriptions of the single-mode Wi-Fi, refer to the foregoing content. Details are not described herein again.

For a cause of low performance of the antenna 2 operating on the Wi-Fi 2.4G frequency band in the low-performance scenario 21, refer to the following descriptions of FIG. 21. Details are not described herein.

**An improvement manner for the low-performance scenario 21 and related content thereof are described below.**

In the low-performance scenario 21, based on the second antenna structure in this application, when the electronic device is in the single-mode Wi-Fi, the electronic device may re-adjust, according to a preset frequency adjustment rule 22a, operating frequencies of the antenna 2 and the antenna 1 coupled thereto, to adjust current directions of radiators in the antenna 1 and the antenna 2 to a target current direction (denoted as a target current direction 21). The target current direction 21 is a current direction satisfying the single-mode Wi-Fi when the second antenna structure is used. The radiators in the antenna 1 and the antenna 2 may be responsible for providing a 2.4G Wi-Fi communication mode, to improve performance of the antenna 2, and therefore improve a communication capability of the electronic device during communication with another electronic device in the 2.4G Wi-Fi communication mode. The antenna 1 is an antenna responsible for providing cellular network communication. Because the communication mode for which the antenna 1 is responsible is not enabled for the electronic device in the low-performance scenario 21, an operating frequency of the antenna 1 may be adjusted to use the antenna 1 to assist the antenna 2 in improving performance. For a reason for generating the target current direction herein, refer to the foregoing related descriptions of generating the target current direction. Details are not described herein again.

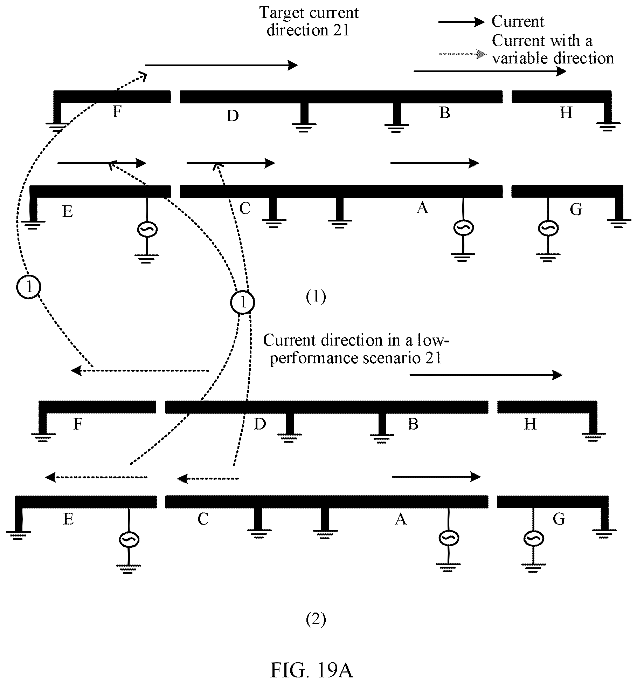

**FIG. 19A is a diagram of comparison between a current direction in a single-mode Wi-Fi scenario and a current direction in the low-performance scenario 21.**

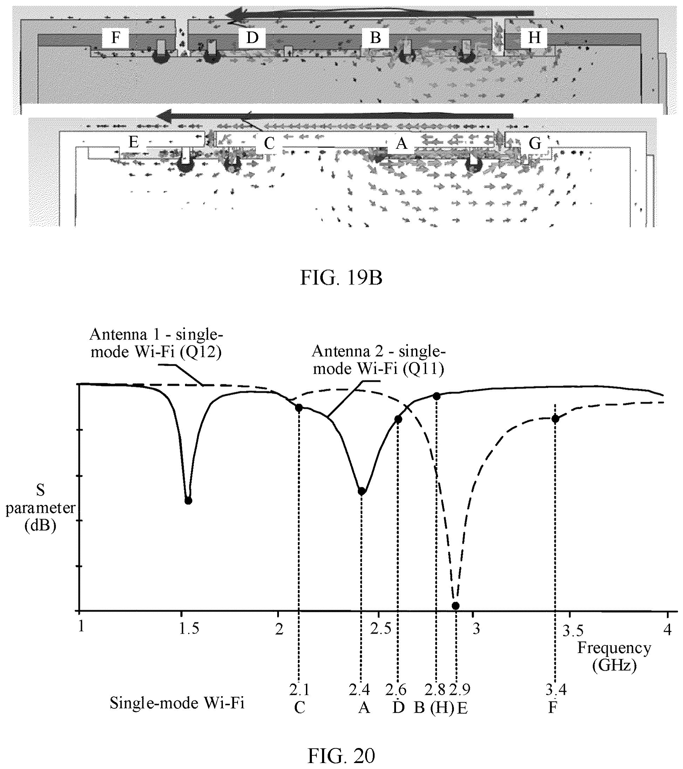

**FIG. 19B is a simulation diagram of example current distribution when the electronic device is in the single-mode Wi-Fi.**

**First, based on the foregoing reason for generating the target current direction, a target current direction 21 proposed for the single-mode Wi-Fi scenario is described in detail with reference to FIG. 19A and FIG. 19B.**

**(1) in FIG. 19A is a diagram of a target current direction 21.**

(1) in FIG. 19A shows expected current directions (the target current direction 21) of the radiators in the antenna 1 and the antenna 2 when the operating frequencies of the antenna 2 and the antenna 1 coupled thereto are re-adjusted according to the preset frequency adjustment rule 22a. When the electronic device is in the single-mode Wi-Fi, the antenna 2 is responsible for providing the 2.4G Wi-Fi communication mode for the electronic device, the radiator A is a primary radiator, and the radiator H, the radiator B, the radiator D, the radiator F, the radiator C, and the radiator E are parasitic radiators. Based on the foregoing content, all of the radiator H, the radiator B, the radiator D, the radiator F, the radiator C, and the radiator E are first-type radiators, and directions of expected currents generated by the radiators are the same as a direction of a current of the radiator A.

It should be understood that an example in which a current direction of the radiator A (primary radiator) is a direction shown in (1) in FIG. 5A is used for description herein. In an actual case, the current direction of the radiator A may alternatively be opposite to the direction shown in (1) in FIG. 5A. This is not limited in this embodiment of this application.

**(2) in FIG. 19A shows a current direction in the low-performance scenario 21.**

With reference to (2) in FIG. 19A and (1) in FIG. 19A, the following describes in detail causes of improvement of performance of the antenna 2 when the electronic device is in the single-mode Wi-Fi after a frequency adjustment rule in this application is used.

Refer to (2) in FIG. 19A. In the low-performance scenario 21, a cause of low performance of the antenna 2 includes but is not limited to the following causes.

**Cause of low performance 21-1:** The radiator F, the radiator D, the radiator E, and the radiator C are first-type radiators. However, currents generated by the radiators are in a direction opposite to a current of the radiator A, and parasitic resonance caused by the radiators has adverse impact on the radiator A, leading to degradation of performance of the antenna 2.

It can be learned from (1) in FIG. 19A and (2) in FIG. 19A that, for the cause of low performance 21-1, a first change is made: The currents generated by the radiator F, the radiator D, the radiator E, and the radiator C change from being in a direction opposite to the direction of the current of the radiator A (primary radiator) to being in a same direction as the current of the radiator A, so that performance of the antenna 2 can be improved. The first change for the cause of low performance 21-1 is indicated by a white circle ① in FIG. 19A.

FIG. 19B is a simulation diagram of example current distribution when the electronic device is in the single-mode Wi-Fi. The current distribution corresponds to the target current direction 21 shown in (1) in FIG. 19A. Current directions of the radiator B to the radiator E are the same as a current direction of the radiator A.

**The preset frequency adjustment rule 22a for adjusting the target current direction 21 is further described.**

In some possible cases, the preset frequency adjustment rule 22a is used for adjusting a frequency magnitude relationship between the radiator A (primary radiator) and parasitic radiators of the radiator A.

The preset frequency adjustment rule 22a may include: In the second antenna structure, when the electronic device is in the single-mode Wi-Fi, an operating frequency (denoted as an operating frequency A) of the radiator A (primary radiator) is adjusted to belong to the Wi-Fi 2.4G frequency band (denoted as a frequency band A). For example, the operating frequency A may be 2.4 GHz. An operating frequency of the radiator C is adjusted to be less than and close to the operating frequency A. An electrical length of the radiator B is set to be greater than a preset length value 1, and an electrical length of the radiator H is set to be greater than the preset length value 1, so that the radiator B and the radiator H can be considered as one parasitic radiator with the radiator B as a main radiator. This may be considered as that a frequency of the radiator H is the same as a frequency of the radiator B. In addition, an operating frequency of the radiator B is adjusted to be greater than and close to the operating frequency A. An operating frequency of the radiator D is adjusted to be greater than and close to the operating frequency A. An operating frequency of the radiator E is adjusted to be greater than and close to the operating frequency A. An operating frequency of the radiator F is greater than and close to the operating frequency A.

In some possible cases, an operating frequency of a parasitic radiator closer to the radiator A (primary radiator) may be set to be closer to the operating frequency A. Because distances from the radiator D, the radiator B, the radiator E, and the radiator F to the radiator gradually increase, radiators in ascending order of frequencies in the single-mode Wi-Fi scenario may be sequentially as follows: the radiator C, the radiator A, the radiator D, the radiator B, the radiator H, the radiator E, and the radiator F.

Herein, it should be understood that the radiator A (primary radiator) is a primary radiator having a highest degree of coupling to the radiator C, the radiator D, the radiator B, the radiator E, and the radiator F. The radiator H may be considered as a parasitic radiator with the radiator B as a main radiator, and a direction of a current generated by the radiator H is the same as a direction of a current of the radiator B. Based on the foregoing reason for generating the target current direction, it can be understood that the target current direction 21 may be generated with reference to the preset frequency adjustment rule 22a and the foregoing reason for generating the target current direction, to improve performance of the antenna 2.

It should be understood that, in the foregoing descriptions, all of the radiator C, the radiator D, the radiator B, the radiator H, the radiator E, and the radiator F serve as parasitic radiators of the radiator A (primary radiator). Operating frequencies of the parasitic radiators are adjusted, so that appropriate parasitic resonance is generated after the primary radiator performs resonance, to improve performance of the antenna 2. In an actual case, more or fewer parasitic radiators than those described above may be used to generate parasitic resonance to improve performance of the antenna 2. For example, in some other possible cases, only the radiator C, the radiator D, and the radiator B may serve as parasitic radiators of the radiator A (primary radiator), and generate appropriate parasitic resonance after the primary radiator performs resonance, to improve performance of the antenna 2. In this case, the preset frequency adjustment rule 21a may include: An operating frequency (denoted as an operating frequency A) of the radiator A (primary radiator) belongs to the Wi-Fi 2.4G frequency band (denoted as a frequency band A). For example, the operating frequency A may be 2.4 GHz. An operating frequency of the radiator C is less than and close to the operating frequency A. Based on the foregoing content, in this case, the radiator C, the radiator D, the radiator B, and the radiator A (primary radiator) in ascending order of operating frequencies may be as follows: the radiator C, the radiator A (primary radiator), the radiator D, and the radiator B.

**FIG. 20 is a diagram of a preset frequency adjustment rule 22a.**

FIG. 20 is a line graph of effect of an S parameter for the antenna 1 and the antenna 2 in the single-mode Wi-Fi scenario during simulation effect testing of the electronic device. A horizontal coordinate represents a frequency in a unit of GHz, and a vertical coordinate represents an amplitude value of S11 in a unit of dB.

FIG. 20 includes two curves: a curve "Antenna 2 - single-mode Wi-Fi", referred to as a curve Q11; and a curve "Antenna 1 - single-mode Wi-Fi", referred to as a curve Q12. The curve Q11 shows a frequency magnitude relationship between radiators in the antenna 2 and frequencies corresponding to the radiators in the single-mode Wi-Fi scenario. The curve Q12 shows a frequency magnitude relationship between radiators in the antenna 1 and frequencies corresponding to the radiators in the single-mode Wi-Fi scenario.

In FIG. 20, letters A to F respectively represent the radiator A to the radiator F. It can be learned from FIG. 20 that radiators in ascending order of frequencies in the single-mode Wi-Fi scenario may be sequentially as follows: the radiator C (approximately 2.1 GHz), the radiator A (approximately 2.4 GHz), the radiator D (approximately 2.6 GHz), the radiator B and the radiator H (approximately 2.8 GHz), the radiator E (approximately 2.9 GHz), and the radiator F (approximately 3.4 GHz). This satisfies the foregoing descriptions of the preset frequency adjustment rule 22a. The frequency magnitude relationship between the radiators in FIG. 20 can enable expected current directions of the radiators in the antenna 1 and the antenna 2 to be the target current direction 21. For descriptions of the target current direction 21, refer to the foregoing descriptions of (1) in FIG. 19A. Details are not described herein again.

Herein, it should be understood that, as shown in FIG. 20, compared with the radiator E and the radiator F, a reason for adjusting frequencies of the radiator D and the radiator B to be closer to that of the radiator A (primary radiator) is to use a radiator satisfying a fixed arrangement to better achieve forward parasitic radiation effect on the radiator A. Compared with the radiator E and the radiator F, the radiator B and the radiator D are closer to the radiator A, and are more likely to have forward parasitic radiation effect on the radiator A.

Herein, it should be further understood that the antenna 1 and the antenna 2 may share the radiator D, the radiator F, and the radiator C in the single-mode Wi-Fi scenario. FIG. 20 shows an example in which the radiator D and the radiator F belong to the antenna 1. In an actual case, an example in which the radiator D and the radiator F belong to the antenna 2 may alternatively be used. This is not limited in this embodiment of this application.

**FIG. 21 is a diagram of comparison between a frequency adjustment rule in the single-mode Wi-Fi scenario and a frequency adjustment rule in the low-performance scenario 21.**

FIG. 21 is a line graph of comparison between effect of an S parameter for the antenna 1 and the antenna 2 in the single-mode Wi-Fi scenario and that in the low-performance scenario 11 during simulation effect testing of the electronic device. A horizontal coordinate represents a frequency in a unit of GHz, and a vertical coordinate represents an amplitude value of S11 in a unit of dB.

FIG. 21 includes four curves: a curve "Antenna 2 - single-mode Wi-Fi", referred to as a curve Q11; a curve "Antenna 1 - single-mode Wi-Fi", referred to as a curve Q12; a curve "Antenna 2 - scenario 21", referred to as a curve Q13; and a curve "Antenna 1 - scenario 21", referred to as a curve Q14. The curve Q13 shows a frequency magnitude relationship between radiators in the antenna 2 and frequencies corresponding to the radiators in the low-performance scenario 21. The curve Q14 shows a frequency magnitude relationship between radiators in the antenna 1 and frequencies corresponding to the radiators in the low-performance scenario 21. Related descriptions of the curve Q11 and the curve Q12 are the same as those of the curve Q11, the curve Q12, and related content thereof in FIG. 6. Details are not described herein again.

Herein, it should be understood that the curve Q13 and the curve Q14 shown in FIG. 21 are a case in the low-performance scenario 21. In this case, in the low-performance scenario 21, when an operating frequency of the antenna 1 is a mid-high band B3 frequency band (MHB B3 for short), performance of the antenna 2 is the best compared with performance achieved when the operating frequency of the antenna 1 is another frequency band.

In FIG. 21, letters A to F respectively represent the radiator A to the radiator F. It can be learned from FIG. 21 that radiators in ascending order of frequencies in the low-performance scenario 21 may be sequentially as follows: the radiator E (approximately 1.7 GHz), the radiator D and the radiator F (approximately 2.1 GHz), the radiator C (approximately 2.2 GHz), the radiator A (approximately 2.4 GHz), and the radiator B and the radiator H (approximately 2.8 GHz). This satisfies the foregoing descriptions of the preset frequency adjustment rule 12a. This may be understood as an example of the frequency adjustment rule 12a. The frequency magnitude relationships between the radiators shown in the curve Q13 and the curve Q14 in FIG. 20 can enable current directions of the radiators in the antenna 1 and the antenna 2 to be the current direction in the foregoing low-performance scenario 21. For the current direction in the low-performance scenario 21, refer to the foregoing descriptions of (2) in FIG. 19A. Details are not described herein again.

It can be learned from operating frequencies of radiators determined according to the preset frequency adjustment rule 21a that, compared with the low-performance scenario 21, an operating frequency of at least one radiator in the single-mode Wi-Fi scenario changes. For example, the change includes but is not limited to the following changes.

Radiator frequency change 21: Operating frequencies of the radiator E, the radiator D, and the radiator F change from being higher than an operating frequency of the radiator A (primary radiator) to being lower than the operating frequency of the radiator A. The change is indicated by a white circle ① in FIG. 21.

The radiator frequency change 21 may cause current directions of the radiator E, the radiator D, and the radiator F to change from being opposite to a current direction of the radiator A to being the same as the current direction of the radiator A. For related descriptions of the current direction changes of the radiator E, the radiator D, and the radiator F, refer to the foregoing related descriptions of the white circle ① in FIG. 19A. Details are not described herein again.

Herein, it should be understood that values of operating frequencies of radiators shown in FIG. 20 and FIG. 21 are examples for description, and may be other values in an actual case. For example, an operating frequency of a same radiator is an operating frequency greater than or less than the operating frequency by 1 GHz. This shall not be construed as a limitation on embodiments of this application.

**The following describes a process in which frequencies of radiators are adjusted by using at least one frequency control circuit according to the preset frequency adjustment rule 22a in the single-mode Wi-Fi scenario, to enable directions of expected currents generated by the radiators to satisfy the target current direction 21. In addition, the adjustment process is compared with an adjustment process in the low-performance scenario.**

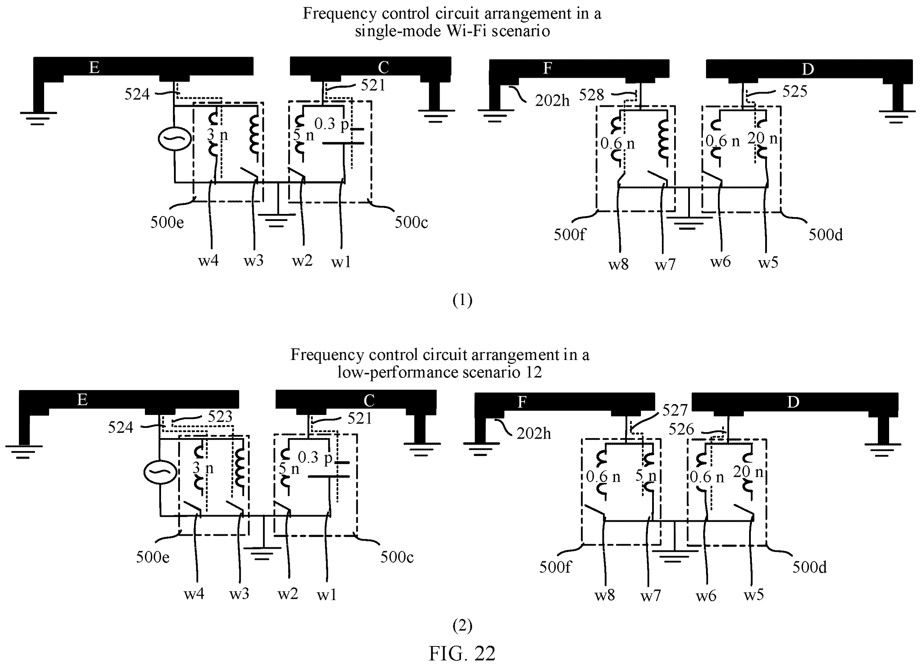

**FIG. 22 is a diagram of a frequency control circuit arrangement in the single-mode Wi-Fi scenario and a frequency control circuit arrangement in the low-performance scenario 21.**

How to obtain, through adjustment, the frequencies of the radiators shown in FIG. 21 is described below based on FIG. 22.

In the first antenna structure, the radiator B and the radiator H are not connected to a frequency control circuit, and the radiator H may be considered as a parasitic radiator with the radiator B as a main radiator. Operating frequencies of the radiator B and the radiator H may be equal and fixed at a frequency band. The frequency band is approximately 2.6 GHz to 2.8 GHz. For example, the operating frequency may be 2.8 GHz. This is not limited in this embodiment of this application.

Frequency control circuits are connected to the radiator C, the radiator E, the radiator D, and the radiator F. The arrangement of the frequency control circuits herein is also intended to describe frequency adjustment for the radiator C, the radiator E, the radiator D, and the radiator F.

(1) in FIG. 22 shows the frequency control circuit arrangement in the single-mode Wi-Fi scenario. For the radiator C, the electronic device turns on (ON) a switch unit w1 and turns off (OFF) w2 in a frequency control circuit 500c, to turn on a frequency adjustment branch 521. This is equivalent to that the radiator C is connected to a capacitor of approximately 0.3 p, and a frequency is adjusted to approximately 2.1 GHz. For the radiator E, the electronic device turns on (ON) a switch unit w4 and turns off (OFF) w3 in a frequency control circuit 500e, to turn on a frequency adjustment branch 524. This is equivalent to that the radiator E is connected to an inductor of approximately 3 n, and a frequency is adjusted to approximately 2.9 GHz. For the radiator D, the electronic device turns on (ON) a switch unit w5 and turns off (OFF) w6 in a frequency control circuit 500d, to turn on a frequency adjustment branch 525. This is equivalent to that the radiator D is connected to an inductor of approximately 20 n, and a frequency is adjusted to approximately 2.6 GHz. For the radiator F, the electronic device turns on (ON) a switch unit w8 and turns off (OFF) w7 in a frequency control circuit 500f, to turn on a frequency adjustment branch 528. This is equivalent to that the radiator F is connected to an inductor of approximately 0.6 n, and a frequency is adjusted to approximately 3.4 GHz.

(2) in FIG. 22 shows the frequency control circuit arrangement in the low-performance scenario 12. For the radiator C, a control manner of the frequency control circuit 500c connected to the radiator C is the same as that in (1) in FIG. 22. In this case, a frequency of the radiator C is adjusted to approximately 2.2 GHz. For the radiator E, the electronic device turns off (OFF) both a switch unit w4 and a switch unit w3 in a frequency control circuit 500e, to turn on neither of a frequency adjustment branch 524 and a frequency adjustment branch 525. This is equivalent to that the radiator E is connected to a 0-ohm resistor and then grounded, and a frequency is adjusted to approximately 1.7 GHz. For the radiator D, the electronic device turns on (ON) a switch unit w6 and turns off (OFF) w5 in a frequency control circuit 500d, to turn on a frequency adjustment branch 526. This is equivalent to that the radiator D is connected to an inductor of approximately 0.6 n, and a frequency is adjusted to approximately 2.1 GHz. For the radiator F, the electronic device turns on (ON) a switch unit w7 and turns off (OFF) w8 in a frequency control circuit 500f, to turn on a frequency adjustment branch 527. This is equivalent to that the radiator F is connected to an inductor of approximately 5 n, and a frequency is adjusted to approximately 2.1 GHz.

**The following describes beneficial effect of the single-mode Wi-Fi scenario compared with the low-performance scenario 21.**

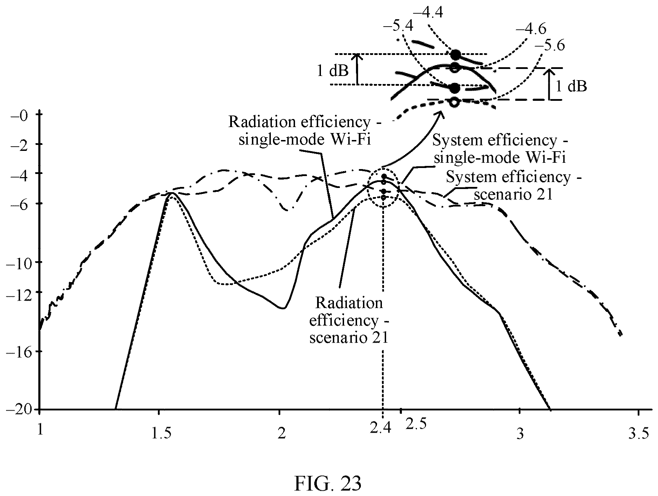

**FIG. 23 is a diagram of comparison between radiation efficiency and system efficiency of the antenna 2 in the single-mode Wi-Fi scenario and radiation efficiency and system efficiency of the antenna 2 in the low-performance scenario 21 during simulation effect testing of the electronic device.**

As shown in FIG. 23, a horizontal coordinate represents a frequency in a unit of GHz, and a vertical coordinate represents efficiency (radiation efficiency or system efficiency) in a unit of dB.

In FIG. 23, a curve "Radiation efficiency - single-mode Wi-Fi" and a curve "Radiation efficiency - scenario 21" respectively represent radiation efficiency during operation of the antenna 2 in the single-mode Wi-Fi scenario and radiation efficiency during operation of the antenna 2 in the low-performance scenario. In this case, an operating frequency of the antenna 2 is 2.4 GHz, the radiation efficiency of the antenna 2 in the single-mode Wi-Fi scenario is approximately -4.6 dB, and the radiation efficiency of the antenna 2 in the low-performance scenario 21 is approximately -5.6 dB. Therefore, compared with the low-performance scenario 21, in the single-mode Wi-Fi, the radiation efficiency of the antenna 2 is improved by approximately 1 dB.

In FIG. 23, a curve "System efficiency - single-mode Wi-Fi" and a curve "System efficiency - scenario 21" respectively represent system efficiency during operation of the antenna 2 in the single-mode Wi-Fi scenario and system efficiency during operation of the antenna 2 in the low-performance scenario. In this case, an operating frequency of the antenna 2 is 2.4 GHz, the system efficiency of the antenna 2 in the single-mode Wi-Fi scenario is approximately -4.4 dB, and the system efficiency of the antenna 2 in the low-performance scenario 21 is approximately -5.4 dB. Therefore, compared with the low-performance scenario 21, in the single-mode Wi-Fi, the system efficiency of the antenna 2 is also improved by 1 dB.

**Low-performance scenario 22:**

When the operating frequencies of the antenna 1 to the antenna 3 are adjusted according to the preset frequency adjustment rule 12b and the electronic device is in a Wi-Fi and B41 coexistence mode, the antenna 1 is responsible for providing a cellular network communication mode (on a B41 frequency band), and the antenna 2 is responsible for providing a 2.4G Wi-Fi communication mode. In this case, although performance of the antenna 1 is good, the antenna 2 has low performance when operating on a Wi-Fi 2.4G frequency band. Consequently, the electronic device has a poor communication capability when communicating with another electronic device in the 2.4G Wi-Fi communication mode in the Wi-Fi and B41 coexistence mode. For related descriptions of the Wi-Fi and B41 coexistence mode, refer to the foregoing content. Details are not described herein again.

For a cause of low performance of the antenna 2 operating on the Wi-Fi 2.4G frequency band in the low-performance scenario 22, refer to the following descriptions of FIG. 27. Details are not described herein.

**An improvement manner for the low-performance scenario 22 and related content thereof are described below.**

In the low-performance scenario 22, based on the second antenna structure in this application, when the electronic device is in the Wi-Fi and B41 coexistence mode, the electronic device may re-adjust, according to a preset frequency adjustment rule 22b, operating frequencies of radiators in the antenna 2 and the antenna 1 coupled thereto, to adjust current directions of radiators in the antenna 1 and the antenna 2 to a target current direction (denoted as a target current direction 22). The target current direction 22 is a current direction satisfying the Wi-Fi and B41 coexistence mode when the second antenna structure is used. The electronic device may change operating frequencies of some radiators responsible for providing the cellular network communication mode (on the B41 frequency band), to enable resonance generated by the radiators to be used for providing the 2.4G Wi-Fi communication mode. Alternatively, the electronic device may change operating frequencies of some radiators responsible for providing the cellular network communication mode (on the B41 frequency band), to prevent resonance generated by the radiators from causing adverse impact on the 2.4G Wi-Fi communication mode. For a reason for generating the target current direction 22 herein, refer to the foregoing related descriptions of generating the target current direction. Details are not described herein again.

**First, based on the foregoing reason for generating the target current direction, a target current direction 22 proposed for the Wi-Fi and B41 coexistence mode scenario is described in detail.**

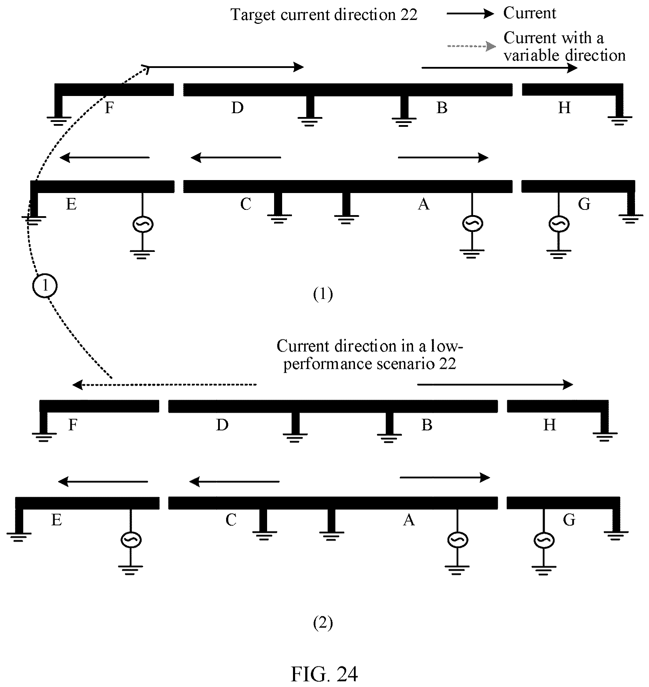

**(1) in FIG. 24 is a diagram of a target current direction 22.**

(1) in FIG. 24 shows expected current directions (the target current direction 22) of the radiators in the antenna 1 and the antenna 2 when the operating frequencies of the antenna 2 and the antenna 1 are re-adjusted according to the preset frequency adjustment rule 22b.

The antenna 1 is mainly responsible for providing the cellular network communication mode (on the B41 frequency band) for the electronic device. In this case, the radiator E is a primary radiator. A parasitic radiator of the radiator E mainly includes the radiator C. The radiator C is a first-type radiator, and a direction of an expected current generated by the radiator C is the same as a direction of a current of the radiator E.

The antenna 2 is mainly responsible for providing the 2.4G Wi-Fi communication mode for the electronic device. In this case, the radiator A is a primary radiator. A parasitic radiator of the radiator A mainly includes the radiator B, the radiator H, the radiator D, and the radiator F. The radiator B, the radiator H, the radiator D, and the radiator F are first-type radiators, and directions of expected currents generated by the radiators are the same as a direction of a current of the radiator A.

In some possible cases, an expected current direction of the radiator E (primary radiator) is opposite to an expected current direction of the radiator A (primary radiator).

Herein, it should be understood that, in addition to the radiator C, the parasitic radiator of the radiator E may further include the radiator B, the radiator D, and other parasitic radiators. However, in the Wi-Fi and B41 coexistence mode scenario, radiators other than the radiator C have small impact on the radiator E and have large impact on the radiator A. This is not described herein, and is to be described below during description of the radiator A. Similarly, in the Wi-Fi and B41 coexistence mode scenario, in addition to the radiator B, the radiator H, the radiator D, and the radiator F, the parasitic radiator of the radiator A may further include the radiator E or other radiators. However, these radiators have small impact on the radiator A and are not described herein.

Herein, it should be understood that, in the Wi-Fi and B41 coexistence mode scenario, a frequency of the radiator D is higher than a frequency of the radiator E. When the frequency of the radiator E belongs to the B41 frequency band, the radiator D may also serve as a parasitic radiator of the radiator E, and the radiator D may generate a current (not shown in FIG. 24) in a same direction as a current of the radiator E, to achieve forward parasitic radiator effect on the radiator E.

It should be further understood that an example in which current directions of the radiator A (primary radiator) and the radiator E (primary radiator) are a direction shown in (1) in FIG. 24 is used for description herein. In an actual case, the current directions of the radiator A and the radiator E may alternatively be opposite to the direction shown in (1) in FIG. 24. This is not limited in this embodiment of this application.

**(2) in FIG. 24 shows a current direction in the low-performance scenario 22.**

With reference to (2) in FIG. 24 and (1) in FIG. 24, the following describes in detail causes of improvement of performance of the antenna 2 when the electronic device is in the Wi-Fi and B41 coexistence mode after a frequency adjustment rule in this application is used.

Refer to (2) in FIG. 24. In the low-performance scenario 22, a cause of low performance of the antenna 2 includes but is not limited to the following causes.

**Cause of low performance 22-1:** The radiator D and the radiator H are parasitic radiators of the radiator A (primary radiator), and are first-type radiators. However, currents of the radiator D and the radiator H are in a direction opposite to a direction of a current of the radiator A. Resonance generated when the currents of the radiator D and the radiator H are in a same direction as the current of the radiator A has adverse impact on the radiator A, leading to low performance of the antenna 2.

It can be learned from (1) in FIG. 24 and (2) in FIG. 24 that, for the cause of low performance 22-1, a first change is made: The currents of the radiator D and the radiator H change from being in a direction opposite to the direction of the current of the radiator A to being in a same direction as the current of the radiator A, so that performance of the antenna 2 can be improved. The first change for the cause of low performance 22-1 is indicated by a white circle ① in FIG. 24.

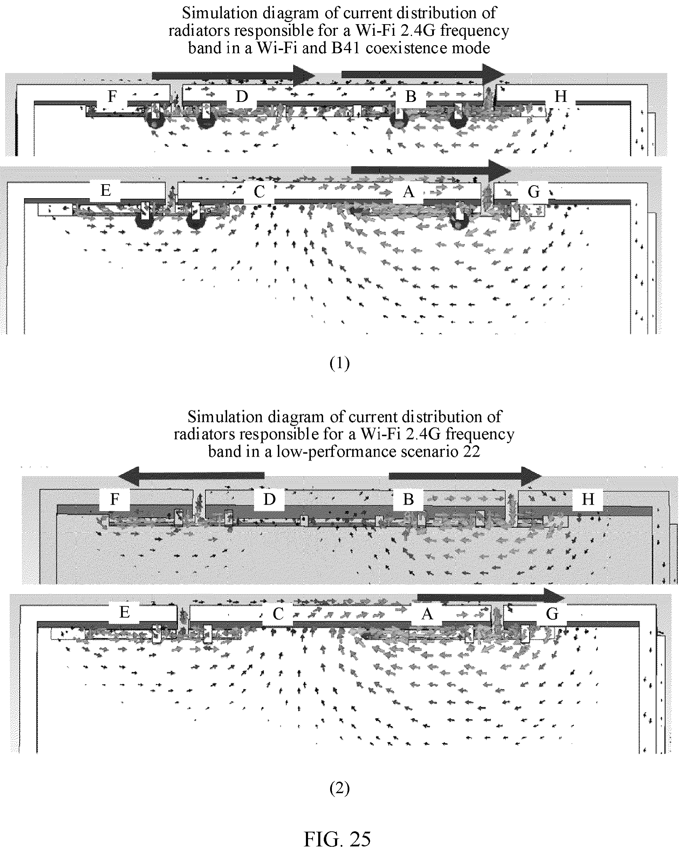

**FIG. 25 is a simulation diagram of example current distribution of radiators mainly responsible for the Wi-Fi 2.4G frequency band when the electronic device is in the Wi-Fi and B41 coexistence mode scenario.**

(1) in FIG. 25 is a simulation diagram of current distribution of radiators mainly responsible for the Wi-Fi 2.4G frequency band when the electronic device is in the Wi-Fi and B41 coexistence mode. Current directions of the radiators correspond to current directions of radiators in the target current direction 22 shown in (1) in FIG. 24. In this case, the radiator A is a primary radiator, and parasitic radiators may include the radiator D, the radiator F, the radiator B, and the radiator H. Current directions of the parasitic radiators are the same as a current direction of the radiator A.

(2) in FIG. 25 is a simulation diagram of current distribution of radiators mainly responsible for the Wi-Fi 2.4G frequency band when the electronic device is in the low-performance scenario 22. In this case, current directions of the radiator D and the radiator F are the same as a current direction of the radiator A, causing degradation of performance of the antenna 2 (including the radiator A).

**The preset frequency adjustment rule 22b for adjusting the target current direction 22 is further described.**

In some possible cases, the preset frequency adjustment rule 22b is used for adjusting a frequency magnitude relationship between the radiator A (primary radiator) and a main parasitic radiator (including the radiator B, the radiator H, the radiator D, and the radiator F) of the radiator A; and is further used for adjusting a frequency magnitude relationship between the radiator E (primary radiator) and a main parasitic radiator (including the radiator C) of the radiator E.

The preset frequency adjustment rule 22b may include: In the second antenna structure, when the electronic device is in the Wi-Fi and B41 coexistence mode, an operating frequency (denoted as an operating frequency A) of the radiator A (primary radiator) is adjusted to belong to the Wi-Fi 2.4G frequency band (denoted as a frequency band A). For example, the operating frequency A may be 2.4 GHz. An operating frequency of the radiator D is greater than and close to the operating frequency A. An electrical length of the radiator B is set to be greater than a preset length value 1, and an electrical length of the radiator H is set to be greater than the preset length value 1, so that the radiator B and the radiator H can be considered as one parasitic radiator with the radiator B as a main radiator. This may be considered as that a frequency of the radiator H is the same as a frequency of the radiator B. An operating frequency of the radiator B is adjusted to be greater than and close to the operating frequency A.

In some possible cases, an operating frequency of a (main) parasitic radiator closer to the radiator A (primary radiator) may be set to be closer to the operating frequency A. Because distances from the radiator D, the radiator B, the radiator E, and the radiator F to the radiator gradually increase, radiators, providing the 2.4G Wi-Fi communication mode, in ascending order of frequencies in the Wi-Fi and B41 coexistence mode scenario may be sequentially as follows: the radiator A, the radiator D, the radiator B, the radiator H, and the radiator F.

An operating frequency (denoted as an operating frequency E) of the radiator E (primary radiator) is adjusted to belong to the B41 frequency band. For example, the operating frequency E may be 2.55 GHz. An operating frequency of the radiator C is greater than the operating frequency E, and is close to the operating frequency E, so that an expected current generated by the radiator C is in a same direction as a current of the radiator E. In this case, radiators, responsible for providing the cellular network communication mode (on the B41 frequency band), in ascending order of frequencies in the Wi-Fi and B41 coexistence mode scenario may be sequentially as follows: the radiator E and the radiator C.

In some possible cases, the radiator C is highly coupled to the radiator A (primary radiator), but a direction of an expected current generated by the radiator C is opposite to a direction of a current of the radiator A. An operating frequency corresponding to the radiator C may be adjusted to be high, to avoid adverse impact on the radiator A. For example, an operating frequency of the radiator D is set to be higher than operating frequencies of radiators other than the radiator F. The radiator F is highly coupled to the radiator E (primary radiator), but a direction of an expected current generated by the radiator F is opposite to the direction of the current of the radiator A, and the radiator F is away from the radiator A. Therefore, an operating frequency of the radiator F may be set to be the highest, to reduce impact on the two radiators.

With reference to the foregoing content, in some possible cases, radiators in ascending order of operating frequencies in the Wi-Fi and B41 coexistence mode scenario may be sequentially as follows: the radiator A, the radiator E, the radiator D, the radiator B, the radiator H, the radiator C, and the radiator F.

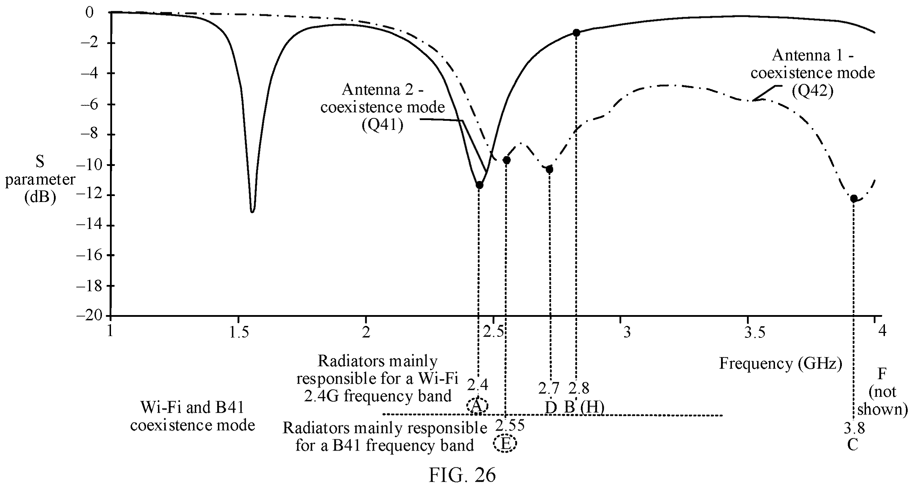

**FIG. 26 is a diagram of a preset frequency adjustment rule 22b.**

FIG. 26 is a line graph of effect of an S parameter for the antenna 1 and the antenna 2 in the Wi-Fi and B41 coexistence mode scenario during simulation effect testing of the electronic device.

FIG. 26 includes two curves: a curve "Antenna 2 - coexistence mode", referred to as a curve Q41; and a curve "Antenna 1 - coexistence mode", referred to as a curve Q42. The curve Q41 shows a frequency magnitude relationship between radiators in the antenna 2 and frequencies corresponding to the radiators in the Wi-Fi and B41 coexistence mode scenario. The curve Q42 shows a frequency magnitude relationship between radiators in the antenna 1 and frequencies corresponding to the radiators in the Wi-Fi and B41 coexistence mode scenario.

In FIG. 26, letters A to F respectively represent the radiator A to the radiator F. It can be learned from FIG. 26 that, in some possible cases, radiators, mainly responsible for the Wi-Fi 2.4G frequency band, in ascending order of frequencies in the Wi-Fi and B41 coexistence mode scenario may be sequentially as follows: the radiator A (approximately 2.4 GHz), the radiator D (approximately 2.7 GHz), the radiator B and the radiator H (approximately 2.8 GHz), and the radiator F. A frequency of the radiator F is not shown in FIG. 26. This may be understood as that the frequency of the radiator F is high and is not shown in FIG. 26. The radiator F and the radiator D may be considered as radiators with the radiator D as a main radiator, and a current direction of the radiator F is the same as a current direction of the radiator D.

Radiators, mainly responsible for the Wi-Fi 2.4G frequency band, in ascending order of frequencies may be sequentially as follows: the radiator E (approximately 2.55 GHz) and the radiator C (approximately 3.8 GHz).

An operating frequency (not shown) of the radiator C may be adjusted to a quite high position (greater than 4G), for example, 5G. In this way, a current of the radiator C can be weakened to reduce adverse impact on the antenna 2 or the antenna 1.

The frequency magnitude relationship between the radiators shown in FIG. 26 satisfies the foregoing descriptions of the preset frequency adjustment rule 22b. In this way, expected current directions of the radiators in the antenna 1 and the antenna 2 can be the target current direction 22. For descriptions of the target current direction 22, refer to the foregoing descriptions of (1) in FIG. 24. Details are not described herein again.

Herein, it should be understood that the antenna 1 and the antenna 2 may share the radiator D in the single-mode Wi-Fi scenario. FIG. 26 shows an example in which the radiator D belongs to the antenna 1. In an actual case, an example in which the radiator D belongs to the antenna 2 may alternatively be used. This is not limited in this embodiment of this application.

**FIG. 27 is a diagram of comparison between a frequency adjustment rule in the Wi-Fi and B41 coexistence mode scenario and a frequency adjustment rule in the low-performance scenario 22.**

FIG. 27 is a line graph of comparison between effect of an S parameter for the antenna 1 and the antenna 2 in the Wi-Fi and D41 coexistence mode scenario and that in the low-performance scenario 22 during simulation effect testing of the electronic device.

FIG. 27 includes four curves: a curve "Antenna 2 - coexistence mode", referred to as a curve Q41; a curve "Antenna 1 - coexistence mode", referred to as a curve Q42; a curve "Antenna 2 - scenario 22", referred to as a curve Q43; and a curve "Antenna 1 - scenario 22", referred to as a curve Q44. The curve Q43 shows a frequency magnitude relationship between radiators in the antenna 2 and frequencies corresponding to the radiators in the low-performance scenario 22. The curve Q44 shows a frequency magnitude relationship between radiators in the antenna 1 and frequencies corresponding to the radiators in the low-performance scenario 11. Related descriptions of the curve Q41 and the curve Q42 are the same as those of the curve Q41, the curve Q42, and related content thereof in FIG. 26. Details are not described herein again.

Herein, it should be understood that the curve Q43 and the curve Q44 shown in FIG. 27 are a case in the low-performance scenario 22. In this case, in the low-performance scenario 22, an operating frequency of the antenna 1 is a mid-high band B41 frequency band (MHB B41 for short).

In FIG. 27, letters A to F respectively represent the radiator A to the radiator F. It can be learned from FIG. 27 that, in the low-performance scenario 22, radiators mainly responsible for the Wi-Fi 2.4G frequency band include the radiator A (primary radiator) and main parasitic radiators of the radiator A, including the radiator B and the radiator H. Radiators mainly responsible for the B41 frequency band include the radiator E (primary radiator) and main parasitic radiators of the radiator E, including the radiator F, the radiator C, and the radiator D.

In the low-performance scenario 22, radiators, mainly responsible for the Wi-Fi 2.4G frequency band, in ascending order of frequencies may be sequentially as follows: the radiator A (approximately 2.4 GHz), and the radiator B and the radiator H (approximately 2.8 GHz).

Radiators, mainly responsible for the Wi-Fi 2.4G frequency band, in ascending order of frequencies may be sequentially as follows: the radiator E (approximately 2.6 GHz), the radiator F (approximately 3.1 GHz), the radiator C (approximately 3.8 GHz), and the radiator D. A frequency of the radiator D is not shown in FIG. 27. This may be understood as that the frequency of the radiator D is high and is not shown in FIG. 27. The radiator D and the radiator F may be considered as radiators with the radiator F as a main radiator, and a current direction of the radiator D is the same as a current direction of the radiator F.

The frequency magnitude relationships between the radiators shown in the curve Q43 and the curve Q44 satisfy the foregoing descriptions of the preset frequency adjustment rule 12b. This may be considered as an example of the frequency adjustment rule 12b. In this way, current directions of the radiators in the antenna 1 and the antenna 2 are a current direction in the foregoing low-performance scenario 22. For the current direction in the low-performance scenario 22, refer to the foregoing descriptions of (2) in FIG. 24. Details are not described herein again.

It can be learned from operating frequencies of radiators determined according to the preset frequency adjustment rule 21b that, compared with the low-performance scenario 22, an operating frequency of at least one radiator in the Wi-Fi and B41 coexistence mode scenario changes. For example, the change includes but is not limited to the following changes.

Radiator frequency change 51: An operating frequency of the radiator D changes from a high frequency to a frequency 2.7, and a frequency of the radiator F changes from 3.1 GHz to a high frequency. The change is indicated by a white circle ① in FIG. 27. The radiator frequency change 51 may cause the radiator D and the radiator F to change from the radiator F being a main radiator to the radiator D being a main radiator. When the radiator F is a main radiator, currents generated by the radiator F and the radiator D are in a same direction as a current of the radiator E (primary radiator), and therefore are in a direction opposite to a direction of a current of the radiator A. When the radiator D is a main radiator, currents generated by the radiator D and the radiator F are in a same direction as a current of the radiator A (primary radiator). For related descriptions of the current direction changes of the radiator D and the radiator F, refer to the foregoing related descriptions of the white circle ① in FIG. 24. Details are not described herein again.

Herein, it should be understood that values of operating frequencies of radiators shown in FIG. 26 and FIG. 27 are examples for description, and may be other values in an actual case. For example, an operating frequency of a same radiator is an operating frequency greater than or less than the operating frequency by 1 GHz. This shall not be construed as a limitation on embodiments of this application.

**The following describes a process in which frequencies of radiators are adjusted by using at least one frequency control circuit according to the preset frequency adjustment rule 22b in the Wi-Fi and B41 coexistence mode scenario, to enable directions of expected currents generated by the radiators to satisfy the target current direction 22. In addition, the adjustment process is compared with an adjustment process in the low-performance scenario.**

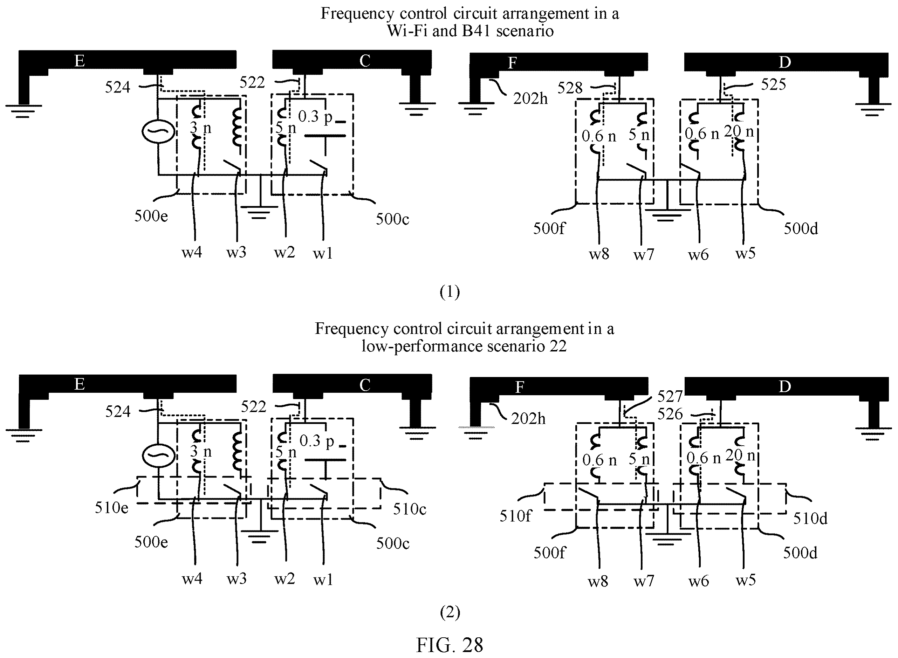

**FIG. 28 is a diagram of a frequency control circuit arrangement in the Wi-Fi and B41 coexistence mode scenario and a frequency control circuit arrangement in the low-performance scenario 22.**

How to obtain, through adjustment, the frequencies of the radiators shown in FIG. 27 is described below based on FIG. 28.

Frequency control circuits are connected to the radiator C, the radiator E, the radiator D, and the radiator F. The arrangement of the frequency control circuits herein is also intended to describe frequency adjustment for the radiator C, the radiator E, the radiator D, and the radiator F.

(1) in FIG. 28 shows the frequency control circuit arrangement in the Wi-Fi and B41 coexistence mode scenario. For the radiator C, the electronic device turns on (ON) a switch unit w2 and turns off (OFF) w1 in a frequency control circuit 500c, to turn on a frequency adjustment branch 521. This is equivalent to that the radiator C is connected to an inductor of approximately 5 n, and a frequency is adjusted to approximately 3.8 GHz. For the radiator E, the electronic device turns on (ON) a switch unit w4 and turns off (OFF) w3 in a frequency control circuit 500e, to turn on a frequency adjustment branch 524. This is equivalent to that the radiator E is connected to an inductor of approximately 3n, and a frequency is adjusted to approximately 2.55 GHz. For the radiator D, the electronic device turns on (ON) a switch unit w5 and turns off (OFF) w6 in a frequency control circuit 500d, to turn on a frequency adjustment branch 525. This is equivalent to that the radiator D is connected to an inductor of approximately 20 n, and a frequency is adjusted to approximately 2.7 GHz. For the radiator F, the electronic device turns on (ON) a switch unit w8 and turns off (OFF) w7 in a frequency control circuit 500f, to turn on a frequency adjustment branch 528. This is equivalent to that the radiator F is connected to an inductor of approximately 0.6 n, and a frequency is adjusted to a high frequency.

(2) in FIG. 28 shows the frequency control circuit arrangement in the low-performance scenario 22. Frequencies of the radiator D and the radiator F remain unchanged compared with frequencies of the radiator D and the radiator F in the Wi-Fi and B41 coexistence mode scenario. A control manner of the frequency control circuit 500c connected to the radiators is the same as that in (1) in FIG. 28. Details are not described herein again. For the radiator D, the electronic device turns on (ON) a switch unit w6 and turns off (OFF) w5 in a frequency control circuit 500d, to turn on a frequency adjustment branch 526. This is equivalent to that the radiator D is connected to an inductor of approximately 0.6 n, and a frequency is adjusted to a high frequency. For the radiator F, the electronic device turns on (ON) a switch unit w7 and turns off (OFF) w8 in a frequency control circuit 500f, to turn on a frequency adjustment branch 527. This is equivalent to that the radiator F is connected to an inductor of approximately 5 n, and a frequency is adjusted to approximately 3.1 GHz.

**The following describes beneficial effect of the Wi-Fi and B41 coexistence mode scenario compared with the low-performance scenario 22.**

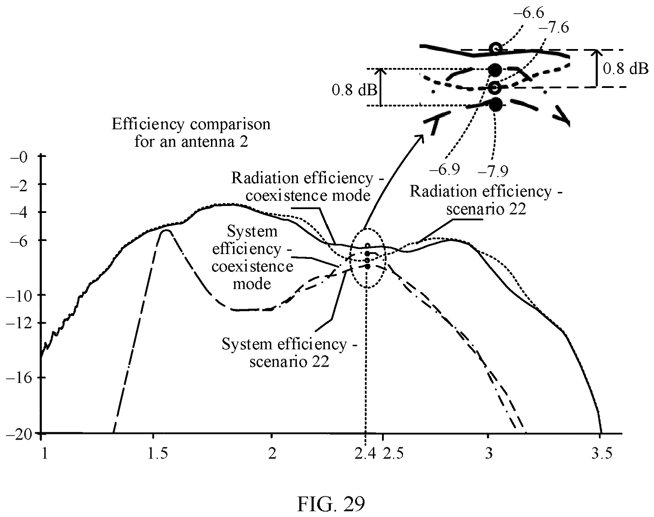

**FIG. 29 is a diagram of comparison between efficiency of the antenna 2 and the antenna 1 in the Wi-Fi and B41 coexistence mode scenario and efficiency of the antenna 2 and the antenna 1 in the low-performance scenario 22 during simulation effect testing of the electronic device.**

As shown in FIG. 29, a horizontal coordinate represents a frequency in a unit of GHz, and a vertical coordinate represents efficiency (radiation efficiency or system efficiency) in a unit of dB.

In FIG. 29, a curve "Radiation efficiency - coexistence mode" and a curve "Radiation efficiency - scenario 22" respectively represent radiation efficiency during operation of the antenna 2 in the coexistence mode scenario and radiation efficiency during operation of the antenna 2 in the low-performance scenario. In this case, an operating frequency of the antenna 2 is 2.4 GHz, the radiation efficiency of the antenna 2 in the coexistence mode scenario is approximately -6.6 dB, and the radiation efficiency of the antenna 2 in the low-performance scenario 22 is approximately -7.6 dB. Therefore, compared with the low-performance scenario 22, in the coexistence mode, the radiation efficiency of the antenna 2 is improved by approximately 1 dB.

In FIG. 29, a curve "System efficiency - coexistence mode" and a curve "System efficiency - scenario 22" respectively represent system efficiency during operation of the antenna 2 in the coexistence mode scenario and system efficiency during operation of the antenna 2 in the low-performance scenario. In this case, an operating frequency of the antenna 2 is 2.4 GHz, the system efficiency of the antenna 2 in the coexistence mode scenario is approximately -7.9 dB, and the system efficiency of the antenna 2 in the low-performance scenario 22 is approximately -6.9 dB. Therefore, compared with the low-performance scenario 22, in the coexistence mode, the system efficiency of the antenna 2 is also improved by 1 dB.

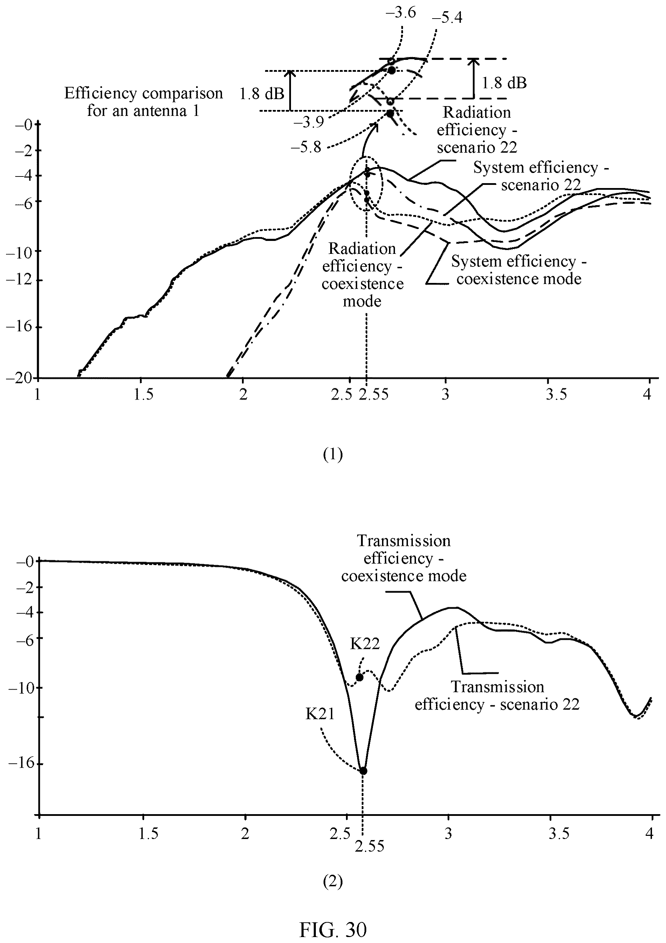

**FIG. 30 is a diagram of comparison between efficiency of the antenna 1 in the Wi-Fi and B41 coexistence mode scenario and efficiency of the antenna 1 in the low-performance scenario 11 during simulation effect testing of the electronic device.**

As shown in (1) in FIG. 30, a horizontal coordinate represents a frequency in a unit of GHz, and a vertical coordinate represents efficiency (radiation efficiency or system efficiency) in a unit of dB. A curve "Radiation efficiency - coexistence mode" and a curve "Radiation efficiency - scenario 22" respectively represent radiation efficiency during operation of the antenna 1 in the coexistence mode scenario and radiation efficiency during operation of the antenna 1 in the low-performance scenario 22. A curve "System efficiency - coexistence mode" and a curve "System efficiency - scenario 22" respectively represent system efficiency during operation of the antenna 1 in the coexistence mode scenario and system efficiency during operation of the antenna 1 in the low-performance scenario. In this case, an operating frequency of the antenna 1 is 2.55 GHz. The radiation efficiency of the antenna 1 is reduced from -3.6 dB in the low-performance scenario to -5.4 dB in the Wi-Fi and B41 coexistence mode, and the system efficiency of the antenna 1 is reduced from -3.9 dB in the low-performance scenario to -5.8 dB in the Wi-Fi and B41 coexistence mode. Therefore, compared with the low-performance scenario 22, in the Wi-Fi and B41 coexistence mode, the radiation efficiency of the antenna 1 is reduced by approximately 1.6 dB.

As shown in (2) in FIG. 30, a horizontal coordinate represents a frequency in a unit of GHz, and a vertical coordinate represents efficiency (transmission efficiency) in a unit of dB. As shown in (2) in FIG. 30, A curve "Transmission efficiency - coexistence mode" and a curve "Transmission efficiency - scenario 22" respectively represent transmission efficiency during operation of the antenna 1 in the coexistence mode scenario and transmission efficiency during operation of the antenna 1 in the low-performance scenario 22. Transmission efficiency indicated by a point K21 is smaller than transmission efficiency indicated by K22. Therefore, the transmission efficiency of the antenna 1 in the coexistence mode is slightly poorer than the transmission efficiency of the antenna 1 in the low-performance scenario 22.

It can be learned from FIG. 29 and FIG. 30 that, although performance of the antenna 1 is degraded, the radiation efficiency and the system efficiency of the antenna 1 in this case are at a position above -6 dB, and the transmission efficiency is below -6 dB. This indicates that, although the performance of the antenna 1 is degraded, the performance is still good. In addition, performance of the antenna 2 is improved. This may be understood as that the performance of the antenna 1 is balanced while the performance of the antenna 2 is improved.

Herein, it should be understood that, in the second antenna structure, when the electronic device is in another mode, operating frequencies of the antenna 1 and the antenna 2 may be adjusted according to the preset frequency adjustment rule 12, to enable the electronic device to communicate with another electronic device. The another mode may be a mode other than the single-mode Wi-Fi and the Wi-Fi and B41 coexistence mode. Details are not described in this embodiment of this application.

It should be understood that, in the second antenna structure, when the electronic device is in another mode, operating frequencies of the antenna 1 and the antenna 2 may be adjusted according to the preset frequency adjustment rule 11, to enable the electronic device to communicate with another electronic device. The another mode may be a mode other than the single-mode Wi-Fi and the Wi-Fi and B41 coexistence mode. Details are not described in this embodiment of this application.

It should be further understood that, in the foregoing related content, the communication mode in which the 2.4G Wi-Fi communication is enabled and the cellular network communication is not enabled is an example of the foregoing communication mode A, and the communication mode in which the 2.4G Wi-Fi communication is enabled and the cellular network communication is performed on the B41 frequency band is another example of the foregoing communication mode A. The antenna 2 (responsible for the Wi-Fi 2.4G frequency band) is an example of the antenna A. In an actual case, the antenna A may alternatively be another antenna responsible for another frequency band. This is not limited in this embodiment of this application.

**A third antenna structure is described below in detail.**

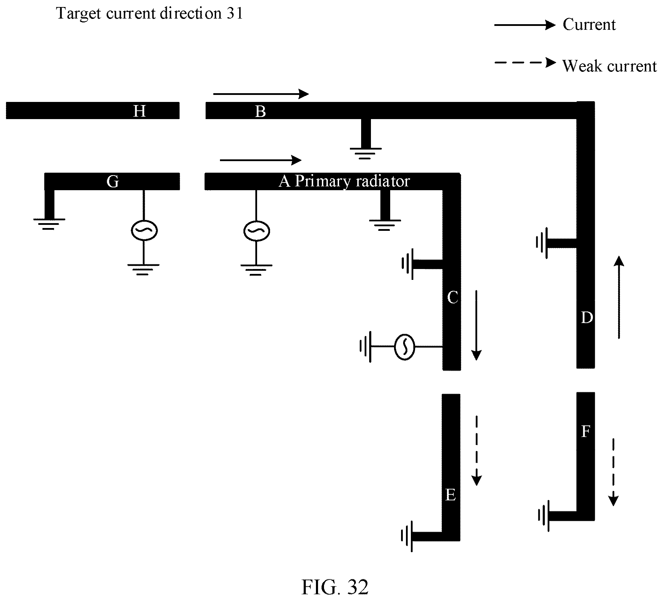

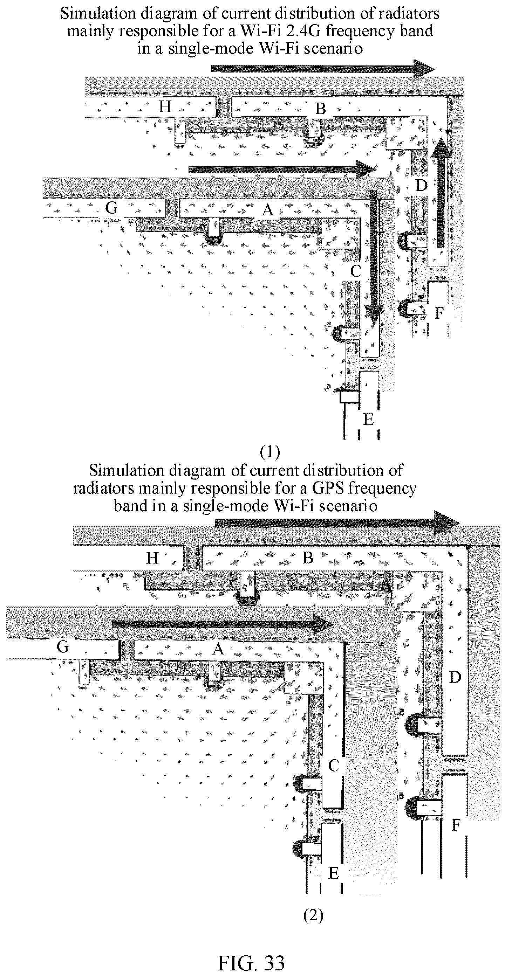

Based on the third antenna structure, when the electronic device is in single-mode Wi-Fi, the electronic device may perform, according to a preset frequency adjustment rule 23a, frequency adjustment on radiators mainly responsible for a Wi-Fi 2.4G frequency band in an antenna 1 and an antenna 2, to use the antenna 1 to assist the antenna 2 in improving performance, to enable the electronic device to achieve a good capability of communicating with another electronic device in a Wi-Fi 2.4G communication mode. In addition, when the electronic device is in the single-mode Wi-Fi, frequency adjustment is performed, according to the preset frequency adjustment rule 23a, on a radiator mainly responsible for a GPS frequency band in the antenna 2. Compared with the foregoing first antenna structure, in the third antenna structure, more radiators may be used to be responsible for the GPS frequency band, to enable the electronic device to achieve a good capability of communicating with another electronic device in a GPS communication mode. For descriptions of the frequency adjustment rule 23a and related content thereof, refer to descriptions of FIG. 32 and FIG. 33 and related content thereof in the following content. Details are not described herein.

Based on the third antenna structure, when the electronic device is in a Wi-Fi and B41 coexistence mode, the electronic device may perform, according to a preset frequency adjustment rule 23b, frequency adjustment on radiators mainly responsible for the Wi-Fi 2.4G frequency band and radiators mainly responsible for a B41 frequency band in the antenna 1 and the antenna 2. A frequency of a radiator D responsible for the B41 frequency band in a low-performance scenario 12 may be adjusted to be responsible for the Wi-Fi 2.4G frequency band. In this way, although performance of the antenna 1 (responsible for the B41 frequency band) is degraded, radiation efficiency and system efficiency of the antenna 1 are still good, and performance of the antenna 2 (responsible for the Wi-Fi 2.4G frequency band) can be improved. That is, the performance of the antenna 1 is balanced while the performance of the antenna 2 is improved. For related content of the low-performance scenario 12, refer to the foregoing related descriptions. Details are not described herein again.

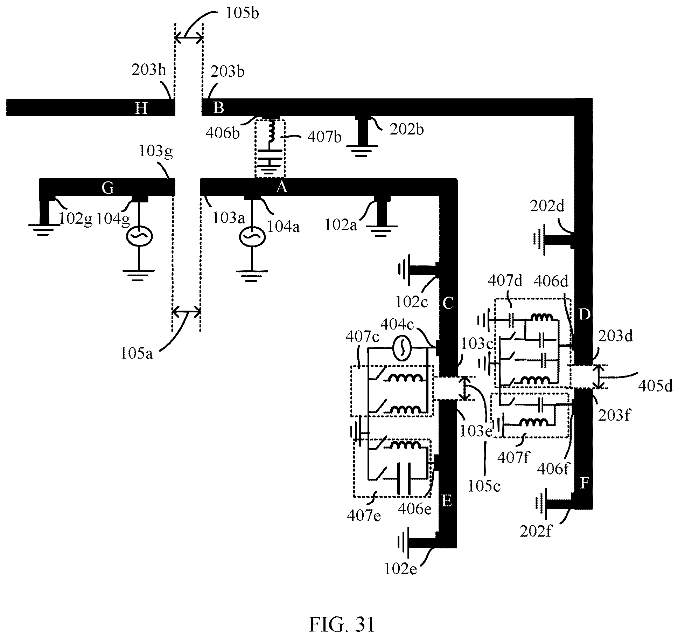

**FIG. 31 is an example diagram of the third antenna structure.**

As shown in FIG. 31, the third antenna structure is similar to the foregoing first antenna structure. Refer to the descriptions of the first antenna structure in FIG. 3 and related content thereof. For example, in FIG. 31, reference signs same as those in FIG. 3 indicate same parts between the first antenna structure and the third antenna structure. The same parts between the two antenna structures are not described herein again; instead, a difference between the two antenna structures is described. The difference between the third antenna structure and the first antenna structure includes: A radiator H does not include a ground terminal. A radiator E does not include a feed point; instead, a feed point (for example, a feed point 404c) is provided on a radiator C. A connection point 406b is provided on a radiator B for connecting to a frequency control circuit.

In the third antenna structure, the feed point 404c of the radiator C is connected to a radio frequency source 4 of the electronic device. The feed point 404c is connected to the first floor in the first device body 100 through a frequency control circuit 407c. A switch device included in the frequency control circuit 407c may be gated to at least one frequency adjustment branch, to adjust a frequency of the radiator C. A connection point 406e of the radiator E is connected to the first floor in the first device body 100 through a frequency control circuit 407e. A switch device included in the frequency control circuit 407e may be gated to at least one frequency adjustment branch, to adjust a frequency of the radiator E. A connection point 406e of the radiator E is connected to the first floor in the first device body 100 through a frequency control circuit 407e. A connection point 406d of the radiator D is connected to the second floor in the second device body 200 through a frequency control circuit 407d. A switch device included in the frequency control circuit 407d may be gated to at least one frequency adjustment branch, to adjust a frequency of the radiator D. A connection point 406f of the radiator F is connected to the second floor in the second device body 200 through a frequency control circuit 407f. A switch device included in the frequency control circuit 407f may be gated to at least one frequency adjustment branch, to adjust a frequency of the radiator F. When the radiator H is not provided with a ground terminal, a length of the radiator H is not limited, and the length of the radiator H may be greater than a length of the radiator B, or may be less than a length of the radiator B.

In some possible cases, the frequency control circuit 407e connected to the connection point 406e is the same as the frequency control circuit 400c connected to the connection point 106c in the first antenna structure. The frequency control circuit 407c connected to the feed point 404c is the same as the frequency control circuit 400e connected to the feed point 104e in the first antenna structure.

In the third antenna structure, because the radiator C has a feed point, the radiator does not belong to the antenna 2, but belongs to the antenna 1. For subordination relationships between other radiators and the antenna 1, the antenna 2, and an antenna 3, refer to the subordination relationships between the radiators and the antenna 1, the antenna 2, and the antenna 3 in the first antenna structure. Details are not described herein again.

In the third antenna structure, an operating frequency band (a frequency range) of the antenna 1 may include one or both of a mid-high band (MHB) frequency band and an N78 frequency band, and feeding in the antenna 1 occurs on the radiator C. An operating frequency band of the antenna 2 includes the GPS frequency band or the Wi-Fi 2.4G frequency band, and feeding in the antenna 2 occurs on a radiator A. In this case, the antenna 2 may be responsible for providing GPS communication and 2.4G Wi-Fi communication for the electronic device, and feeding in the antenna 2 occurs on a radiator G. An operating frequency band of the antenna 3 includes one or more of the N78 frequency band or a Wi-Fi 5G frequency band.

For communication modes provided by the antennas for the electronic device based on operating frequencies, refer to the foregoing descriptions of related content. Details are not described herein again.

**The following describes related content in a single-mode Wi-Fi scenario based on the third antenna structure.**

**Compared with the first antenna structure, in the third antenna structure, when the electronic device is in the single-mode Wi-Fi,** in addition to the foregoing frequency (for example, 2.6 GHz or 2.8 GHz) that is higher than a frequency of the radiator A, a frequency of the radiator B may further include another frequency obtained through adjustment by a frequency control circuit connected to the radiator B, and the another frequency is a frequency close to the GPS frequency band. The foregoing frequency higher than the frequency of the radiator A may be referred to as a frequency 11, and the another frequency close to the GPS frequency band may be referred to as a frequency 12.

In this way, when the electronic device is in the single-mode Wi-Fi, on the radiator B, a current (in a same direction as a current of the radiator A) at the frequency 11 may be distributed to achieve forward parasitic radiation effect on the radiator A whose operating frequency belongs to the Wi-Fi 2.4G frequency band, and a current (in a same direction as the current of the radiator A) at the frequency 12 may also be distributed to achieve forward parasitic radiation effect on the radiator A whose operating frequency belongs to the GPS frequency band.

Based on the third antenna structure in this application, the electronic device may re-adjust, according to a preset frequency adjustment rule 23a, operating frequencies of the antenna 2 and the antenna 1 coupled thereto, to adjust current directions of radiators in the antenna 1 and the antenna 2 to a target current direction (denoted as a target current direction 31). The target current direction 31 is a current direction satisfying the single-mode Wi-Fi when the third antenna structure is used. The radiators in the antenna 1 and the antenna 2 may be responsible for providing the 2.4G Wi-Fi communication mode and the GPS communication mode. In some possible cases, radiators mainly responsible for the Wi-Fi 2.4G frequency band include the radiator A, the radiator B, the radiator C, and the radiator D, and radiators mainly responsible for the GPS frequency band include the radiator A and the radiator B.

In this way, performance of the antenna 2 can be improved, to improve a communication capability of the electronic device during communication with another electronic device in the 2.4G Wi-Fi communication mode and the GPS communication mode.

**FIG. 32 shows a target current direction 31 in the single-mode Wi-Fi scenario.**

The target current direction 31 indicates current directions of radiators mainly responsible for the Wi-Fi 2.4G frequency band when an operating frequency of the radiator A includes the Wi-Fi 2.4G frequency band. The radiator A is a primary radiator, and parasitic radiators include the radiator B, the radiator C, and the radiator D. Based on the foregoing content, the radiator B and the radiator C are first-type radiators, and directions of expected currents generated by the radiators are the same as a direction of a current of the radiator A. The radiator D is a second-type radiator, and a direction of an expected current generated by the radiator D is opposite to the direction of the current of the radiator A.

In some possible cases, when the operating frequency of the radiator A includes the Wi-Fi 2.4G frequency band, parasitic radiators of the radiator A may further include other radiators, for example, the radiator E, the radiator F, and the radiator H. Herein, for the radiator E and the radiator F, frequencies of the radiator E and the radiator F may be adjusted to be high (higher than the frequency of the radiator B), to enable the radiator E and the radiator F to generate weak currents (weaker than a current distributed on the radiator A). Herein, other radiators have small parasitic effect on the radiator A, and are not to be described herein.

Herein, it should be understood that, in addition to the Wi-Fi 2.4G frequency band, the operating frequency of the radiator A further includes the GPS frequency band. Radiators mainly responsible for the GPS frequency band may include the radiator A (primary radiator) and the radiator B (parasitic radiator). In this case, current directions of the radiator A and the radiator B are the same.

**FIG. 33 is a simulation diagram of example current distribution of radiators when the electronic device is in the single-mode Wi-Fi scenario.**

(1) in FIG. 33 is a simulation diagram of example current distribution of radiators mainly responsible for the Wi-Fi 2.4G frequency band when the electronic device is in the single-mode Wi-Fi. Current directions of the radiators correspond to current directions of radiators in the target current direction 31 shown in FIG. 32. A current direction of the radiator D is opposite to a current direction of the radiator A. Current directions of the radiator B and the radiator C are the same as the current direction of the radiator A (primary radiator). Current directions of the radiator E and the radiator F are the same as the current direction of the radiator A. In addition, currents of the radiator E and the radiator F are weaker than a current of the radiator A.

(2) in FIG. 33 is a simulation diagram of example current distribution of radiators mainly responsible for the GPS frequency band when the electronic device is in the single-mode Wi-Fi. It can be learned that current directions of the radiator B and the radiator A (primary radiator) are the same.

**The preset frequency adjustment rule 23a for adjusting the target current direction 31 is further described.**

In some possible cases, the preset frequency adjustment rule 23a is used for adjusting a frequency magnitude relationship between radiators mainly responsible for the Wi-Fi 2.4G frequency band and radiators mainly responsible for the GPS frequency band.

The preset frequency adjustment rule 23a may include: In the third antenna structure, when the electronic device is in the single-mode Wi-Fi, an operating frequency of the radiator A (primary radiator) is adjusted to include a frequency 21 and a frequency 22, where the frequency 21 belongs to the Wi-Fi 2.4G frequency band, and the frequency 22 belongs to the GPS frequency band. An operating frequency of the radiator B is adjusted to include the frequency 11 and the frequency 12, where the frequency 11 is greater than the operating frequency 21, and the frequency 12 is greater than the operating frequency 22. An operating frequency of the radiator C is adjusted to be less than the operating frequency 21. An operating frequency of the radiator D is adjusted to be greater than the operating frequency 21.

Usually, in some possible cases, frequencies of parasitic radiators may alternatively be set to be close to a frequency of a primary radiator, to better achieve forward parasitic radiation effect on the primary radiator.

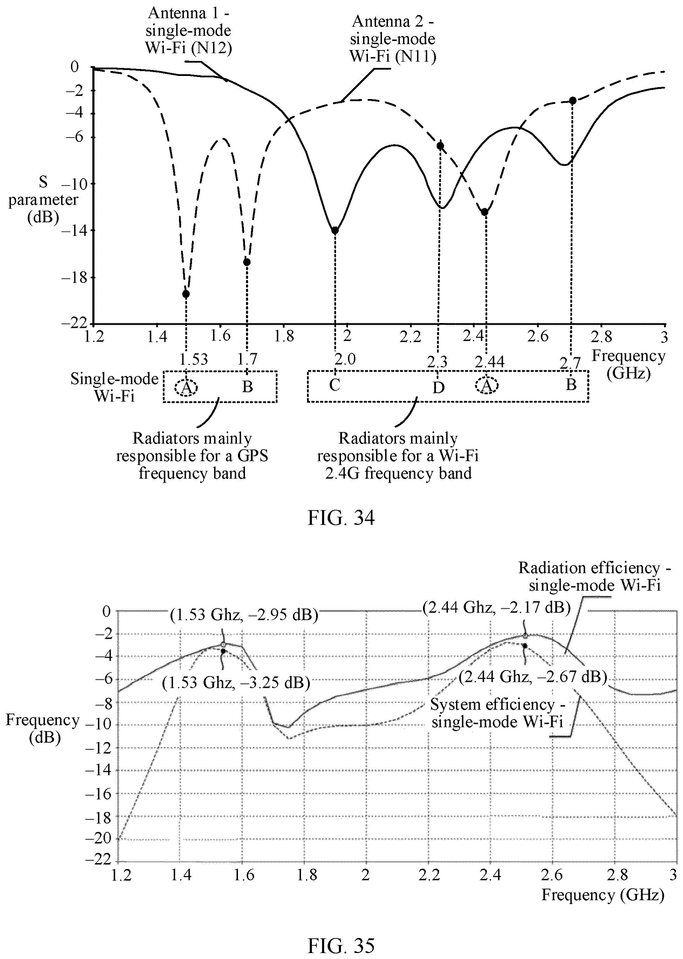

**FIG. 34 is a diagram of a preset frequency adjustment rule 23a.**

FIG. 34 is a line graph of effect of an S parameter for the antenna 1 and the antenna 2 in the single-mode Wi-Fi scenario during simulation effect testing of the electronic device. A horizontal coordinate represents a frequency in a unit of GHz, and a vertical coordinate represents an amplitude value of S11 in a unit of dB.

FIG. 34 includes two curves: a curve "Antenna 2 - single-mode Wi-Fi", referred to as a curve N11; and a curve "Antenna 1 - single-mode Wi-Fi", referred to as a curve N12. The curve N11 shows a frequency magnitude relationship between radiators in the antenna 2 and frequencies corresponding to the radiators in the single-mode Wi-Fi scenario. The curve N12 shows a frequency magnitude relationship between radiators in the antenna 1 and frequencies corresponding to the radiators in the single-mode Wi-Fi scenario.

In FIG. 34, letters A to D respectively represent the radiator A to the radiator D. It can be learned from FIG. 34 that, radiators, mainly responsible for the Wi-Fi 2.4G frequency band, in ascending order of frequencies in the single-mode Wi-Fi scenario may be sequentially as follows: the radiator C (approximately 2.0 GHz), the radiator D (approximately 2.3 GHz), the radiator A (primary radiator, at approximately 2.44 GHz), and the radiator B (approximately 2.7 GHz). The frequency magnitude relationship between the radiators mainly responsible for the Wi-Fi 2.4G frequency band in FIG. 34 can enable expected current directions of the radiators in the antenna 1 and the antenna 2 to be the target current direction 31. This helps improve performance of the antenna 2 on the Wi-Fi 2.4G frequency band. For descriptions of the target current direction 31, refer to the foregoing descriptions of FIG. 32. Details are not described herein again.

It can be further learned from FIG. 34 that, radiators, mainly responsible for the GPS frequency band, in ascending order of frequencies in the single-mode Wi-Fi scenario may be sequentially as follows: the radiator A (primary radiator, at approximately 1.53 GHz) and the radiator B (approximately 1.7 GHz). In this way, when an operating frequency of the radiator A belongs to the GPS frequency band, the radiator B can generate a current in a same direction as a current of the radiator A. This helps improve performance of the antenna 2 on the GPS frequency band.

It should be understood that, as shown in FIG. 34, compared with the radiator C, a reason for adjusting a frequency of the radiator D to be closer to that of the radiator A (primary radiator) herein lies in: Compared with the radiator C, the radiator D is farther away from the radiator A. If the radiator D is expected to provide better forward parasitic radiation effect on the radiator A, the frequency of the radiator D needs to be adjusted to be close to that of the radiator A. Otherwise, a current excited by the radiator D is weak, and has small forward parasitic radiation effect on the radiator A. How to obtain, through adjustment, the frequencies of the radiators shown in FIG. 34 is described below.

The radiator A may generate two operating frequencies through matching: the frequency 21 (which belongs to the Wi-Fi 2.4G frequency band) and the frequency 22 (which belongs to the GPS frequency band). The radiator B is connected to a frequency control circuit 407b (for example, an LC series circuit) or a frequency selection circuit in another form. The radiator B turns off a switch unit in the frequency control circuit 407b or is directly connected to a floor, to produce equivalent capacitance for the GPS frequency band and produce equivalent large capacitance or small inductance for the Wi-Fi 2.4G frequency band, to generate two different frequencies, including the frequency 11 (approximately 2.7 GHz) and the frequency 12 (approximately 1.7 GHz). The radiator C switches a switch unit in the frequency control circuit 407c to adjust a frequency of the radiator C to approximately 2.0 GHz. The radiator D switches a switch unit in the frequency control circuit 407d to adjust a frequency of the radiator D to approximately 2.3 GHz. The radiator E and the radiator F switch, through the frequency control circuit 407e and the frequency control circuit 407f respectively, to switches connected to small inductance, to adjust the radiator E and the radiator F to high frequencies.

In some possible cases, a manner of adjusting the frequency of the radiator C is the same as the manner of adjusting the frequency of the radiator E shown in (1) in FIG. 8, and a manner of adjusting the frequency of the radiator D is the same as the manner of adjusting the frequency of the radiator D shown in (1) in FIG. 8. Refer to the foregoing descriptions of related content. Details are not described herein again.

**Radiation efficiency and system efficiency of the antenna 2 in the single-mode Wi-Fi scenario are described below.**

**FIG. 35 is a diagram of comparison of radiation efficiency and system efficiency of the antenna 2 in the single-mode Wi-Fi scenario during simulation effect testing of the electronic device.**

As shown in FIG. 35, a horizontal coordinate represents a frequency in a unit of GHz, and a vertical coordinate represents efficiency (radiation efficiency or system efficiency) in a unit of dB. The radiation efficiency and the system efficiency being closer to 0 dB indicates higher radiation efficiency and system efficiency of the antenna and better performance of the antenna. A curve "Radiation efficiency - single-mode Wi-Fi" and a curve "System efficiency - single-mode Wi-Fi" respectively represent radiation efficiency and system efficiency during operation of the antenna 2 in the single-mode Wi-Fi scenario.

In the third antenna structure, when an operating frequency of the antenna 2 is 1.53 GHz (a GPS frequency band), radiation efficiency is -2.9 dB, and system efficiency is -3.25 dB. With reference to FIG. 9, in the first antenna structure, when an operating frequency of the antenna 2 is 1.53 GHz, both radiation efficiency and system efficiency are below -4 dB. Therefore, compared with the foregoing frequency adjustment according to the preset frequency adjustment rule 21a in the first antenna structure, during frequency adjustment according to the preset frequency adjustment rule 23a, performance of the antenna 2 on the GPS frequency band in the single-mode Wi-Fi scenario can be improved.

In the third antenna structure, when an operating frequency of the antenna 2 is 2.44 GHz (a Wi-Fi frequency band), radiation efficiency is -2.17 dB, and system efficiency is -2.67 dB. With reference to FIG. 9, in the first antenna structure, when an operating frequency of the antenna 2 is 2.44 GHz (approximately equal to 2.4 GHz), radiation efficiency is -2.8 dB, and system efficiency is -3.3 dB. Therefore, compared with the performance of the first antenna structure in the low-performance scenario 11, during frequency adjustment according to the preset frequency adjustment rule 23a, performance of the antenna 2 on the Wi-Fi 2.4G frequency band in the single-mode Wi-Fi scenario can still be improved.

**The following describes related content in a Wi-Fi and B41 coexistence mode scenario based on the third antenna structure.**

Based on the third antenna structure in this application, when the electronic device is in the Wi-Fi and B41 coexistence mode, the electronic device may re-adjust, according to a preset frequency adjustment rule 23b, operating frequencies of the antenna 2 and the antenna 1 coupled thereto, to adjust current directions of radiators in the antenna 1 and the antenna 2 to a target current direction (denoted as a target current direction 32). The target current direction 32 is a current direction satisfying the Wi-Fi and B41 coexistence mode when the third antenna structure is used. The radiators in the antenna 1 and the antenna 2 may be properly responsible for providing the 2.4G Wi-Fi communication mode and cellular network communication mode (on the B41 frequency band).

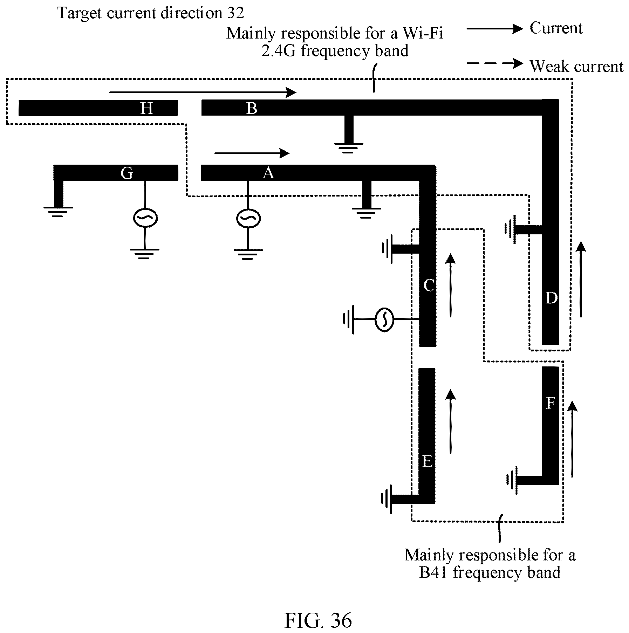

**FIG. 36 shows a target current direction 32 in the Wi-Fi and B41 coexistence mode scenario.**

**As shown in FIG. 36, compared with the first antenna structure, in the third antenna structure, when the electronic device is in the Wi-Fi and B41 coexistence mode,** the radiator C is a primary radiator when the electronic device provides the cellular network communication mode (on the B41 frequency band). In addition to the radiator C, radiators mainly responsible for the B41 frequency band may further include the radiator E and the radiator F. In this case, the electronic device may adjust an operating frequency of the radiator C to the B41 frequency band, for example, to 2.55 GHz. In addition, frequencies of the radiator E and the radiator F are adjusted to be higher than the frequency of the radiator C, so that the radiator E and the radiator F serving as parasitic radiators can excite a current in a same direction as a current of the radiator A.

**As shown in FIG. 36, in the third antenna structure, when the electronic device is in the Wi-Fi and B41 coexistence mode,** the radiator A is a primary radiator when the electronic device provides the 2.4G Wi-Fi communication mode. In addition to the radiator A, radiators mainly responsible for the Wi-Fi 2.4G frequency band may further include the radiator H, the radiator B, and the radiator D. In this case, an operating frequency of the radiator A may be adjusted to the Wi-Fi 2.4G frequency band, for example, to 2.4 GHz. An operating frequency of the radiator D is adjusted to be lower than the frequency of the radiator A, so that the radiator D serving as a parasitic radiator excites a current in a same direction as a current of the radiator A. In addition, a frequency of the radiator B is adjusted to be higher than the frequency of the radiator A, so that the radiator B serving as a parasitic radiator excites a current in a same direction as the current of the radiator A. The radiator H and the radiator B may be considered as one parasitic radiator with the radiator B as a main radiator. In this case, frequencies of the radiator H and the radiator B are the same, and directions of currents excited by the radiator H and the radiator B are also the same.

The frequency of the radiator D may be adjusted through the frequency control circuit 407d connected to the radiator D, to produce equivalent large capacitance for the Wi-Fi 2.4G frequency band, and produce an equivalent short circuit for the B41 frequency band, without taking effect on the B41 frequency band. In this way, the radiator D can assist the radiator A in providing the 2.4G Wi-Fi communication mode, without affecting the radiator C that provides the cellular network communication mode (on the B41 frequency band).

It should be further understood that, in some possible cases, when the radiator A generates resonance on the Wi-Fi 2.4G frequency band, the radiator G and the radiator A may be considered as one parasitic radiator with the radiator A as a main radiator, and therefore the radiator G may also excite a current in a same direction as a current of the radiator A. In this case, resonance generated by the radiator G has forward parasitic radiation effect on the radiator A, so that performance of the antenna 2 can be improved.

In some possible cases, in the third antenna structure, when the electronic device is in the Wi-Fi and B41 coexistence mode, frequency adjustment manners for radiators (the radiator A, the radiator H, the radiator B, and the radiator D) mainly responsible for the Wi-Fi 2.4G frequency band may be the same as the adjustment manners in the first antenna structure. Details are not described herein again.

The following describes in detail frequency adjustment of radiators (the radiator C, the radiator E, and the radiator F) mainly responsible for the B41 frequency band in the third antenna structure.

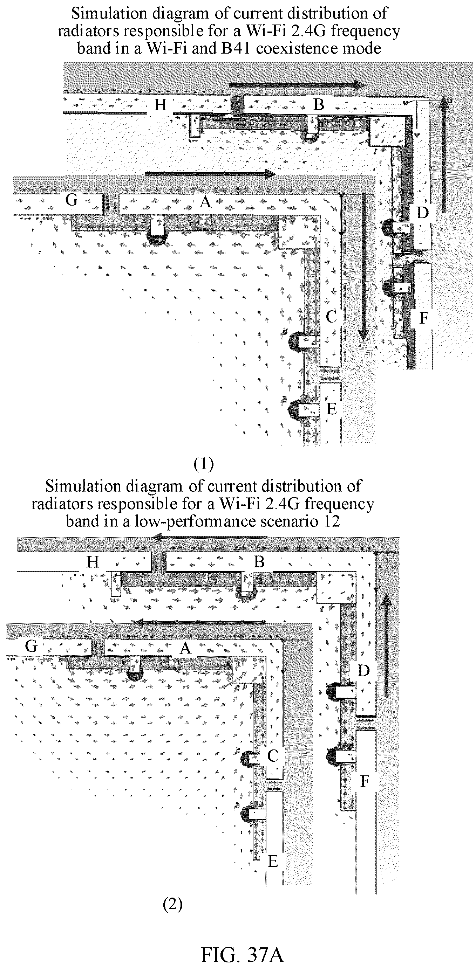

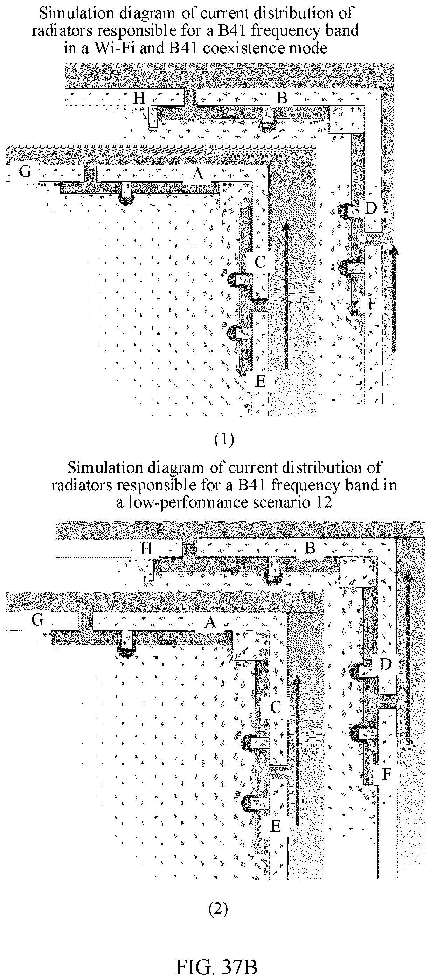

**FIG. 37A and FIG. 37B are simulation diagrams of example current distribution of radiators when the electronic device is in the Wi-Fi and B41 coexistence mode scenario.**

(1) in FIG. 37A is a simulation diagram of example current distribution of radiators mainly responsible for the Wi-Fi 2.4G frequency band when the electronic device is in the Wi-Fi and B41 coexistence mode scenario. Current directions of the radiators correspond to current directions of radiators in the target current direction 32 shown in FIG. 36. In this case, a current direction of the radiator D is opposite to a current direction of the radiator A. Current directions of the radiator B and the radiator C are the same as the current direction of the radiator A.

(2) in FIG. 37A is a simulation diagram of current distribution of radiators mainly responsible for the Wi-Fi 2.4G frequency band when the electronic device is in the low-performance scenario 12. In this case, current directions of the radiator D and the radiator F are the same as a current direction of the radiator A, causing degradation of performance of the antenna 2 (including the radiator A).

(1) in FIG. 37B is a simulation diagram of example current distribution of radiators mainly responsible for the B41 frequency band when the electronic device is in the Wi-Fi and B41 coexistence mode scenario. Current directions of the radiators correspond to current directions of radiators in the target current direction 32 shown in FIG. 36. In this case, the radiator E and the radiator F mainly serve as parasitic radiators of the radiator C (primary radiator), and current directions of the radiator E and the radiator F are the same as a current direction of the radiator C.

(2) in FIG. 37B is a simulation diagram of current distribution of radiators mainly responsible for the B41 frequency band when the electronic device is in the low-performance scenario 12. In this case, the radiator E and the radiator D mainly serve as parasitic radiators of the radiator C (primary radiator).

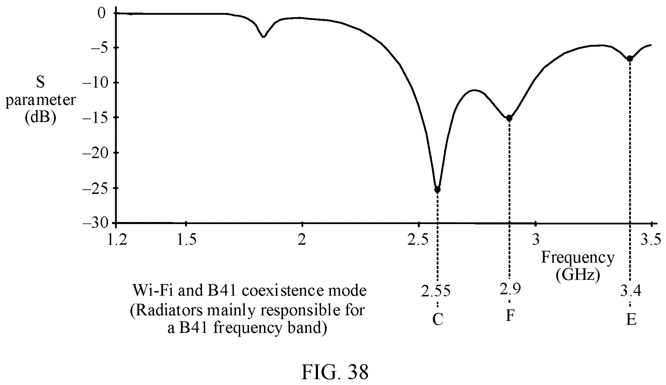

**FIG. 38 is a diagram of frequencies of radiators mainly responsible for the B41 frequency band.**

FIG. 38 is a line graph of effect of an S parameter for the antenna 1 in the Wi-Fi and B41 coexistence mode scenario during simulation effect testing of the electronic device. As shown in FIG. 38, a horizontal coordinate represents a frequency in a unit of GHz, and a vertical coordinate represents an amplitude value of S11 in a unit of dB.

In FIG. 38, letters C, E, and F respectively represent the radiator C, the radiator E, and the radiator F. It can be learned from FIG. 38 that, in some possible cases, in the Wi-Fi and B41 coexistence mode scenario, a frequency of the radiator C (primary radiator) among the radiators mainly responsible for the B41 frequency band may be set to 2.55 GHz, which belongs to the B41 frequency band. A frequency of the radiator E is 2.9 GHz, and a frequency of the radiator E is 3.4 GHz, both of which are higher than the frequency band of the radiator C. In this way, currents distributed on the radiator E and the radiator F are in a same direction as a current distributed on the radiator C.

As shown in FIG. 38, compared with the radiator E, a reason for adjusting a frequency of the radiator F to be closer to that of the radiator C herein lies in: Compared with the radiator E, the radiator F is farther away from the radiator C. If the radiator F is expected to provide better forward parasitic radiation effect on the radiator C, the frequency of the radiator F needs to be adjusted to be close to that of the radiator C. Otherwise, a current excited by the radiator F is weak, and has small forward parasitic radiation effect on the radiator C.

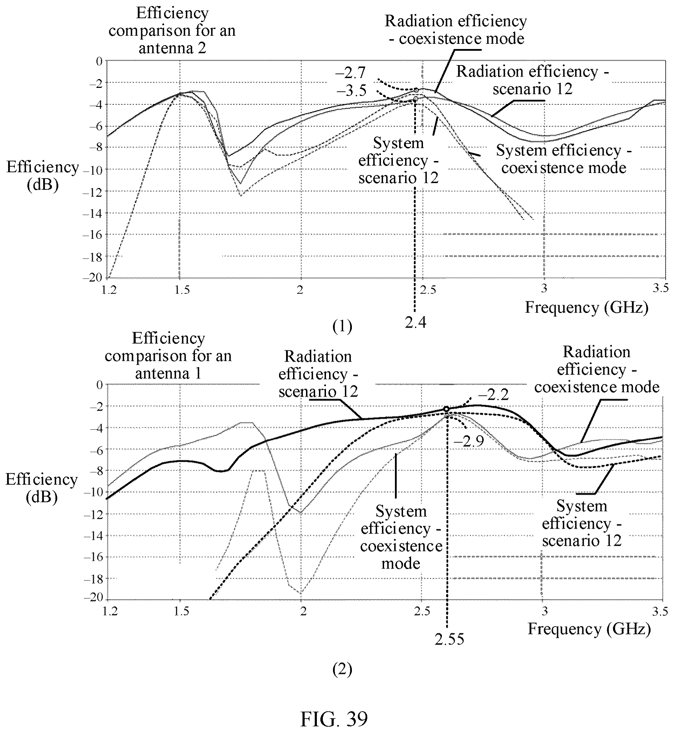

**FIG. 39 is a diagram of comparison between efficiency in the Wi-Fi and B41 coexistence mode scenario and efficiency in the low-performance scenario 12 during simulation effect testing of the electronic device.**

(1) in FIG. 39 is a diagram of comparison between efficiency of the antenna 2 in the Wi-Fi and B41 coexistence mode scenario and efficiency of the antenna 2 in the low-performance scenario 12 during simulation effect testing. A curve "Radiation efficiency - coexistence mode" and a curve "Radiation efficiency - scenario 12" respectively represent radiation efficiency during operation of the antenna 2 in the Wi-Fi and B41 coexistence mode scenario and radiation efficiency during operation of the antenna 2 in the low-performance scenario 12 when an operating frequency of the antenna 2 is 2.4 GHz (which belongs to the Wi-Fi 2.4G frequency band). In this case, the radiation efficiency of the antenna 2 in the Wi-Fi and B41 coexistence mode scenario is approximately -2.7 dB, and the radiation efficiency of the antenna 2 in the low-performance scenario 12 is approximately -3.5 dB. Therefore, compared with the low-performance scenario 12, in the coexistence mode, the radiation efficiency of the antenna 2 is improved by approximately 0.8 dB.

In (1) in FIG. 39, a curve "System efficiency - coexistence mode" and a curve "System efficiency - scenario 12" respectively represent system efficiency during operation of the antenna 2 in the Wi-Fi and B41 coexistence mode scenario and system efficiency during operation of the antenna 2 in the low-performance scenario 12. It can be learned that, compared with the low-performance scenario 12, the system efficiency in the Wi-Fi and B41 coexistence mode scenario is improved.

(2) in FIG. 39 is a diagram of comparison between efficiency of the antenna 1 in the Wi-Fi and B41 coexistence mode scenario and efficiency of the antenna 1 in the low-performance scenario 12 during simulation effect testing. A curve "Radiation efficiency - coexistence mode" and a curve "Radiation efficiency - scenario 12" respectively represent radiation efficiency during operation of the antenna 1 in the Wi-Fi and B41 coexistence mode scenario and radiation efficiency during operation of the antenna 1 in the low-performance scenario 12 when an operating frequency of the antenna 1 is 2.55 GHz (which belongs to the B41 frequency band). In this case, the radiation efficiency of the antenna 1 in the Wi-Fi and B41 coexistence mode scenario is approximately -2.9 dB, and the radiation efficiency of the antenna 1 in the low-performance scenario 12 is approximately -2.2 dB. Therefore, compared with the low-performance scenario 12, in the coexistence mode, the radiation efficiency of the antenna 1 is reduced by approximately 0.7 dB, but is still close to 0 dB. This indicates that the radiation efficiency of the antenna 2 in this case is still good.

In (2) in FIG. 39, a curve "System efficiency - coexistence mode" and a curve "System efficiency - scenario 12" respectively represent system efficiency during operation of the antenna 1 in the Wi-Fi and B41 coexistence mode scenario and system efficiency during operation of the antenna 1 in the low-performance scenario 12. It can be learned that, compared with the low-performance scenario 12, the system efficiency in the Wi-Fi and B41 coexistence mode scenario is reduced, but is still close to 0 dB. This indicates that the system efficiency of the antenna 1 in this case is still good.

Herein, it should be understood that, in addition to the foregoing three antenna structures, other antenna structures may be further obtained based on the fixed structures in this application. A frequency adjustment rule in the single-mode Wi-Fi and a frequency adjustment rule in the Wi-Fi and B41 coexistence mode may be similar or the same, and may be directly obtained or deduced based on the foregoing content. Details are not described herein in this embodiment of this application. The frequency control circuits shown in the antenna structures are examples for description. During actual application, the frequency control circuits may alternatively be adjusted. This shall not be construed as a limitation on embodiments of this application.

It should be further understood that the foregoing communication mode A may further include other communication modes in addition to the communication modes in the single-mode Wi-Fi and the Wi-Fi and B41 coexistence mode. For example, herein, the 2.4G Wi-Fi communication mode is not enabled, but a cellular network communication mode (on an MHB frequency band) is enabled.

In the following content, a state in which the 2.4G Wi-Fi communication mode is not enabled for the electronic device but the cellular network communication mode (on the MHB frequency band) is enabled may be referred to as single-mode MHB.

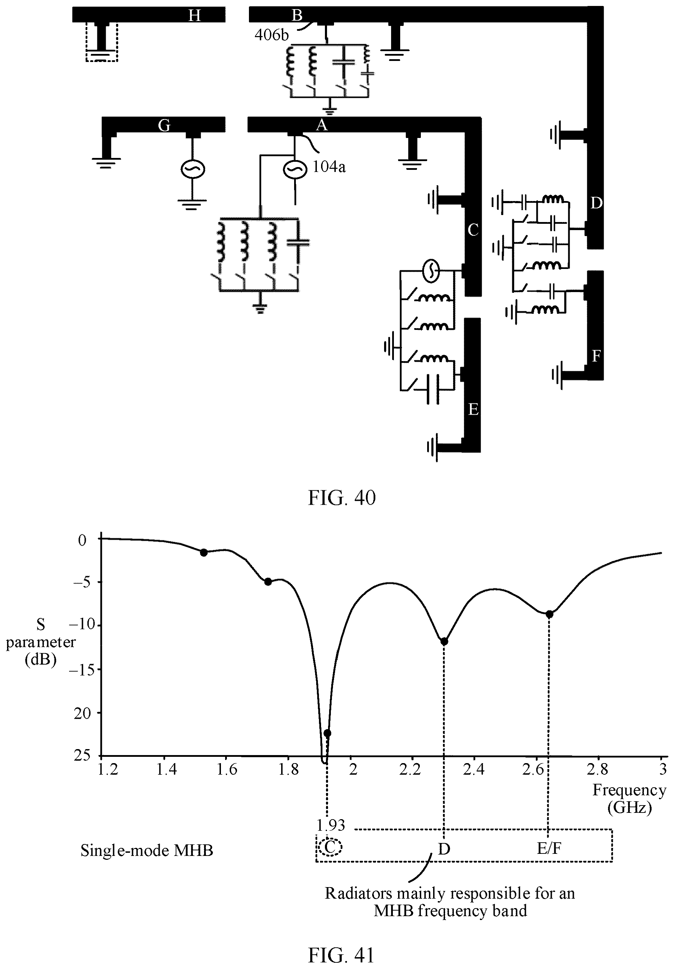

**FIG. 40 shows an example antenna structure in a single-mode MHB scenario.**

As shown in FIG. 40, the antenna structure in the single-mode MHB scenario is similar to the foregoing third antenna structure. A difference lies in that a frequency control circuit connected to a connection point 406b of a radiator B includes a plurality of frequency adjustment branches. A feed point 104a of a radiator A is connected to a frequency control circuit and then grounded through a switch unit. A radiator H may include a ground terminal, or may not include the ground terminal.

Compared with the frequency control circuit 407b connected to the radiator B in FIG. 31, the frequency control circuit connected to the radiator B in FIG. 40 includes more frequency adjustment branches, so that the radiator B can have more frequency bands through adjustment. The frequency control circuit connected to the radiator A includes a plurality of frequency adjustment branches, so that the radiator A can have a plurality of different frequency bands through adjustment.

**FIG. 41 shows an example frequency adjustment rule in the single-mode MHB scenario.**

In FIG. 41, letters A to F respectively represent the radiator A to a radiator F.

As shown in FIG. 41, radiators, mainly responsible for the MHB frequency band, in ascending order of frequencies in the single-mode MHB scenario may be sequentially as follows: a radiator C (primary radiator), a radiator D, a radiator E, and the radiator F. An operating frequency of the radiator C belongs to the MHB frequency band. Frequencies of all parasitic radiators (the radiator D, the radiator E, and the radiator F) of the radiator C are higher than the frequency of the radiator C, so that currents excited by the parasitic radiators are in a same direction as a current of the radiator C. In this way, the parasitic radiators can have forward parasitic radiation effect on the radiator C, so that the electronic device has a good communication capability when communicating with another electronic device in the cellular network communication mode (on the MHB frequency band). In addition, the radiator A switches capacitance through a switch to generate a frequency lower than an MHB frequency (which belongs to the MHB frequency band), and the radiator B switches capacitance through a stub to generate a frequency lower than the MHB frequency and higher than a frequency of the radiator A, to jointly improve performance of an antenna 3 in the single-mode MHB scenario.

Herein, it should be understood that frequencies of radiators in this embodiment of this application may also be understood as resonance frequencies. A frequency of a parasitic radiator may also be understood as a parasitic resonance frequency.

It should be understood that all of the frequency control circuits in the foregoing content are LC series circuits, and may alternatively be frequency selection circuits in other forms in an actual case. This is not limited in this embodiment of this application.

It should be further understood that, in the foregoing related content, for the radiator B and the radiator H, lengths of the radiators are controlled to control frequencies to be frequencies meeting a requirement. In an actual case, as shown in FIG. 42, a frequency control circuit may alternatively be added between the radiator B or the radiator H to separately adjust frequencies of the radiator B and the radiator H.

According to a frequency adjustment rule in this application, when the electronic device is in the folded state, performance of the antenna A (for example, the antenna 2) can be improved. In addition to radiation efficiency and system efficiency of the antenna, the performance may further include other content. For example, a body SAR value of the antenna may alternatively be reduced, and transmit power of the antenna may be increased, to improve performance of the antenna in a free space scenario or a handheld scenario when the electronic device is in the folded state. An SAR (specific absorption rate, English full name: "specific absorption rate") is electromagnetic power absorbed by human tissue per unit mass, and is measured in a unit of W/kg. Internationally, an SAR value is usually used to measure thermal effect of radiation of a foldable-screen electronic device. The body SAR value represents an average specific absorption rate of a body when the antenna approaches the body. For example, an example in which the antenna is of the foregoing second antenna structure is used for description. When the electronic device is in the single-mode Wi-Fi scenario, an SAR of a front surface (front surface) of the electronic device may decrease from 1.4 to 0.78 compared with an SAR in a case (an operating frequency of the antenna 1 is the mid-high band B3 frequency band) of the low-performance scenario 11. An SAR of a top surface (top surface) of the electronic device may decrease from 1.78 to 1.29 compared with an SAR in a case (an operating frequency of the antenna 1 is the mid-high band B3 frequency band) of the low-performance scenario 11. It should be understood that, in the foregoing descriptions of the SAR, an example in which body 5mm 10g is normalized to -6 dB is used for description.

In the foregoing related content, a frequency of the radiator A may be adjusted through matching. In addition to the Wi-Fi 2.4G frequency band, the frequency of the radiator A may further include another frequency band. For example, as shown in FIG. 6, FIG. 12, FIG. 20, and FIG. 26, the radiator A further has a frequency between 1.55 GHz and 1.65 GHz. The frequency belongs to a GPS frequency band, and may provide a GPS communication mode for the electronic device.

The foregoing radiator G may provide 5G communication and 5G Wi-Fi communication for the electronic device. Herein, the radiator G does not participate in improvement of performance of the antenna 2. If a 5G communication mode or a 5G Wi-Fi communication mode is not enabled for the electronic device, performance of the antenna 2 may alternatively be improved by using the radiator G.

**The following describes a phenomenon: Currents generated on a larger quantity of parasitic radiators meeting a condition 1 being in a same direction as a current generated on a primary radiator indicates a larger improvement of performance of a target antenna (including the primary radiator).**

As shown in (1) in FIG. 43, the radiator A is a primary radiator, and the radiator C and the radiator D are parasitic radiators. When currents excited by the parasitic radiators are in a same direction as a current of the radiator A and the radiators are arranged in a linear shape, a floor eigenmode of a floor is shown in (2) in FIG. 43, indicating that the floor eigenmode is well excited.

Currents of a larger quantity of radiators, among the parasitic radiators meeting the condition 1, being in a same direction as a current of the radiator A (primary radiator) indicates a larger magnetic vector potential of the radiator A and higher efficiency (for example, radiation efficiency) of a target antenna (including the radiator A). For a relationship between a magnetic vector potential and currents in a same direction, refer to the following formula (1) and formula (2).

$$\vec{W} = \frac{1}{2}\left[\frac{1}{\mu}\nabla\vec{A} \times (\nabla\emptyset_c - \mathrm{jw}\vec{A})\right] \qquad \text{Formula (1)}$$

$$\vec{A} = \frac{\mu}{4\pi}\iiint_V \vec{J}e^{-j\omega R}/RdV \qquad \text{Formula (2)}$$

In the formula (1), $\vec{W}$ represents a magnetic vector potential of the radiator A, and $\vec{A}\backslash$ represents a sum of currents of parasitic radiators of the radiator A. A larger sum of currents indicates a larger value of $\vec{W}$. The formula (2) indicates that, a larger quantity of radiators whose currents are in a same direction as the current of the radiator A (primary radiator) indicates a larger value of $\vec{A}$. It can be learned from the formula (1) and the formula (2) that, a larger quantity of radiators whose currents are in a same direction as the current of the radiator A (primary radiator) indicates a larger magnetic vector potential of the radiator A.

For a relationship between efficiency and a magnetic vector potential of the radiator A, refer to the following formula (3).

$$P = \int_0^{2\pi}\int_0^\pi \vec{W}r^2 \sin\theta \, d\theta d\emptyset \qquad \text{Formula (3)}$$

In the formula (3), P represents efficiency of the radiator A. It can be learned from the formula (3) that, a larger magnetic vector potential of the radiator A indicates higher efficiency (for example, radiation efficiency) of the target antenna (including the radiator A).

It can be known from the formula (1) to the formula (3) that, a larger quantity of radiators, among the parasitic radiators meeting the condition 1, whose currents are in a same direction as the current of the radiator A (primary radiator) indicates higher efficiency (for example, radiation efficiency) of the radiator A.

**The following describes a phenomenon: Currents generated on a larger quantity of parasitic radiators meeting a condition 2 being in a direction opposite to a direction of a current generated on a primary radiator indicates a larger improvement of performance of a target antenna (including the primary radiator).**

As shown in FIG. 44, when a current direction of the radiator D is opposite to a current direction of the radiator A, an equivalent current ($\vec{J}$) and an equivalent magnetic current ($\vec{M}$) of a target antenna (including the radiator A) are orthogonal to each other. This is similar to a magneto-electric dipole, and two types of radiation are complementary to each other, so that the target antenna has high radiation efficiency.

Herein, it should be understood that the foregoing first antenna stub includes all radiators disposed in the first device body 100, and the second antenna stub includes all radiators disposed in the second device body 200.

In some possible cases, the first antenna stub includes at least the foregoing radiator A and radiator C, and the second antenna stub includes at least the foregoing radiator B and radiator D. When the electronic device is in the folded state, a projection of the first antenna stub on the second device body 200 overlaps the second antenna stub. For descriptions of the radiators, refer to the foregoing descriptions of the radiator A to the radiator D. Details are not described herein again.

In this case, when the electronic device is in the single-mode Wi-Fi, frequencies of the radiator A to the radiator D may still be adjusted according to a frequency adjustment rule, to enable current directions of the radiator A and the radiator D to be an expected current direction, to improve performance of the antenna.

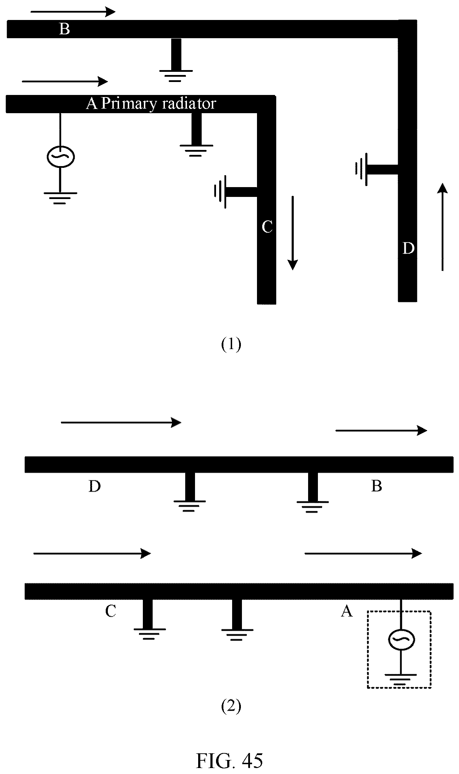

**FIG. 45 is a diagram of current distribution of the radiator A to the radiator D when the electronic device is in the single-mode Wi-Fi in this case.**

(1) in FIG. 45 is a diagram of current distribution of the radiator A to the radiator D when the electronic device is in the single-mode Wi-Fi, the first antenna stub is specifically distributed along an L-shaped bezel (to be specific, a bezel at a corner) of the first device body 100, and the second antenna stub is specifically distributed along an L-shaped bezel of the second device body 200. A current A is distributed on the radiator A, and a current in a same direction as the current A is distributed on each of the radiator B and the radiator C. A current in a direction opposite to a direction of the current A is distributed on the radiator D. In this case, for a manner of adjusting frequencies of the radiator A to the radiator D, refer to the foregoing descriptions of adjusting the frequencies of the radiator A to the radiator D in FIG. 5A and related content thereof. Details are not described herein again.

(2) in FIG. 45 is a diagram of current distribution of the radiator A to the radiator D when the electronic device is in the single-mode Wi-Fi, the first antenna stub is specifically distributed along a linear bezel of the first device body 100, and the second antenna stub is specifically distributed along a linear bezel of the second device body 200. A current A is distributed on the radiator A, and a current in a same direction as the current A is distributed on each of the radiator B, the radiator C, and the radiator D. In this case, for a manner of adjusting frequencies of the radiator A to the radiator D, refer to the foregoing descriptions of adjusting the frequencies of the radiator A to the radiator D in FIG. 19A and related content thereof. Details are not described herein again.

It should be understood that other radiators may be further added to the first antenna stub and the second antenna stub to further improve performance of the antenna.

For example, in another possible case, the first antenna stub may further include a radiator E in addition to the foregoing radiator A and radiator C, and the second antenna stub may further include a radiator F in addition to the foregoing radiator B and radiator D. For descriptions of the radiators, refer to the foregoing descriptions of the radiator A to the radiator F. Details are not described herein again.

In this case, when the electronic device is in the single-mode Wi-Fi, frequencies of the radiator A to the radiator D may still be adjusted according to a frequency adjustment rule, to enable current directions of the radiator A and the radiator D to be an expected current direction, to improve performance of the antenna.

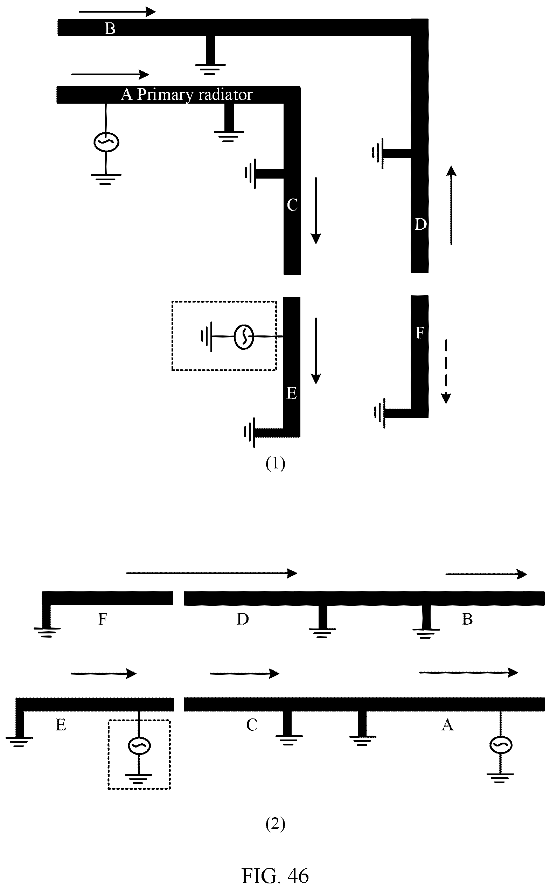

**FIG. 46 is a diagram of current distribution of the radiator A to the radiator D when the electronic device is in the single-mode Wi-Fi in this case.**

(1) in FIG. 46 is a diagram of current distribution of the radiator A to the radiator D when the electronic device is in the single-mode Wi-Fi, the first antenna stub is specifically distributed along an L-shaped bezel (to be specific, a bezel at a corner) of the first device body 100, and the second antenna stub is specifically distributed along an L-shaped bezel of the second device body 200.

(2) in FIG. 46 is a diagram of current distribution of the radiator A to the radiator D when the electronic device is in the single-mode Wi-Fi, the first antenna stub is specifically distributed along a linear bezel of the first device body 100, and the second antenna stub is specifically distributed along a linear bezel of the second device body 200.

As shown in (1) in FIG. 46 and (2) in FIG. 46, a current in a same direction as a current of the radiator A is distributed on each of the radiator E and the radiator F. For current distribution of the radiator A to the radiator D, refer to the foregoing descriptions of FIG. 45. For frequency adjustment of the radiator A to the radiator D, refer to the foregoing descriptions of related content. Details are not described herein again.

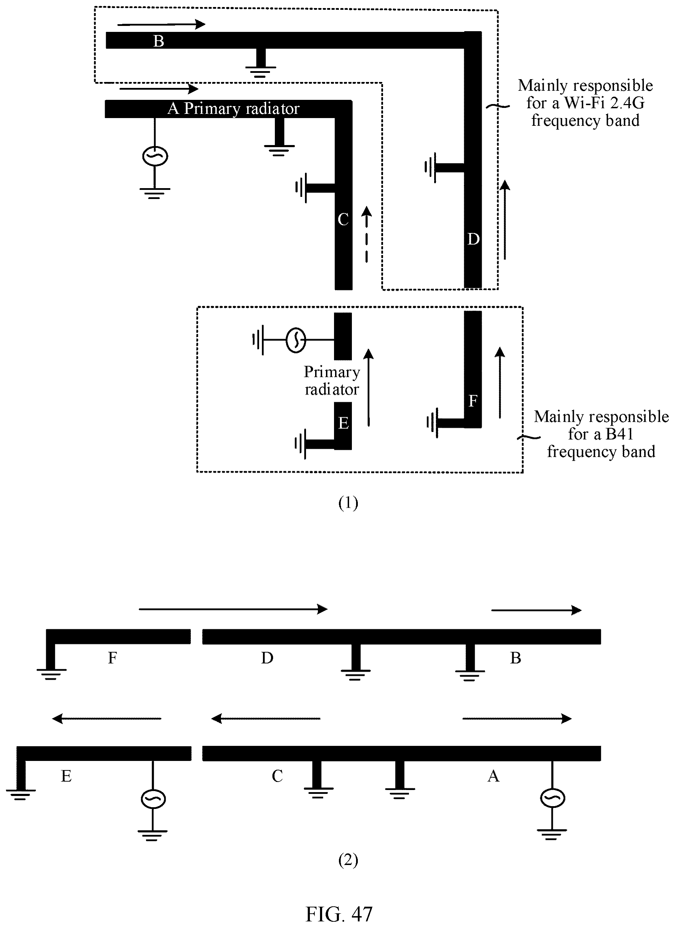

In some possible cases, one feed point may be provided on the radiator A, and another radiator may be provided on the radiator E. FIG. 47 is a diagram of current distribution of the radiator A to the radiator F when the electronic device is in the Wi-Fi and B41 coexistence mode in this case.

(1) in FIG. 47 is a diagram of current distribution of the radiator A to the radiator F when the electronic device is in the Wi-Fi and B41 coexistence mode, the first antenna stub is specifically distributed along an L-shaped bezel (to be specific, a bezel at a corner) of the first device body 100, and the second antenna stub is specifically distributed along an L-shaped bezel of the second device body 200. In this case, the L-shaped bezel specifically includes a horizontal bezel and a vertical bezel, the radiator E is specifically disposed at the vertical bezel, and the radiator A is specifically disposed at the horizontal bezel. The horizontal bezel is perpendicular to the vertical bezel.

The radiator A, the radiator B, and the radiator D are radiators mainly responsible for the Wi-Fi 2.4G frequency band. The radiator E and the radiator F are radiators mainly responsible for the B41 frequency band. A current B is distributed on the radiator A, a current in a same direction as the current B is distributed on the radiator B, and a current in a direction opposite to a direction of the current B is distributed on the radiator D. A current C is distributed on the radiator E, and a current in a same direction as the current C is distributed on the radiator F. In this case, for a manner of adjusting frequencies of the radiator A to the radiator F, refer to the foregoing descriptions of adjusting the frequencies of the radiator A to the radiator F in FIG. 10 and related content thereof. Details are not described herein again.

In some possible implementations, a current of the radiator C is weak. For example, a current distributed on the radiator C is weaker than the current distributed on the radiator A and the current distributed on the radiator E, to avoid adverse impact on the radiator A or the radiator E.

(2) in FIG. 47 is a diagram of current distribution of the radiator A to the radiator F when the electronic device is in the Wi-Fi and B41 coexistence mode, the first antenna stub is specifically distributed along a linear bezel of the first device body 100, and the second antenna stub is specifically distributed along a linear bezel of the second device body 200.

The radiator A, the radiator B, the radiator D, and the radiator F are radiators mainly responsible for the Wi-Fi 2.4G frequency band. The radiator E and the radiator C are radiators mainly responsible for the B41 frequency band. A current B is distributed on the radiator A, and a current in a same direction as the current B is distributed on each of the radiator B, the radiator C, the radiator D, and the radiator F. A current C is distributed on the radiator E, and a current in a same direction as the current C is distributed on the radiator C. In this case, for a manner of adjusting frequencies of the radiator A to the radiator F, refer to the foregoing descriptions of adjusting the frequencies of the radiator A to the radiator F in FIG. 24 and related content thereof. Details are not described herein again.

Herein, it should be understood that the horizontal bezel may be understood as the foregoing bezel 1, and the vertical bezel may be understood as the foregoing bezel 2. "Horizontal" and "vertical" do not describe a position relationship with a horizontal plane, but indicate that the two bezels are different.

Herein, it should be understood that, in some possible cases, in the single-mode Wi-Fi scenario, an excitation source connected to the feed point on the radiator A transmits an excitation signal. Another radiator (for example, the radiator E) may not include a feed point, or may include a feed point. An excitation source connected to the feed point on the another radiator may transmit an excitation signal, or may not transmit an excitation signal. This is not limited in this embodiment of this application. For example, the another feed point may be provided on the radiator E, or may be provided on another radiator. For example, when the another feed point is provided on the radiator E, an excitation source connected to the feed point on the radiator E may transmit an excitation signal, or may not transmit an excitation signal.

In some possible cases, in the Wi-Fi and B41 coexistence mode scenario, both the excitation source connected to the feed point on the radiator A and the excitation source connected to the feed point on the radiator E may transmit excitation signals.

To sum up, in embodiments of this application, in the single-mode Wi-Fi scenario and the Wi-Fi and B41 coexistence mode scenario, whether an excitation source connected to each feed point transmits an excitation signal is not emphasized. This shall not be construed as a limitation on embodiments of this application.

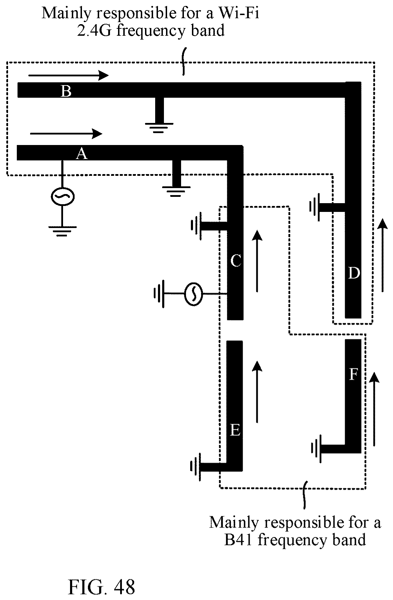

In some possible cases, one feed point may be provided on the radiator A, and another radiator may be provided on the radiator C. FIG. 48 is a diagram of current distribution of the radiator A to the radiator F when the electronic device is in the Wi-Fi and B41 coexistence mode in this case.

FIG. 48 is a diagram of current distribution of the radiator A to the radiator F when the electronic device is in the Wi-Fi and B41 coexistence mode, the first antenna stub is specifically distributed along an L-shaped bezel (to be specific, a bezel at a corner) of the first device body 100, and the second antenna stub is specifically distributed along an L-shaped bezel of the second device body 200. The radiator A, the radiator B, and the radiator D are radiators mainly responsible for the Wi-Fi 2.4G frequency band. The radiator E, the radiator C, and the radiator F are radiators mainly responsible for the B41 frequency band. A current D is distributed on the radiator A, a current in a same direction as the current D is distributed on the radiator B, and a current in a direction opposite to a direction of the current D is distributed on the radiator D. A current E is distributed on the radiator C, and a current in a same direction as the current E is distributed on each of the radiator E and the radiator F. In this case, for a manner of adjusting frequencies of the radiator A to the radiator F, refer to the foregoing descriptions of adjusting the frequencies of the radiator A to the radiator F in FIG. 36 and related content thereof. Details are not described herein again.

As described above, based on the context, the term "when..." used in the foregoing embodiments may be interpreted as "if...", "after...", "in response to determining...", or "in response to detecting...". Similarly, based on the context, the phrase "when it is determined that..." or "if a (stated condition or event) is detected" may be interpreted as "if it is determined that...", "in response to determining that...", "when a (stated condition or event) is detected", or "in response to detecting a (stated condition or event)".

The foregoing embodiments are merely intended to describe the technical solutions of this application, but not to limit this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

**Claims**

1. A foldable-screen electronic device, wherein the foldable-screen electronic device comprises a first device body and a second device body, the first device body and the second device body are connected through a hinge, a first antenna stub is disposed along a bezel of the first device body, and a second antenna stub is disposed along a bezel of the second device body, wherein

   two ends of the first antenna stub are open, a first ground terminal and a second ground terminal are disposed on the first antenna stub, the first ground terminal and the second ground terminal are close to each other, the first ground terminal is close to a first open end of the first antenna stub, the second ground terminal is close to a second open end of the first antenna stub, a first feed point is provided on the first antenna stub, and the first feed point is arranged between the first ground terminal and the first open end;
   two ends of the second antenna stub are open, a third ground terminal and a fourth ground terminal are disposed on the second antenna stub, the third ground terminal and the fourth ground terminal are close to each other, the third ground terminal is close to a third open end of the second antenna stub, and the second ground terminal is close to a fourth open end of the second antenna stub; and
   a projection of a first radiation section on the second device body overlaps a second radiation section, and a projection of a third radiation section on the second device body overlaps a fourth radiation section, wherein the first radiation section is a radiation section between the first ground terminal and the first open end on the first antenna stub, the third radiation section is a radiation section between the second ground terminal and the second open end on the first antenna stub, the second radiation section is an antenna stub between the third ground terminal and the third open end, and the fourth radiation section is a radiation section between the fourth ground terminal and the fourth open end.

2. The foldable-screen electronic device according to claim 1, wherein
   a projection of the second radiation section on the second device body does not overlap the third radiation section.

3. The foldable-screen electronic device according to claim 1 or 2, wherein the first antenna stub is specifically distributed along an L-shaped bezel of the first device body, and the second antenna stub is specifically distributed along an L-shaped bezel of the second device body.

4. The foldable-screen electronic device according to claim 3, wherein a first current is distributed on the first radiation section, a current in a same direction as the first current is distributed on the second radiation section, a current in a same direction as the first current is distributed on the third radiation section, and a current in a direction opposite to a direction of the first current is distributed on the fourth radiation section.

5. The foldable-screen electronic device according to claim 1 or 2, wherein the first antenna stub is specifically distributed along a linear bezel of the first device body, and the second antenna stub is specifically distributed along a linear bezel of the second device body.

6. The foldable-screen electronic device according to claim 5, wherein a first current is distributed on the first radiation section, and a current in a same direction as the first current is distributed on each of the second radiation section, the third radiation section, and the fourth radiation section.

7. The foldable-screen electronic device according to any one of claims 1 to 6, wherein the first antenna stub further comprises a fifth radiation section, and the second antenna stub further comprises a sixth radiation section;

   a slot exists between the fifth radiation section and the third radiation section, and a ground terminal is disposed on the fifth radiation section; and
   a slot exists between the sixth radiation section and the fourth radiation section, and a ground terminal is disposed on the sixth radiation section.

8. The foldable-screen electronic device according to claim 7, wherein when the foldable-screen electronic device is in a folded state, a projection of the fifth radiation section on the second device body overlaps the sixth radiation section.

9. The foldable-screen electronic device according to any one of claims 3 to 8, wherein a current in a same direction as the first current is distributed on each of the fifth radiation section and the sixth radiation section.

10. The foldable-screen electronic device according to any one of claims 3 to 9, wherein the third radiation section is connected to a first tuning circuit, the fourth radiation section is connected to a second tuning circuit, the fifth radiation section is connected to a third tuning circuit, and the sixth radiation section is connected to a fourth tuning circuit.

11. The foldable-screen electronic device according to claim 10, wherein the second radiation section is connected to a fifth tuning circuit.

12. The foldable-screen electronic device according to claim 11, wherein the current distributed on the second radiation section comprises a current of a first frequency and a current of a second frequency, and the first frequency and the second frequency are operating frequencies of the first radiation section.

13. The foldable-screen electronic device according to claim 7 or 8, wherein a second feed point is further provided on the fifth radiation section.

14. The foldable-screen electronic device according to claim 13, wherein an excitation source connected to the first feed point transmits an excitation signal, and an excitation source connected to the second feed point does not transmit an excitation signal, wherein the excitation source connected to the first feed point is different from the excitation source connected to the second feed point.

15. The foldable-screen electronic device according to claim 13, wherein the L-shaped bezel specifically comprises a horizontal bezel and a vertical bezel, and the horizontal bezel is perpendicular to the vertical bezel; and
when the fifth radiation section is specifically disposed at the vertical bezel and the first radiation section is specifically disposed at the horizontal bezel, a second current is distributed on the first radiation section, a current in a same direction as the second current is distributed on the second radiation section, a current in a direction opposite to a direction of the second current is distributed on the fourth radiation section, a third current is distributed on the fifth radiation section, and a current in a same direction as the third current is distributed on the sixth radiation section.

16. The foldable-screen electronic device according to claim 15, wherein the current distributed on the third radiation section is weaker than the second current and the third current.

17. The foldable-screen electronic device according to claim 15, wherein no current is distributed on the third radiation section.

18. The foldable-screen electronic device according to any one of claims 15 to 17, wherein
when the fifth radiation section and the first radiation section are specifically disposed at the horizontal bezel, the second current is distributed on the first radiation section, a current in a same direction as the second current is distributed on each of the second radiation section, the fourth radiation section, and the sixth radiation section, the third current is distributed on the fifth radiation section, and a current in a same direction as the third current is distributed on the third radiation section.

19. The foldable-screen electronic device according to claim 7 or 8, wherein a third feed point is further provided on the third radiation section.

20. The foldable-screen electronic device according to claim 18, wherein the L-shaped bezel specifically comprises a horizontal bezel and a vertical bezel, and the horizontal bezel is perpendicular to the vertical bezel; and
when the third radiation section is specifically disposed at the vertical bezel and the first radiation section is specifically disposed at the horizontal bezel, a fourth current is distributed on the first radiation section, a current in a same direction as the fourth current is distributed on the second radiation section, a current in a direction opposite to a direction of the fourth current is distributed on the fourth radiation section, a fifth current is distributed on the third radiation section, and a current in a same direction as the fifth current is distributed on the fifth radiation section and the sixth radiation section.

21. The foldable-screen electronic device according to any one of claims 15 to 17, wherein an excitation source connected to the first feed point and an excitation source connected to the second feed point each transmit a radio frequency signal, wherein the excitation source connected to the first feed point is different from the excitation source connected to the second feed point.

22. The foldable-screen electronic device according to claim 18 or 19, wherein an excitation source connected to the first feed point and an excitation source connected to the third feed point each transmit a radio frequency signal, wherein the excitation source connected to the first feed point is different from the excitation source connected to the third feed point.

23. The foldable-screen electronic device according to any one of claims 7 to 21, wherein the first antenna stub further comprises a seventh radiation section, and the second antenna stub further comprises an eighth radiation section;

    a slot exists between the seventh radiation section and the first radiation section, and a ground terminal is disposed on the seventh radiation section; and
    a slot exists between the eighth radiation section and the second radiation section, and a ground terminal is disposed on the eighth radiation section.

24. The foldable-screen electronic device according to claim 22, wherein when the foldable-screen electronic device is in the folded state, a projection of the seventh radiation section on the second device body overlaps the eighth radiation section.

25. The foldable-screen electronic device according to claim 22 or 23, wherein a current distributed on the seventh radiation section is in a same direction as the current distributed on the second radiation section.

26. The foldable-screen electronic device according to any one of claims 22 to 24, wherein a fourth feed point is further provided on the eighth radiation section.

(1)

(2)

FIG. 1

Second device body 200

203d

D    202d

B    202b

203b

First device body 100  103c

C

102c    102a    A    104a

103a

(1)

203b    B

202b

103a

104a    A    102a

102c

C

103c

202d

D

203d

(2)

FIG. 2

FIG. 3

(1)

(2)

FIG. 4

Target current direction 11

→ Current

- - -► Weak current

·······► Current with a variable direction

Antenna 2

H    B

G    A Primary radiator

C

D

E

F

Antenna 1

(1)

Current direction in a low-
performance scenario 11

H    B

G    A

Antenna
2

C

D

E

F

Antenna 1

(2)

FIG. 5A

FIG. 5B

FIG. 6

FIG. 7

Frequency control circuit arrangement in a
single-mode Wi-Fi scenario

(1)

Frequency control circuit arrangement in a
low-performance scenario 11

(2)

FIG. 8

EP 4 661 206 A1

FIG. 9

EP 4 661 206 A1

FIG. 10

Simulation diagram of current
distribution of radiators responsible
for a Wi-Fi 2.4G frequency band in
a Wi-Fi and B41 coexistence mode

(1)

Simulation diagram of current
distribution of radiators responsible
for a Wi-Fi 2.4G frequency band in a
low-performance scenario 12

(2)

FIG. 11

FIG. 12

FIG. 13

Frequency control circuit arrangement in a Wi-Fi and B41 coexistence mode scenario

(1)

Frequency control circuit arrangement in a low-performance scenario 12

(2)

FIG. 14

FIG. 15

Efficiency comparison
for an antenna 1

(1)

(2)

FIG. 16

FIG. 17

FIG. 18

Target current
direction 21

→ Current
Current with a
⤍ variable direction

F    D    B    H

E    C    A    G

①    ①    (1)

Current direction in a low-
performance scenario 21

F    D    B    H

E    C    A    G

(2)

FIG. 19A

FIG. 19B

FIG. 20

FIG. 21

Frequency control circuit arrangement in a single-mode Wi-Fi scenario

(1)

Frequency control circuit arrangement in a low-performance scenario 12

(2)

FIG. 22

FIG. 23

FIG. 24

Simulation diagram of current distribution of
radiators responsible for a Wi-Fi 2.4G frequency
band in a Wi-Fi and B41 coexistence mode

(1)

Simulation diagram of current distribution of
radiators responsible for a Wi-Fi 2.4G frequency
band in a low-performance scenario 22

(2)

FIG. 25

FIG. 26

FIG. 27

EP 4 661 206 A1

Frequency control circuit arrangement in a
Wi-Fi and B41 scenario

(1)

Frequency control circuit arrangement in a
low-performance scenario 22

(2)

FIG. 28

FIG. 29

Efficiency comparison for an antenna 1

-3.6  -5.4

1.8 dB

1.8 dB

Radiation efficiency - scenario 22

-3.9

-5.8

System efficiency - scenario 22

Radiation efficiency - coexistence mode

System efficiency - coexistence mode

(1)

Transmission efficiency - coexistence mode

K22

K21

Transmission efficiency - scenario 22

2.55

(2)

FIG. 30

FIG. 31

FIG. 32

Simulation diagram of current distribution of radiators
mainly responsible for a Wi-Fi 2.4G frequency band
in a single-mode Wi-Fi scenario

(1)

Simulation diagram of current distribution of
radiators mainly responsible for a GPS frequency
band in a single-mode Wi-Fi scenario

(2)

FIG. 33

FIG. 34

FIG. 35

Target current direction 32

Mainly responsible for a Wi-Fi 2.4G frequency band

Current

Weak current

H

B

G

A

C

D

E

F

Mainly responsible for a B41 frequency band

FIG. 36

Simulation diagram of current distribution of
radiators responsible for a Wi-Fi 2.4G frequency
band in a Wi-Fi and B41 coexistence mode

(1)

Simulation diagram of current distribution of
radiators responsible for a Wi-Fi 2.4G frequency
band in a low-performance scenario 12

(2)

FIG. 37A

Simulation diagram of current distribution of
radiators responsible for a B41 frequency band
in a Wi-Fi and B41 coexistence mode

(1)

Simulation diagram of current distribution of
radiators responsible for a B41 frequency band in
a low-performance scenario 12

(2)

FIG. 37B

FIG. 38

FIG. 39

FIG. 40

Single-mode MHB

1.93

C          D          E/F

Radiators mainly responsible for an
MHB frequency band

FIG. 41

FIG. 42

(1)

(2)

FIG. 43

$\overleftarrow{M}$

$\overleftarrow{J}$

Equivalent
magnetic
current

Equivalent
current

FIG. 44

(1)

(2)

FIG. 45

(1)

(2)

FIG. 46

B

A Primary radiator

C

D

Mainly responsible
for a Wi-Fi 2.4G
frequency band

Primary
radiator

E

F

Mainly responsible
for a B41
frequency band

(1)

F

D

B

E

C

A

(2)

FIG. 47

Mainly responsible for a Wi-Fi
2.4G frequency band

Mainly responsible for a
B41 frequency band

FIG. 48

## INTERNATIONAL SEARCH REPORT

International application No.

**PCT/CN2023/133256**

**A. CLASSIFICATION OF SUBJECT MATTER**

H01Q 1/08(2006.01)i

According to International Patent Classification (IPC) or to both national classification and IPC

**B. FIELDS SEARCHED**

Minimum documentation searched (classification system followed by classification symbols)

IPC: H01Q

Documentation searched other than minimum documentation to the extent that such documents are included in the fields searched

Electronic data base consulted during the international search (name of data base and, where practicable, search terms used)

CNABS, CNTXT, DWPI, ENTXT, ENTXTC, OETXT, VEN, WPABS, WPABSC, CNKI, 3GPP, IEEE: 天线, 地, 接地, 第二, 第三, 第四, 第一, 翻盖, 折叠, 段, 辐射, 馈点, 馈电, 手机, 枝节, 支节, antenna, ground, first, second, third, forth, fourth, fold +, section, part+, feed+, radiat+, phone+, branch+

**C. DOCUMENTS CONSIDERED TO BE RELEVANT**

| Category* | Citation of document, with indication, where appropriate, of the relevant passages | Relevant to claim No. |
|---|---|---|
| A | CN 115249889 A (HONOR TERMINAL CO., LTD.) 28 October 2022 (2022-10-28) description, paragraphs 57-88, and figures 9-10 | 1-26 |
| A | CN 217768751 U (BEIJING XIAOMI MOBILE SOFTWARE CO., LTD.) 08 November 2022 (2022-11-08) entire document | 1-26 |
| A | CN 115296013 A (HONOR TERMINAL CO., LTD.) 04 November 2022 (2022-11-04) entire document | 1-26 |
| A | CN 115332796 A (VIVO COMMUNICATION TECHNOLOGY CO., LTD.) 11 November 2022 (2022-11-11) entire document | 1-26 |
| A | CN 209747728 U (OPPO GUANGDONG MOBILE TELECOMMUNICATIONS CORP., LTD.) 06 December 2019 (2019-12-06) entire document | 1-26 |
| A | EP 1078415 A2 (ALLGON AB) 28 February 2001 (2001-02-28) entire document | 1-26 |

☑ Further documents are listed in the continuation of Box C.  ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **28 February 2024** | **28 February 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/133256**

**C.    DOCUMENTS CONSIDERED TO BE RELEVANT**

| Category* | Citation of document, with indication, where appropriate, of the relevant passages | Relevant to claim No. |
|---|---|---|
| A | US 2004263396 A1 (SUNG JAE SUK) 30 December 2004 (2004-12-30)<br>entire document | 1-26 |
| A | US 2018097277 A1 (FUJITSU LTD.) 05 April 2018 (2018-04-05)<br>entire document | 1-26 |
| A | WO 2021082560 A1 (HUAWEI TECHNOLOGIES CO., LTD.) 06 May 2021 (2021-05-06)<br>entire document | 1-26 |

Form PCT/ISA/210 (second sheet) (July 2022)

## INTERNATIONAL SEARCH REPORT
### Information on patent family members

| International application No. |
| --- |
| **PCT/CN2023/133256** |

| Patent document cited in search report | | | Publication date (day/month/year) | Patent family member(s) | | | Publication date (day/month/year) |
| --- | --- | --- | --- | --- | --- | --- | --- |
| CN | 115249889 | A | 28 October 2022 | None | | | |
| CN | 217768751 | U | 08 November 2022 | None | | | |
| CN | 115296013 | A | 04 November 2022 | None | | | |
| CN | 115332796 | A | 11 November 2022 | None | | | |
| CN | 209747728 | U | 06 December 2019 | None | | | |
| EP | 1078415 | A2 | 28 February 2001 | JP | 2002512463 | A | 23 April 2002 |
| | | | | KR | 20010042844 | A | 25 May 2001 |
| | | | | KR | 100607097 | B1 | 01 August 2006 |
| | | | | WO | 9954956 | A2 | 28 October 1999 |
| | | | | WO | 9954956 | A3 | 02 December 1999 |
| | | | | US | 6342859 | B1 | 29 January 2002 |
| | | | | DE | 69918103 | D1 | 22 July 2004 |
| | | | | DE | 69918103 | T2 | 21 October 2004 |
| | | | | AU | 4066899 | A | 08 November 1999 |
| | | | | EP | 1078415 | B1 | 16 June 2004 |
| | | | | SE | 9801381 | D0 | 20 April 1998 |
| US | 2004263396 | A1 | 30 December 2004 | GB | 0324775 | D0 | 26 November 2003 |
| | | | | GB | 2403350 | A | 29 December 2004 |
| | | | | GB | 2403350 | B | 11 May 2005 |
| | | | | FI | 20031518 | A0 | 17 October 2003 |
| | | | | FI | 20031518 | A | 26 December 2004 |
| | | | | DE | 10347719 | A1 | 27 January 2005 |
| | | | | DE | 10347719 | B4 | 10 December 2009 |
| | | | | US | 7075484 | B2 | 11 July 2006 |
| | | | | JP | 2005020691 | A | 20 January 2005 |
| | | | | JP | 3828106 | B2 | 04 October 2006 |
| US | 2018097277 | A1 | 05 April 2018 | JP | 2018061093 | A | 12 April 2018 |
| | | | | JP | 6733477 | B2 | 29 July 2020 |
| | | | | US | 9960479 | B2 | 01 May 2018 |
| WO | 2021082560 | A1 | 06 May 2021 | None | | | |

Form PCT/ISA/210 (patent family annex) (July 2022)

**REFERENCES CITED IN THE DESCRIPTION**

**Patent documents cited in the description**

- CN 202310389830